(19) Europäisches Patentamt / European Patent Office / Office européen des brevets

(11) EP 2 748 878 B1

(12) **EUROPÄISCHE PATENTSCHRIFT**

(45) Veröffentlichungstag und Bekanntmachung des Hinweises auf die Patenterteilung:
**01.04.2020 Patentblatt 2020/14**

(21) Anmeldenummer: **12740070.3**

(22) Anmeldetag: **25.07.2012**

(51) Int Cl.:
***H01L 51/50*** *(2006.01)*

(86) Internationale Anmeldenummer:
**PCT/EP2012/003152**

(87) Internationale Veröffentlichungsnummer:
**WO 2013/026515 (28.02.2013 Gazette 2013/09)**

(54) **ORGANISCHE ELEKTROLUMINESZENZVORRICHTUNG**

ORGANIC ELECTROLUMINESCENCE DEVICE

DISPOSITIF ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.08.2011 EP 11006859**

(43) Veröffentlichungstag der Anmeldung:
**02.07.2014 Patentblatt 2014/27**

(73) Patentinhaber: **Merck Patent GmbH**
**64293 Darmstadt (DE)**

(72) Erfinder:
- **KROEBER, Jonas Valentin**
  **60311 Frankfurt am Main (DE)**
- **VOGES, Frank**
  **67098 Bad Duerkheim (DE)**
- **HEUN, Susanne**
  **65812 Bad Soden (DE)**
- **KAISER, Joachim**
  **DE / 64289 Darmstadt (DE)**

(56) Entgegenhaltungen:
**EP-A1- 1 859 491**
**US-A1- 2001 052 751**
**US-A1- 2006 279 204**
**US-A1- 2009 072 725**
**US-A1- 2009 191 427**

- **BRYON W. LARSON ET AL: "Electron Affinity of Phenyl-C 61 -Butyric Acid Methyl Ester (PCBM)", JOURNAL OF PHYSICAL CHEMISTRY C, vol. 117, no. 29, 5 June 2013 (2013-06-05) , pages 14958-14964, XP055352105, ISSN: 1932-7447, DOI: 10.1021/jp403312g**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung betrifft organische Elektrolumineszenzvorrichtungen, welche in der Elektronentransportschicht eine Mischung aus mindestens zwei rein organischen Materialien enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Organische Elektrolumineszenzvorrichtungen auf Basis niedermolekularer Verbindungen sind typischerweise aus mehreren organischen Schichten aufgebaut, die aufeinander aufgebracht werden, wie zum Beispiel Lochtransportschicht, emittierende Schicht und Elektronentransportschicht. Die emittierende Schicht kann fluoreszierend oder phosphoreszierend sein.

Für Vollfarbdisplays werden für die verschiedenfarbigen Pixel häufig dieselben Lochtransport- und Elektronentransportmaterialien in der Lochtransport- bzw. Elektronentransportschicht verwendet. Es ist daher wünschenswert, dass die verwendeten Loch- und Elektronentransportmaterialien mit allen Materialien der emittierenden Schichten kompatibel sind. Dies ist insbesondere bei phosphoreszierenden Emitterschichten eine Herausforderung, da dann für die Materialien der Loch- und Elektronentransportschichten nicht nur jeweils das HOMO (highest occupied molecular orbital = höchstes besetztes Molekülorbital) und das LUMO (lowest unoccupied molecular orbital = niedrigstes unbesetztes Molekülorbital) von Bedeutung sind, sondern auch die Triplettenergie der Materialien, da eine zu geringe Triplettenergie der Loch- bzw. Elektronentransportmaterialien, die direkt an die emittierende Schicht angrenzen, zu einer Löschung der Phosphoreszenz führen würde.

Um gute Effizienzen und Lebensdauern der organischen Elektrolumineszenzvorrichtung zu erreichen, ist es erforderlich, dass die Ladungsbalance in der Vorrichtung ausgeglichen ist, dass also nicht ein Ladungsträger im deutlichen Überschuss in der emittierenden Schicht vorliegt. Dies ist mit Materialien gemäß dem Stand der Technik nicht immer einfach zu realisieren, da die Ladungstransporteigenschaft eines Materials im Wesentlichen eine materialinhärente Eigenschaft ist und es nicht immer möglich ist, die verwendeten Loch- und Elektronentransportmaterialien so aufeinander abzustimmen, dass die gewünschte Ladungsbalance in der emittierenden Schicht erreicht wird. So ist es beispielsweise ein Problem, dass manche Elektronentransportmaterialien, wie sie gemäß dem Stand der Technik verwendet werden, zu viele Elektronen in die emittierende Schicht transportieren. Andere Elektronentransportmaterialien, die dieses Problem nicht aufweisen, weisen jedoch häufig schlechtere Eigenschaften für die Verwendung in einer organischen Elektrolumineszenzvorrichtung auf und sind somit keine echte Alternative zu diesen guten Elektronentransportmaterialien.

Die der vorliegenden Erfindung zugrunde liegende technische Aufgabe ist daher die Bereitstellung von Elektronentransportschichten für organische Elektrolumineszenzvorrichtungen, die das oben genannte Problem nicht aufweisen. Eine Verbesserung der Ladungsbalance äußert sich insbesondere in einer verbesserten Effizienz, einer verbesserten Lebensdauer und meist einer verringerten Betriebsspannung. Dabei ist das Ziel, Elektronentransportschichten bereitzustellen, die sowohl in Kombination mit fluoreszierenden wie auch mit phosphoreszierenden Emitterschichten eingesetzt werden können.

Gemäß dem Stand der Technik werden unter anderem $AlQ_3$ (Aluminiumtrishydroxychinolinat) und andere Metallhydroxychinolinate eingesetzt. Diese eignen sich jedoch nicht in Kombination mit Triplettemittern, insbesondere mit grün und blau emittierenden Triplettemittern, da sie ein nicht ausreichend hohes Triplettniveau aufweisen. Hydroxychinolin hat überdies den Nachteil, dass es mutagen ist und somit erhebliche Gesundheitsrisiken mit sich bringt.

Gemäß dem Stand der Technik werden weiterhin als Elektronentransportmaterialien beispielsweise Triazinderivate verwendet. Triazinderivate haben sich generell als sehr gute Elektronentransportmaterialien erwiesen, zeigen aber auch das oben genannte Problem, dass sie in manchen Deviceaufbauten zu viele Elektronen in die Emitterschicht transportieren und somit nicht zu einer ausgeglichenen Ladungsbalance führen.

Aus dem Stand der Technik (z. B. WO 2010/072300) ist weiterhin bekannt, Triazinderivate in der Elektronentransportschicht mit Alkalimetallverbindungen, insbesondere mit LiQ (Lithiumhydroxychinolinat), zu mischen. LiQ hat jedoch den Nachteil, dass es mutagen ist und somit erhebliche Gesundheitsrisiken mit sich bringt, so dass es wünschenswert wäre, die Verwendung von LiQ vermeiden zu können. Weiterhin hat LiQ ebenso wie viele weitere Metallkomplexe den Nachteil, dass durch die niedrige Triplettenergie die Kombination mit einer grün oder noch mehr mit einer blau phosphoreszierenden Emitterschicht zu einer zumindest teilweisen Löschung der Lumineszenz führt. Überraschend wurde gefunden, dass LiQ in der Elektronentransportschicht keine aktive Rolle beim Elektronentransport in der Schicht spielt.

Aus EP 1286568 ist eine Elektronentransportschicht für eine organische Elektrolumineszenzvorrichtung bekannt, in der ein Anthracenderivat als "farb-neutraler Dotand" in der emittierenden Schicht und in der an die emittierende Schicht angrenzenden Elektronentransportschicht verwendet wird. Dieser "farb-neutrale Dotand" wird in der Elektronentransportschicht in Kombination mit $AlQ_3$ als Elektronentransportmaterial verwendet. Erfindungswesentlich ist hier, dass der "farb-neutrale Dotand" ein Anthracenderivat umfasst. Dieser Deviceaufbau eignet sich nicht für phosphoreszierende Emissionsschichten, da Phosphoreszenz durch Anthracenderivate zumindest teilweise gelöscht wird. Außerdem ist hier das LUMO des farb-neutralen Dotanden niedriger als von AIQ, so dass der Dotand hier aktiv am Elektronentransport teilnimmt.

Aus WO 2007/015781 ist eine fluoreszierende organische Elektrolumineszenzvorrichtung bekannt, welche eine Lochblockierschicht aufweist und welche in der Elektronentransportschicht eine Mischung aus mindestens zwei Materialien aufweist, wobei ein Material ein polycyclischer aromatischer Kohlenwasserstoff, z. B. ein Anthracen- oder Naphthacenderivat, ist. Erfindungswesentlich ist hier die Anwesenheit einer zusätzlichen Lochblockierschicht. Dies stellt einen erheblichen technischen Nachteil dar, da die Verwendung einer zusätzlichen Schicht einen erhöhten technischen Aufwand bedeutet. In der US 2001/052751 A1 und in der EP 1 859 491 A1 werden bereits OLEDs mit Elektronentransportschichten erwähnt welche aus einer Mischschicht bestehen.

Überraschend wurde gefunden, dass organische Elektronentransportschichten zur Verwendung in organischen Elektrolumineszenzvorrichtungen Vorteile aufweisen, wenn sie aus einer Mischung aus mindestens zwei rein organischen Materialien bestehen, wobei das eine Material ein elektronentransportierendes Material ist und das andere Material ein Material ist, das nicht oder nicht wesentlich am Elektronentransport in der Schicht teilnimmt. Dies wird dadurch erreicht, dass bestimmte relative Werte für die HOMO- und LUMO-Lagen der Materialien eingehalten werden. Weiterhin weisen beide Materialien eine bestimmte Mindesttriplettenergie auf. Mit derartigen Elektrolumineszenzvorrichtungen werden Verbesserungen, insbesondere in Bezug auf Effizienz, Lebensdauer und Betriebsspannung, erzielt im Vergleich zu Elektrolumineszenzvorrichtungen, welche nur ein Material in der Elektronentransportschicht enthalten oder welche Mischungen gemäß dem Stand der Technik in der Elektronentransportschicht enthalten. Derartige Elektronentransportschichten sind weiterhin gleichermaßen für fluoreszierende und phosphoreszierende Emitterschichten geeignet.

Gegenstand der Erfindung ist somit eine organische Elektrolumineszenzvorrichtung, enthaltend Anode, Kathode, mindestens eine emittierende Schicht und mindestens eine Elektronentransportschicht, welche auf Kathodenseite direkt an die emittierende Schicht angrenzt, dadurch gekennzeichnet, dass die Elektronentransportschicht aus einer Mischung aus mindestens zwei Materialien ETM1 und ETM2 besteht, wobei für ETM1 und ETM2 die folgenden Bedingungen gelten:

a) $T_1$(ETM1) > 2.2 eV; und
b) $T_1$(ETM2) > 2.2 eV; und
c) -3.2 eV < LUMO(ETM1) < -2.0 eV; und
d) LUMO(ETM2) > LUMO(ETMI);

wobei $T_1$ für die niedrigste Triplettenergie des entsprechenden Materials und LUMO für die Energie (Energieabstand zum Vakuum) des niedrigsten unbesetzten Molekülorbitals des entsprechenden Materials steht, und wobei ETM1 und ETM2 rein organische Materialien sind.

Die Bestimmung der physikalischen Parameter der Materialien ETM1 und ETM2, insbesondere von HOMO, LUMO, Triplettenergie und Energielücke, erfolgt dabei so, wie im Beispielteil ausführlich allgemein beschrieben.

Die erfindungsgemäße organische Elektrolumineszenzvorrichtung enthält, wie oben beschrieben, Anode, Kathode, mindestens eine emittierende Schicht, welche zwischen der Anode und der Kathode angeordnet ist, und die erfindungsgemäße Elektronentransportschicht. Die organische Elektrolumineszenzvorrichtung muss nicht notwendigerweise nur Schichten enthalten, welche aus organischen oder metallorganischen Materialien aufgebaut sind. So ist es auch möglich, dass Anode, Kathode und/oder eine oder mehrere Schichten anorganische Materialien enthalten oder ganz aus anorganischen Materialien aufgebaut sind.

In der Ausführungsform der Erfindung sind die Materialien ETM1 und ETM2 rein organische Materialien, das heißt, sie enthalten keine Metalle.

Falls die erfindungsgemäße organische Elektrolumineszenzvorrichtung außer ETM1 und ETM2 weitere Materialien in der Elektronentransportschicht enthält, weisen alle weiteren Materialien bevorzugt eine Triplettenergie $T_1$ > 2.2 eV auf. Außerdem weisen im Fall weiterer Materialien in der Elektronentransportschicht alle weiteren Materialien bevorzugt ein LUMO > LUMO(ETM1) auf.

Bevorzugt weisen die Materialien ETM1 und ETM2 eine Glasübergangstemperatur $T_G$ von größer als 80 °C auf, besonders bevorzugt größer als 100 °C, ganz besonders bevorzugt größer als 120 °C.

In einer bevorzugten Ausführungsform ist die Triplettenergie $T_1$ von ETM1 und ETM2 und von gegebenenfalls weiteren in der Elektronentransportschicht vorhandenen Materialien > 2.4 eV, besonders bevorzugt > 2.6 eV, ganz besonders bevorzugt > 2.7 eV.

Bei dem Material ETM1 handelt es sich bevorzugt um ein elektronentransportierendes Material. Ein elektronentransportierendes Material im Sinne dieser Anmeldung ist charakterisiert durch ein LUMO im Bereich von -3.2 bis -2.0 eV. ETM1 hat bevorzugt ein LUMO im Bereich von -3.1 eV bis -2.2 eV, besonders bevorzugt im Bereich von -3.0 eV bis -2.4 eV, ganz besonders bevorzugt im Bereich von -2.9 eV bis -2.5 eV.

Bei dem Material ETM2 handelt es sich bevorzugt um ein Material, das nicht oder nicht wesentlich am Elektronentransport in der Elektronentransportschicht teilnimmt. Dies wird dadurch gewährleistet, dass das LUMO von ETM2

größer als das LUMO von ETM1 ist. Bevorzugt ist das LUMO von ETM2 mindestens 0.1 eV größer als das LUMO von ETM1, besonders bevorzugt mindestens 0.2 eV.

In einer weiteren bevorzugten Ausführungsform der Erfindung ist das HOMO von ETM1 < -5.3 eV.

In nochmals einer weiteren bevorzugten Ausführungsform der Erfindung gilt HOMO(ETM1) < HOMO(EML) und besonders bevorzugt auch HOMO(ETM2) < HOMO(EML). HOMO(EML) ist dabei das HOMO der emittierenden Schicht bzw. des Materials der emittierenden Schicht, welches das höchste HOMO aufweist.

Das Mengenverhältnis zwischen ETM1 und ETM2 kann variieren. Insbesondere kann durch Variation dieses Verhältnisses die Ladungsbalance der OLED einfach und reproduzierbar eingestellt werden. Durch das Einstellen des Mischungsverhältnisses lässt sich somit leicht die Effizienz der OLED optimieren. Dabei beträgt der Anteil von ETM2 bevorzugt ≥ 10 Vol.-%, besonders bevorzugt ≥ 30 Vol.-% und ganz besonders bevorzugt ≥ 50 Vol.-%. Weiterhin bevorzugt beträgt der Anteil von ETM2 ≤ 90 Vol.-% und besonders bevorzugt ≤ 80 Vol.-%.

In einer weiteren bevorzugten Ausführungsform der Erfindung enthält die Elektronentransportschicht außer den Materialien ETM1 und ETM2 keine weiteren Materialien.

Im Folgenden werden bevorzugte Ausführungsformen für ETM1 und ETM2, welche erfindungsgemäß in der Elektronentransportschicht vorhanden sind, ausgeführt.

ETM1 ist eine elektronentransportierende Verbindung. Generell eignen sich alle elektronentransportierenden Verbindungen, für die die oben genannte Bedingung bezüglich dem $T_1$-Niveau erfüllt ist. Bevorzugte elektronentransportierende Verbindungen sind ausgewählt aus der Gruppe bestehend aus Verbindungen enthaltend Sechsringheteroarylgruppen, insbesondere Triazinderivate, Pyrimidinderivate, Pyridinderivate, Pyrazinderivate, Chinoxalinderivate bzw. Chinolinderivate, und Verbindungen enthaltend Fünfringheteroaromaten mit mindestens zwei Heteroatomen, insbesondere Oxadiazolderivate und Benzimidazolderivate. Weiterhin eignen sich aromatische Ketone, Lactame, Borane, Diazaphospholderivate und Phosphinoxidderivate. Für alle diese Verbindungen gilt, dass sie derart substituiert sein müssen, dass die oben genannte Bedingung bezüglich dem $T_4$-Niveau erfüllt ist. Ob die oben genannte Bedingung für das $T_1$-Niveau erfüllt ist, lässt sich einfach durch quantenchemische Rechnung überprüfen. Besonders bevorzugt werden als ETM1 Triazin- und Pyrimidinderivate eingesetzt.

Geeignete Triazin- und Pyrimidinderivate, die als ETM1 verwendet werden können, sind insbesondere 1,3,5-Triazinderivate, welche mit mindestens einem, bevorzugt mindestens zwei, besonders bevorzugt mit drei aromatischen oder heteroaromatischen Ringsystemen substituiert sind, und Pyrimidinderivate, die mit einem, zwei oder drei aromatischen oder heteroaromatischen Ringsystemen substituiert sind. Besonders bevorzugt sind Verbindungen der folgenden Formel (1) bis (8),

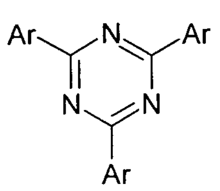

Formel (1)

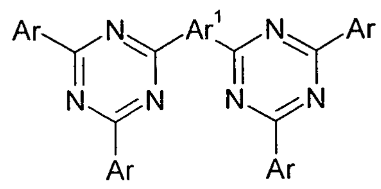

Formel (2)

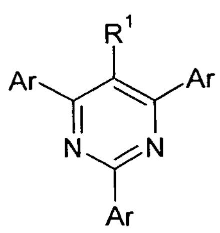

Formel (3)

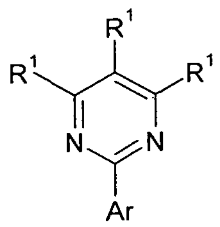

Formel (4)

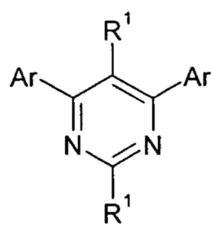

Formel (5)

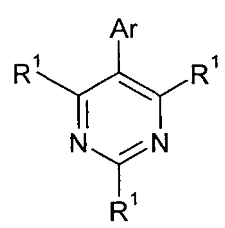

Formel (6)

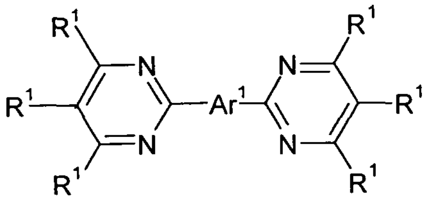

Formel (7)

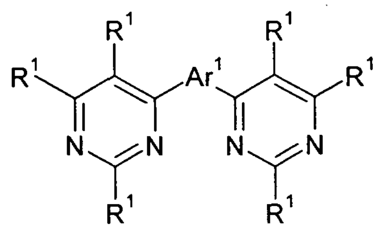

Formel (8)

wobei für die verwendeten Symbole gilt:

Ar ist gleich oder verschieden bei jedem Auftreten ein monovalentes aromatisches oder heteroaromatisches Ringsystem mit 5 bis 60 aromatischen Ringatomen, welches jeweils mit einem oder mehreren Resten $R^1$ substituiert sein kann;

$Ar^1$ ist ein bivalentes aromatisches oder heteroaromatisches Ringsystem mit 5 bis 60 aromatischen Ringatomen, welches mit einem oder mehreren Resten $R^1$ substituiert sein kann;

$R^1$ ist bei jedem Auftreten gleich oder verschieden H, D, F, Cl, Br, I, CHO, $C(=O)Ar^2$, $P(=O)(Ar^2)_2$, $S(=O)Ar^2$, $S(=O)_2Ar^2$, $CR^2=CR^2Ar^2$, CN, $NO_2$, $Si(R^2)_3$, $B(OR^2)_2$, $B(R^2)_2$, $B(N(R^2)_2)_2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C=CR^2$, $C\equiv C$, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Kombination dieser Systeme; dabei können zwei oder mehrere benachbarte Substituenten $R^1$ auch miteinander ein mono- oder polycyclisches, aliphatisches oder aromatisches Ringsystem bilden;

$Ar^2$ ist bei jedem Auftreten gleich oder verschieden ein aromatisches oder heteroaromatisches Ringsystem mit 5 bis 40 aromatischen Ringatomen, das mit einem oder mehreren Resten $R^2$ substituiert sein kann;

$R^2$ ist bei jedem Auftreten gleich oder verschieden H, D, CN oder ein aliphatischer, aromatischer und/oder heteroaromatischer organischer Rest mit 1 bis 20 C-Atomen, in dem auch H-Atome durch F ersetzt sein können; dabei können zwei oder mehrere benachbarte Substituenten $R^2$ auch miteinander ein mono- oder polycyclisches, aliphatisches oder aromatisches Ringsystem bilden.

Eine Arylgruppe im Sinne dieser Erfindung enthält mindestens 6 C-Atome; eine Heteroarylgruppe im Sinne dieser Erfindung enthält mindestens 2 C-Atome und mindestens 1 Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Pyren, Chinolin, Isochinolin, etc., verstanden.

Ein aromatisches Ringsystem im Sinne dieser Erfindung enthält mindestens 6 C-Atome im Ringsystem. Ein heteroaromatisches Ringsystem im Sinne dieser Erfindung enthält mindestens 2 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine kurze, nicht-aromatische Einheit (bevorzugt weniger als 10 % der von H verschiedenen Atome), wie z. B. ein $sp^3$-hybridisiertes C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, Benzophenon, etc. als aromatische Ringsysteme im Sinne dieser Erfindung verstanden werden. Ebenso werden unter einem aromatischen bzw. heteroaromatischen Ringsystem

Systeme verstanden, in denen mehrere Aryl- bzw. Heteroarylgruppen durch Einfachbindungen miteinander verknüpft sind, beispielsweise Biphenyl, Terphenyl oder Bipyridin.

Im Rahmen der vorliegenden Erfindung werden unter einer $C_1$- bis $C_{40}$-Alkylgruppe, in der auch einzelne H-Atome oder $CH_2$-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]octyl, 2-(2,6-Dimethyl)octyl, 3-(3,7-Dimethyl)octyl, Trifluormethyl, Pentafluorethyl und 2,2,2-Trifluorethyl verstanden. Unter einer unter einer $C_2$- bis $C_{40}$-Alkenylgruppe werden bevorzugt Ethenyl, Propenyl, Butenyl, Pentenyl, Cyclopentenyl, Hexenyl, Cyclohexenyl, Heptenyl, Cycloheptenyl, Octenyl und Cyclooctenyl verstanden. Unter einer unter einer $C_2$- bis $C_{40}$-Alkinylgruppe werden bevorzugt Ethinyl, Propinyl, Butinyl, Pentinyl, Hexinyl, Heptinyl und Octinyl verstanden. Unter einer $C_1$- bis $C_{40}$-Alkoxygruppe werden bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Benzanthracen, Benzphenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Benzofluoren, Dibenzofluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt ist in Verbindungen der Formel (1) bis (8) mindestens eine Gruppe Ar gewählt aus den Gruppen der folgenden Formeln (9) bis (15), und die anderen Gruppen Ar haben die oben angegebene Bedeutung,

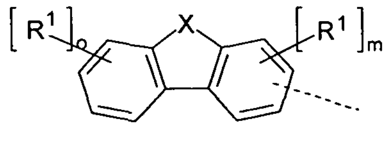

Formel (9)

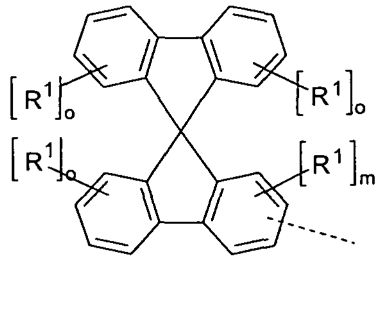

Formel (10)

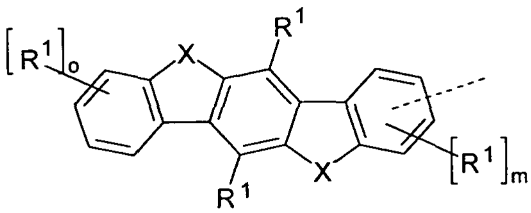

Formel (11)

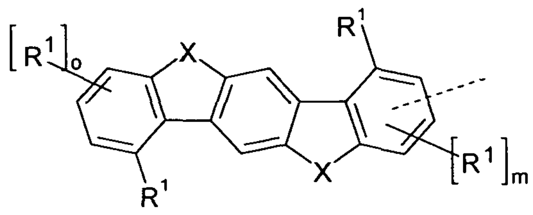

Formel (12)

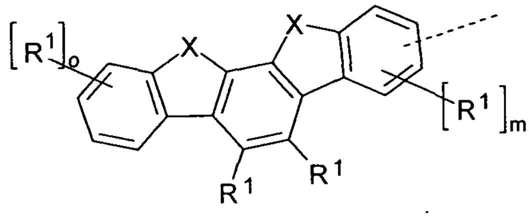

Formel (13)

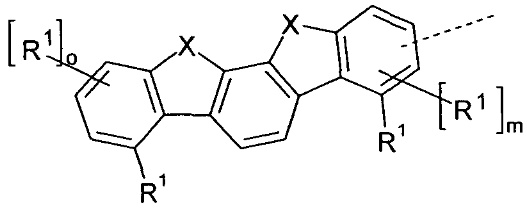

Formel (14)

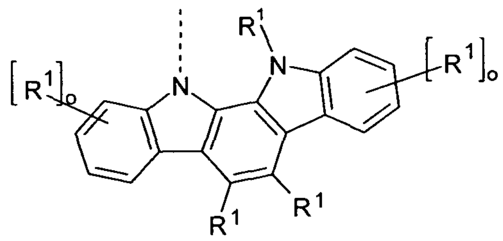

Formel (15)

wobei $R^1$ dieselbe Bedeutung hat, wie oben beschrieben, die gestrichelte Bindung die Verknüpfung mit der Triazineinheit bzw. Pyrimidineinheit darstellt und weiterhin gilt:

X ist gleich oder verschieden bei jedem Auftreten eine bivalente Brücke, ausgewählt aus $B(R^1)$, $C(R^1)_2$, $Si(R^1)_2$, C=O, $C=NR^1$, $C=C(R^1)_2$, O, S, S=O, $SO_2$, $N(R^1)$, $P(R^1)$ und $P(=O)R^1$;

m ist bei jedem Auftreten gleich oder verschieden 0, 1, 2 oder 3;

o ist bei jedem Auftreten gleich oder verschieden 0, 1, 2, 3 oder 4.

Besonders bevorzugte Gruppen Ar sind gewählt aus den Gruppen der folgenden Formeln (9a) bis (15a),

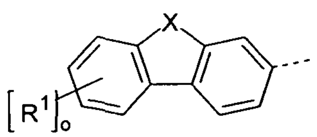

Formel (9a)

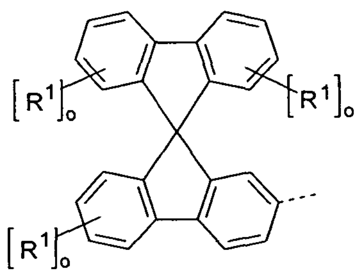

Formel (10a)

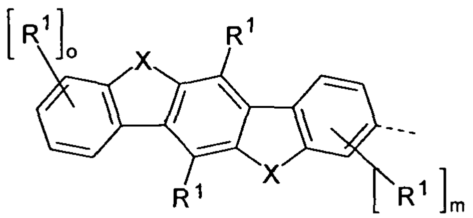

Formel (11a)

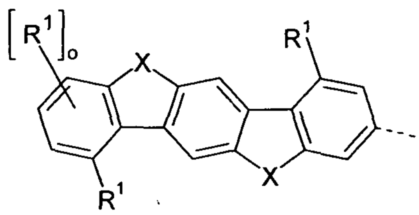

Formel (12a)

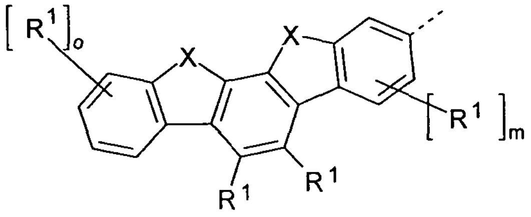

Formel (13a)

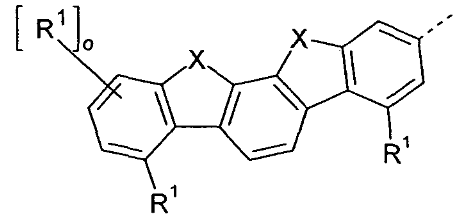

Formel (14a)

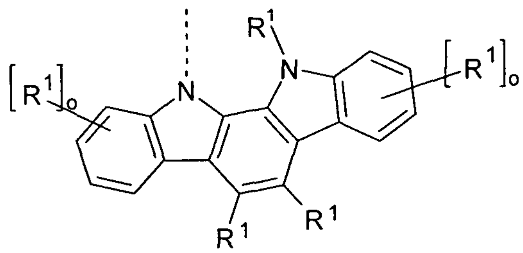

Formel (15a)

wobei die verwendeten Symbole und Indizes dieselbe Bedeutung haben, wie oben beschrieben. Dabei ist X bevorzugt gleich oder verschieden gewählt aus $C(R^1)_2$, $N(R^1)$, O und S, besonders bevorzugt $C(R^1)_2$.

Bevorzugte Gruppen $Ar^1$ in Verbindungen den Formeln (2), (7) und (8) sind gewählt aus den Gruppen der folgenden Formeln (16) bis (22),

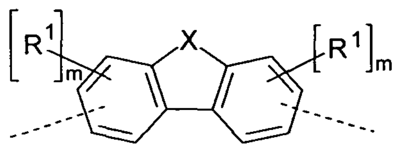

Formel (16)

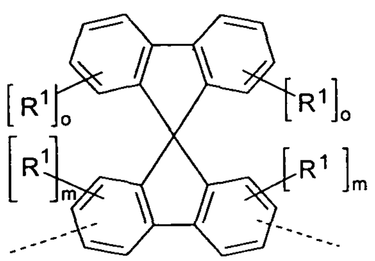

Formel (17)

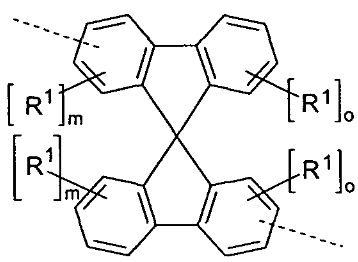

Formel (18)

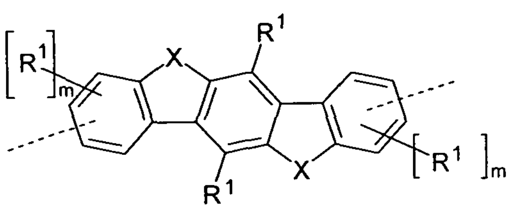

Formel (19)

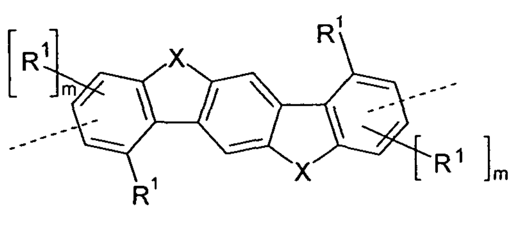

Formel (20)

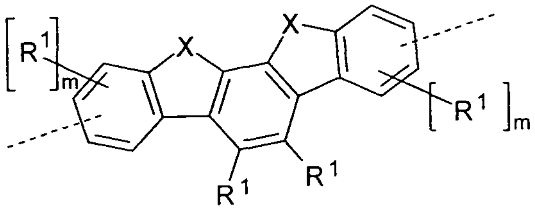

Formel (21)

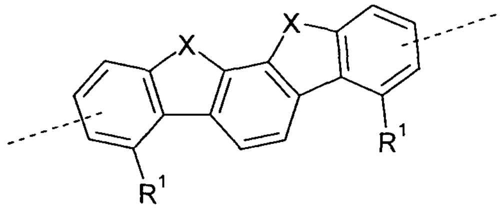

Formel (22)

wobei die verwendeten Symbole und Indizes dieselbe Bedeutung haben, wie oben beschrieben und die gestrichelte Bindung die Verknüpfung mit den beiden Triazineinheiten bzw. Pyrimidineinheiten darstellt.

Besonders bevorzugte Gruppen $Ar^1$ sind gewählt aus den Gruppen der folgenden Formeln (16a) bis (22a),

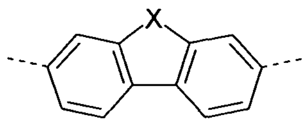

Formel (16a)

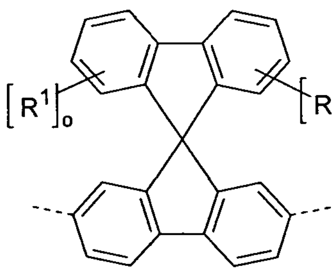

Formel (17a)

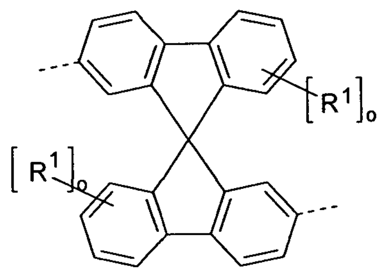

Formel (18a)

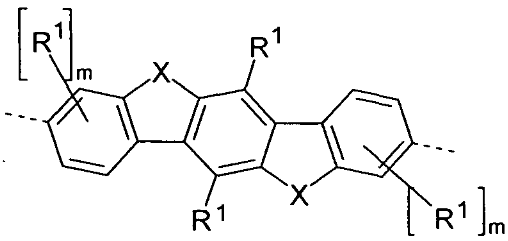

Formel (19a)

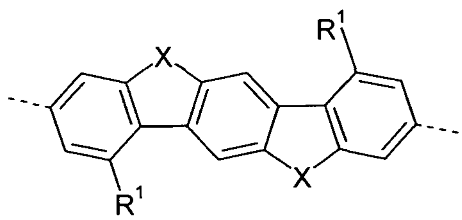

Formel (20a)

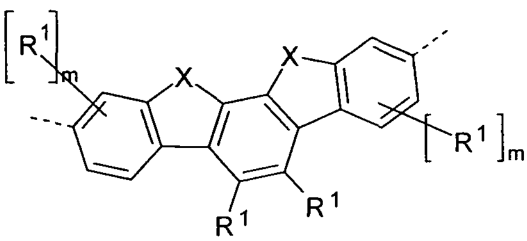

Formel (21a)

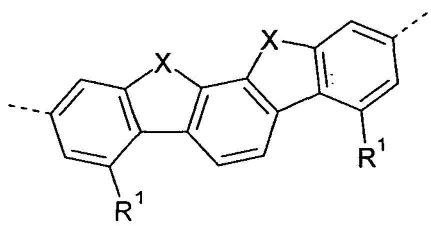

Formel (22a)

wobei die verwendeten Symbole und Indizes dieselbe Bedeutung haben, wie oben beschrieben. Dabei ist X bevorzugt

gleich oder verschieden gewählt aus $C(R^1)_2$, $N(R^1)$, O und S, besonders bevorzugt $C(R^1)_2$.

Bevorzugt sind weiterhin Verbindungen der oben aufgeführten Formel (2), (7) und (8), in denen die Gruppe $Ar^1$ aus den oben aufgeführten Formeln (16) bis (22) ausgewählt ist und Ar bzw. $R^1$ gleich oder verschieden bei jedem Auftreten ausgewählt ist aus den oben aufgeführten Formeln (9) bis (15) oder Phenyl, 1- oder 2-Naphthyl, ortho-, meta- oder para-Biphenyl, welche durch einen oder mehrere Reste $R^1$ substituiert sein können, jedoch bevorzugt unsubstituiert sind.

In einer bevorzugten Ausführungsform der Erfindung weisen die Gruppen Ar und $Ar^1$ nicht mehr als zwei kondensierte Sechsringe auf. Sie sind also bevorzugt nur aus Phenyl- und/oder Naphthylgruppen, besonders bevorzugt nur aus Phenylgruppen, aufgebaut, enthalten aber keine größeren kondensierten Aromaten, wie beispielsweise Anthracen.

Bevorzugte Gruppen Ar und $Ar^1$ sind weiterhin Phenyl, 2-, 3- oder 4-Tolyl, 3- oder 4-o-Xylyl, 2- oder 4-m-Xylyl, 2-p-Xylyl, o-, m- oder p-tert-Butylphenyl, o-, m- oder p-Fluorphenyl, Benzophenon, 1-, 2- oder 3-Phenylmethanon, 2-, 3- oder 4-Biphenyl, 2-, 3- oder 4-o-Terphenyl, 2-, 3- oder 4-m-Terphenyl, 2-, 3- oder 4-p-Terphenyl, 2'-p-Terphenyl, 2'-, 4'- oder 5'-m-Terphenyl, 3'- oder 4'-o-Terphenyl, p-, m,p-, o,p-, m,m-, o,m- oder o,o-Quaterphenyl, Quinquephenyl, Sexiphenyl, 1-, 2-, 3- oder 4-Fluorenyl, 2-, 3- oder 4-Spiro-9,9'-bifluorenyl, 1-, 2-, 3- oder 4-(9,10-Dihydro)phenanthrenyl, 1- oder 2-Naphthyl, 2-, 3-, 4-, 5-, 6-, 7- oder 8-Chinolinyl, 1-, 3-, 4-, 5-, 6-, 7- oder 8-iso-Chinolinyl, 1- oder 2-(4-Methylnaphthyl), 1- oder 2-(4-Phenylnaphthyl), 1- oder 2-(4-naphthyl-naphthyl), 1-, 2- oder 3-(4-naphthyl-phenyl), 2-, 3- oder 4-Pyridyl, 2-, 4- oder 5-Pyrimidinyl, 2- oder 3-Pyrazinyl, 3- oder 4-Pyridanzinyl, 2-(1,3,5-Triazin)yl-, 2-, 3- oder 4-(Phenylpyridyl), 3-, 4-, 5- oder 6-(2,2'-Bipyridyl), 2-, 4-, 5- oder 6-(3,3'-Bipyridyl), 2- oder 3-(4,4'-Bipyridyl) und Kombinationen eines oder mehrerer dieser Reste.

Die Gruppen Ar und $Ar^1$ können, wie oben beschrieben, durch einen oder mehrere Reste $R^1$ substituiert sein. Diese Reste $R^1$ sind bevorzugt gleich oder verschieden bei jedem Auftreten gewählt aus der Gruppe bestehend aus H, F, $C(=O)Ar^2$, $P(=O)(Ar^2)_2$, $S(=O)Ar^2$, $S(=O)_2Ar^2$, einer geradkettigen Alkylgruppe mit 1 bis 4 C-Atomen oder einer verzweigten oder cyclischen Alkylgruppe mit 3 bis 5 C-Atomen, die jeweils mit einem oder mehreren Resten $R^2$ substituiert sein kann, wobei ein oder mehrere H-Atome durch F ersetzt sein können, oder einem aromatischen Ringsystem mit 6 bis 24 aromatischen Ringatomen, das durch einen oder mehrere Reste $R^2$ substituiert sein kann, oder eine Kombination dieser Systeme; dabei können zwei oder mehrere benachbarte Substituenten $R^1$ auch miteinander ein mono- oder polycyclisches, aliphatisches oder aromatisches Ringsystem bilden. Wenn die organische Elektrolumineszenzvorrichtung aus Lösung aufgebracht wird, sind auch geradkettige, verzweigte oder cyclische Alkylgruppen mit bis zu 10 C-Atomen als Substituenten $R^1$ bevorzugt. Die Reste $R^1$ sind besonders bevorzugt gleich oder verschieden bei jedem Auftreten gewählt aus der Gruppe bestehend aus H, $C(=O)Ar^2$ oder einem aromatischen Ringsystem mit 6 bis 24 aromatischen Ringatomen, das durch einen oder mehrere Reste $R^2$ substituiert sein kann, bevorzugt aber unsubstituiert ist.

Beispiele für geeignete Verbindungen der Formeln (1) bis (8) sind die in der folgenden Tabelle aufgeführten Verbindungen:

| | | |
|---|---|---|
| 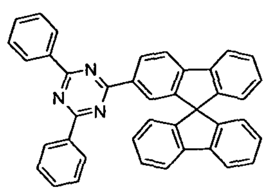 | 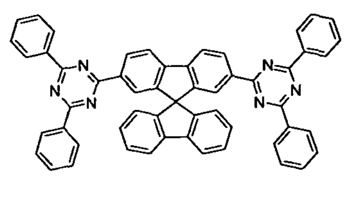 | 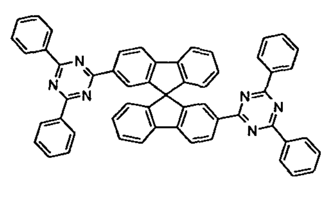 |
| 1 | 2 | 3 |
| 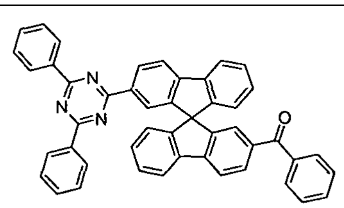 | 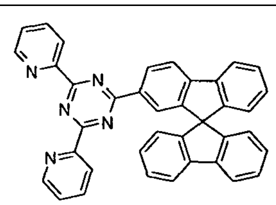 | 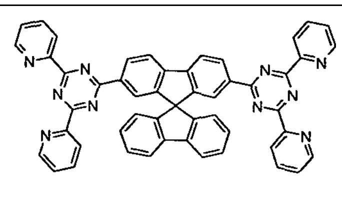 |
| 4 | 5 | 6 |

(fortgesetzt)

| | | |
|---|---|---|
| 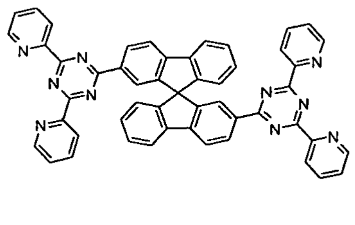 | 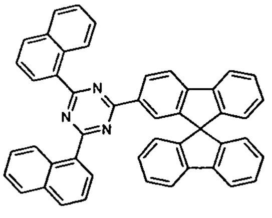 | 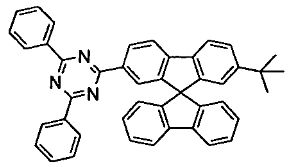 |
| 7 | 8 | 9 |
| 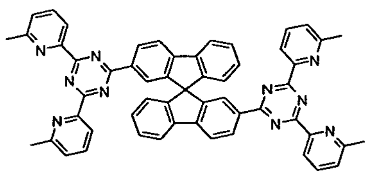 | 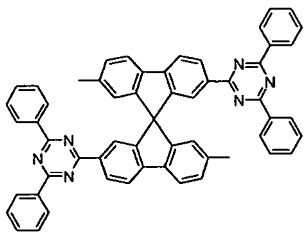 | 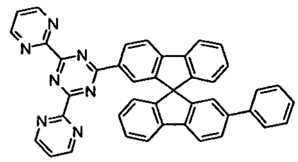 |
| 10 | 11 | 12 |
| 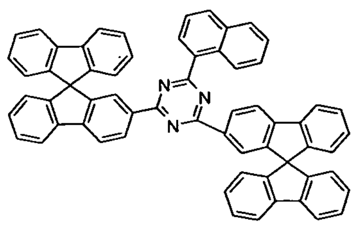 | 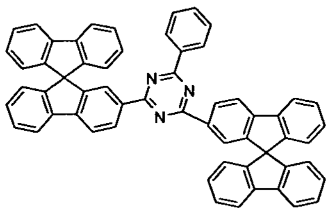 | 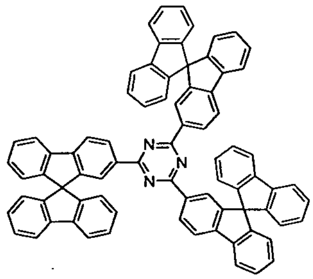 |
| 13 | 14 | 15 |
| 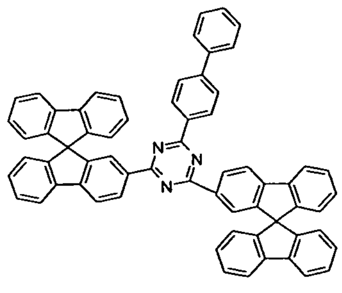 | 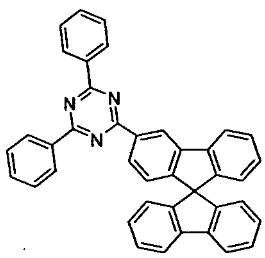 | 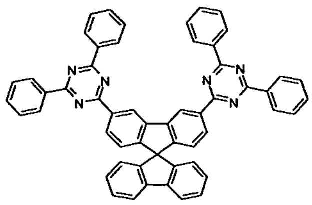 |
| 16 | 17 | 18 |
| 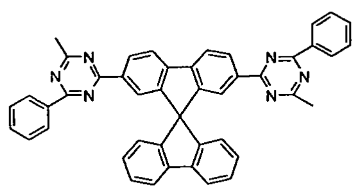 | 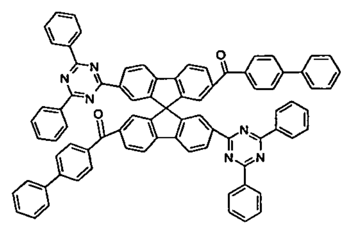 | 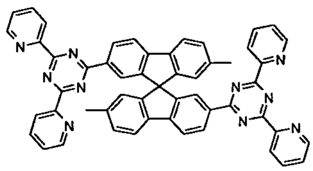 |
| 19 | 20 | 21 |

(fortgesetzt)

| | | |
|---|---|---|
| 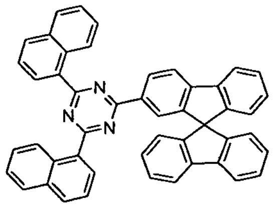 | 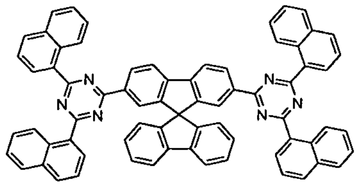 | 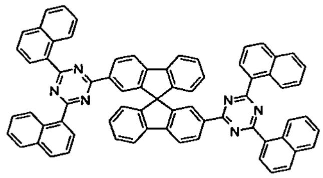 |
| 22 | 23 | 24 |
| 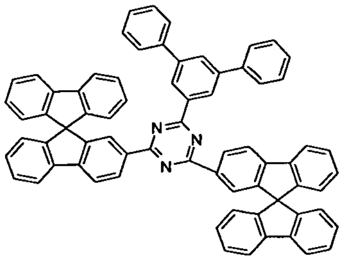 | 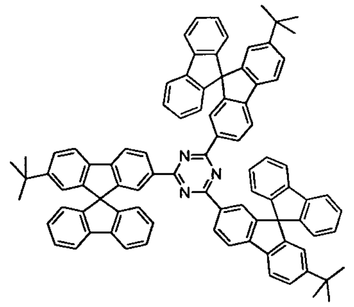 | 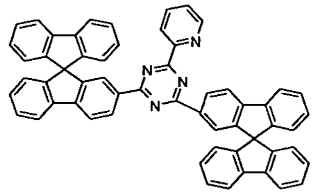 |
| 25 | 26 | 27 |
| 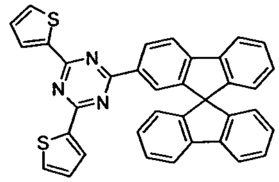 | 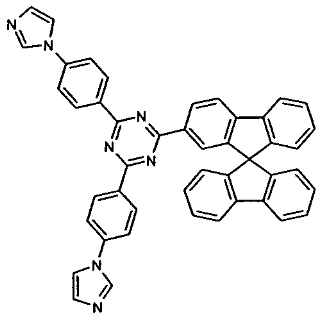 | 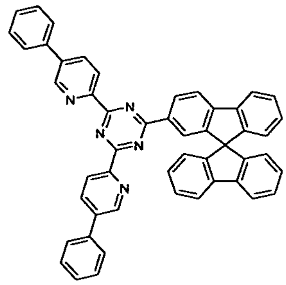 |
| 28 | 29 | 30 |
| 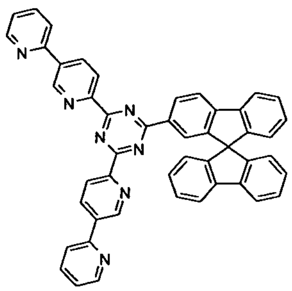 | 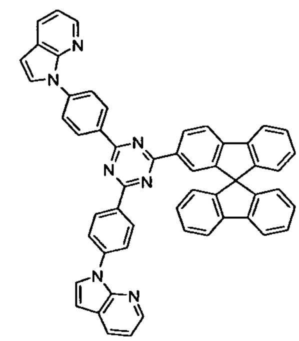 | 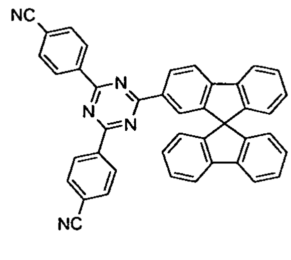 |
| 31 | 32 | 33 |
| 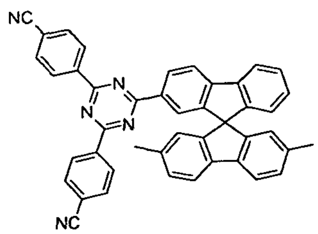 | 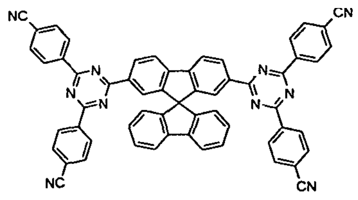 | 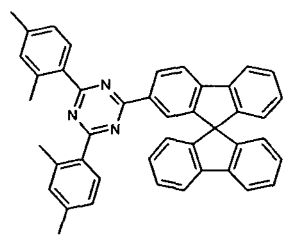 |
| 34 | 35 | 36 |

(fortgesetzt)

| | | |
|---|---|---|
| 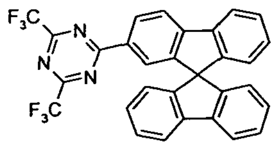 | 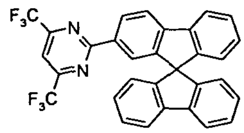 | 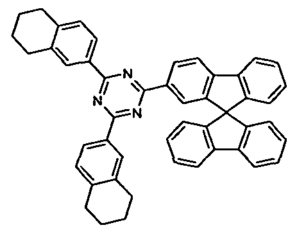 |
| 37 | 38 | 39 |
| 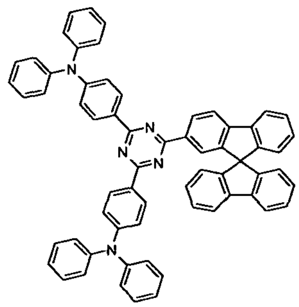 | 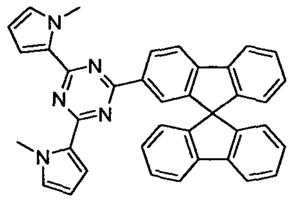 | 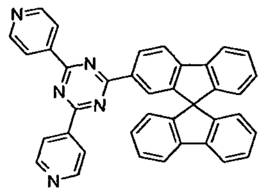 |
| 40 | 41 | 42 |
| 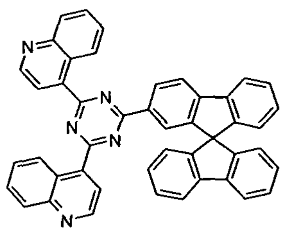 | 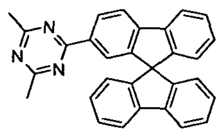 | 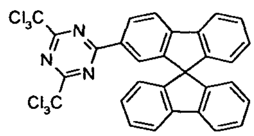 |
| 43 | 44 | 45 |
| 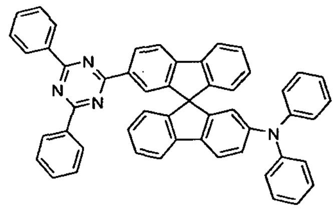 | 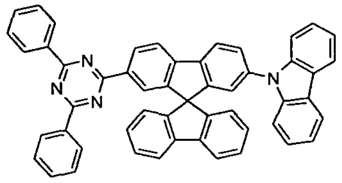 | 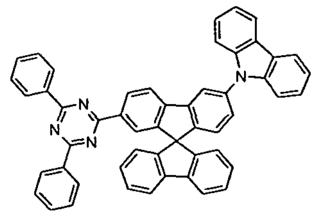 |
| 46 | 47 | 48 |
| 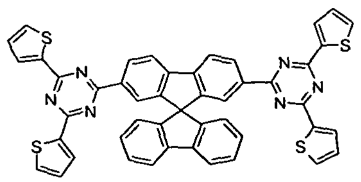 | 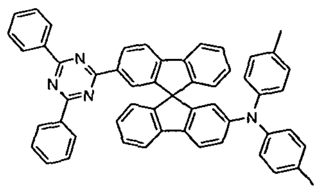 | 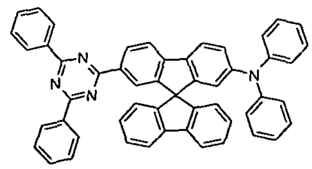 |
| 49 | 50 | 51 |

(fortgesetzt)

| | | |
|---|---|---|
| 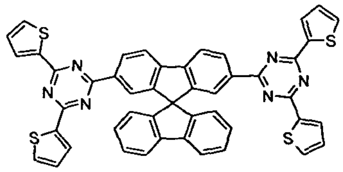 | 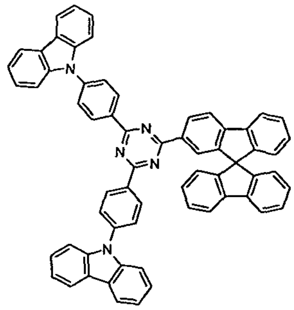 | 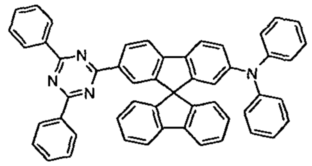 |
| 52 | 53 | 54 |
| 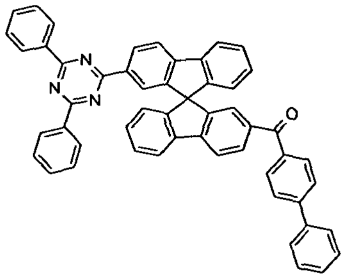 | 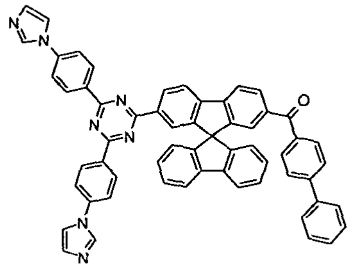 | 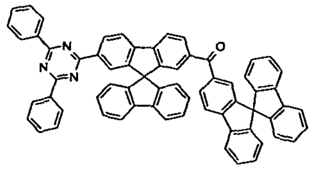 |
| 55 | 56 | 57 |
| 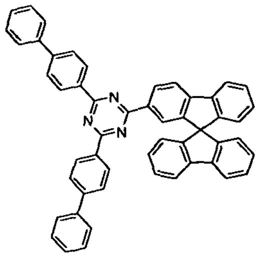 | 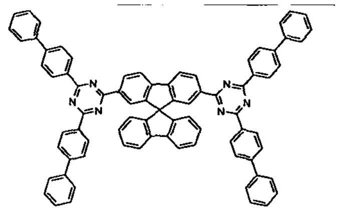 | 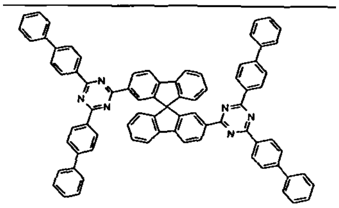 |
| 58 | 59 | 60 |
| 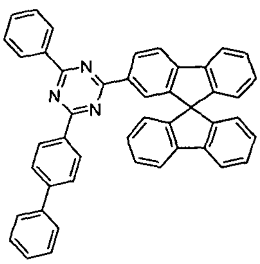 | 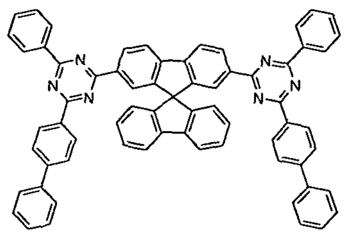 | 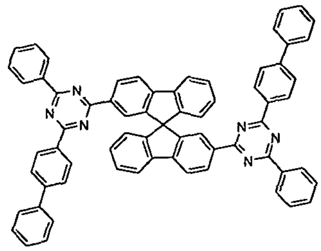 |
| 61 | 62 | 63 |
| 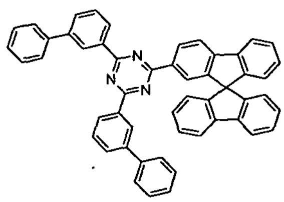 | 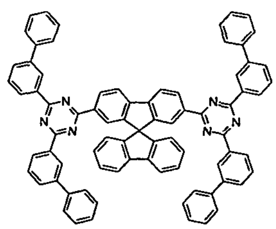 | 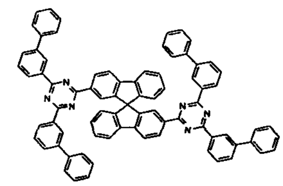 |
| 64 | 65 | 66 |

(fortgesetzt)

| | | |
|---|---|---|
| 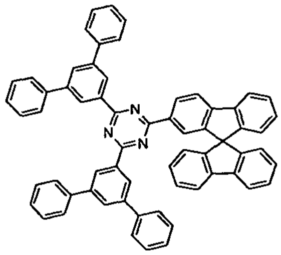 | 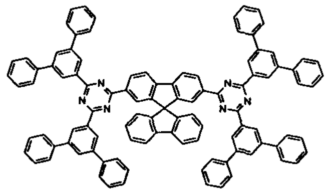 | 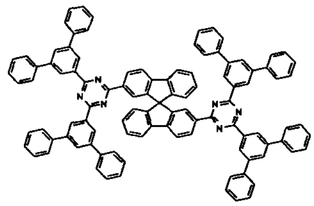 |
| 67 | 68 | 69 |
| 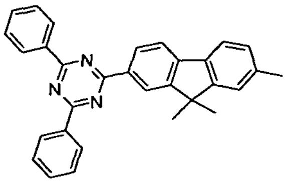 | 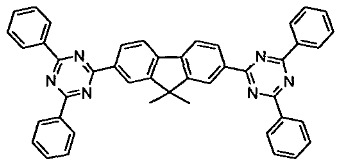 | 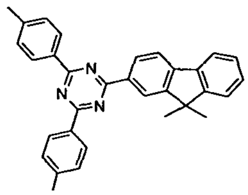 |
| 70 | 71 | 72 |
| 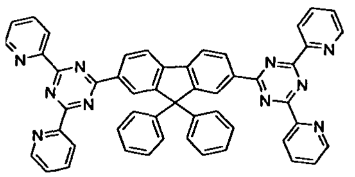 | 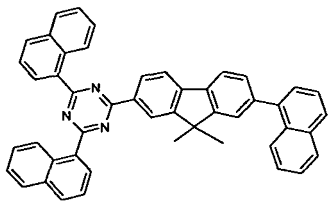 | 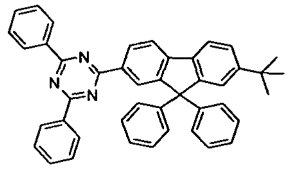 |
| 73 | 74 | 75 |
| 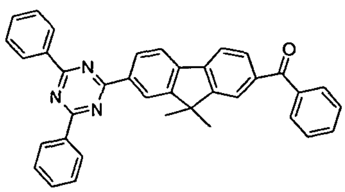 | 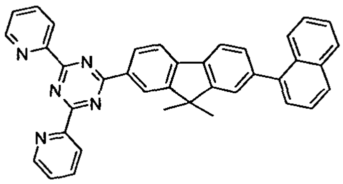 | 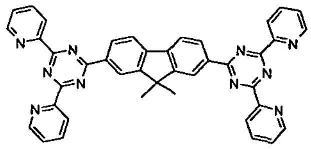 |
| 76 | 77 | 78 |
| 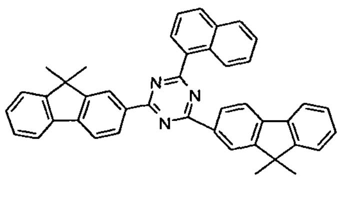 | 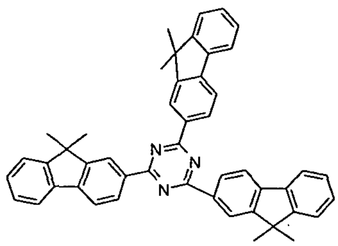 | 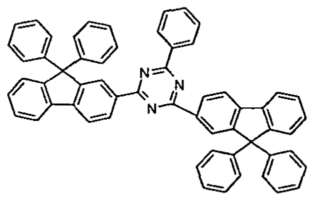 |
| 79 | 80 | 81 |
| 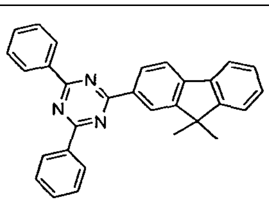 | 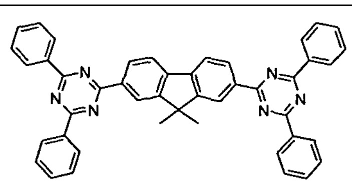 | 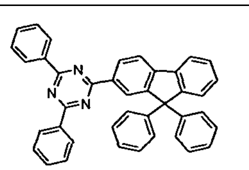 |
| 82 | 83 | 84 |

(fortgesetzt)

| | | |
|---|---|---|
| 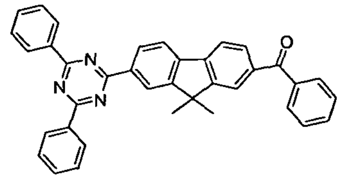 | 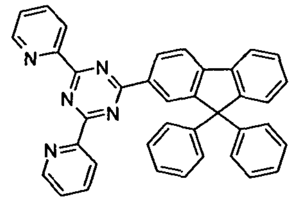 | 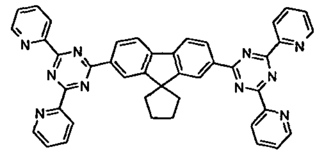 |
| 85 | 86 | 87 |
| 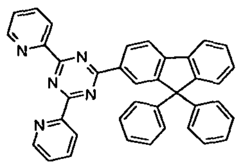 | 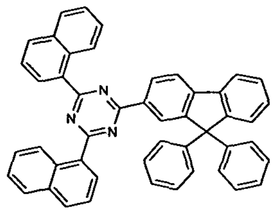 | 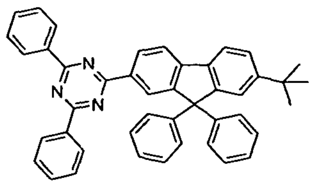 |
| 88 | 89 | 90 |
| 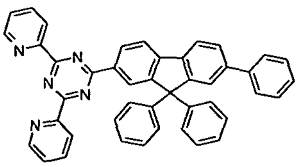 | 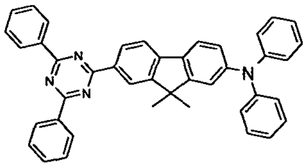 | 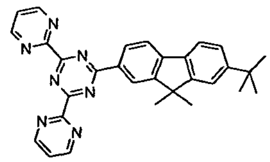 |
| 91 | 92 | 93 |
| 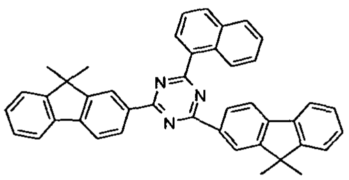 | 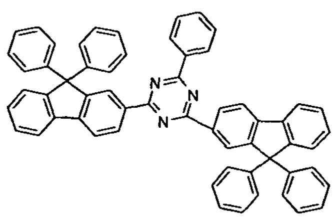 | 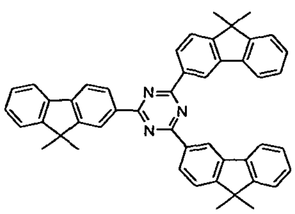 |
| 94 | 95 | 96 |
| 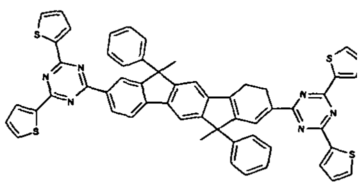 | 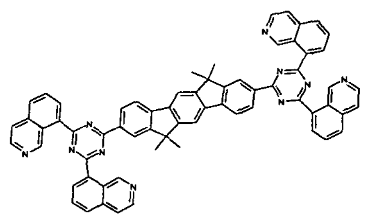 | 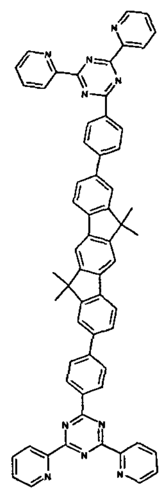 |
| 97 | 98 | 99 |

(fortgesetzt)

| | | |
|---|---|---|
| 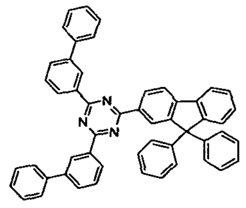 | 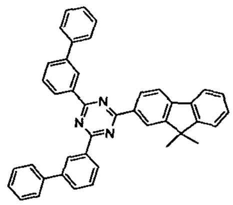 | 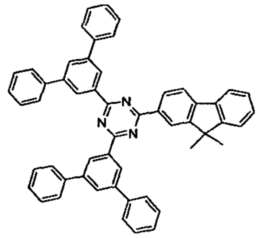 |
| 100 | 101 | 102 |
| 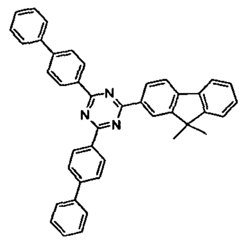 | 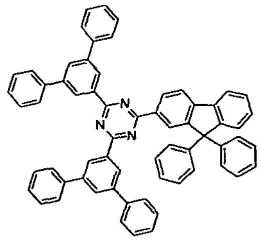 | 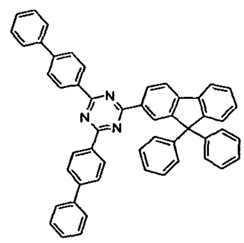 |
| 103 | 104 | 105 |
| 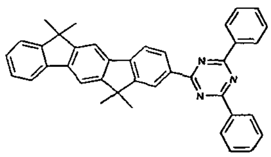 | 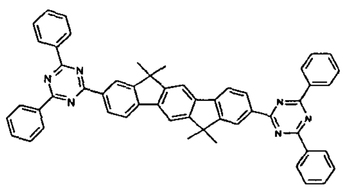 | 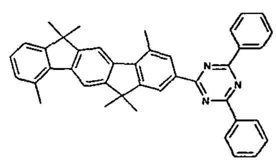 |
| 106 | 107 | 108 |
| 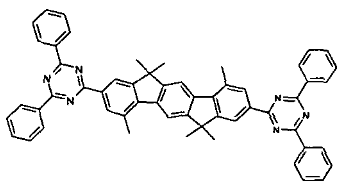 | 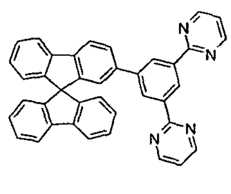 | 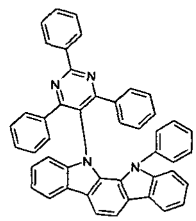 |
| 109 | 110 | 111 |
| 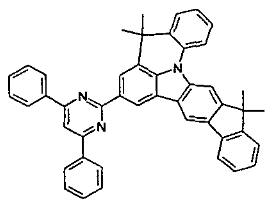 | 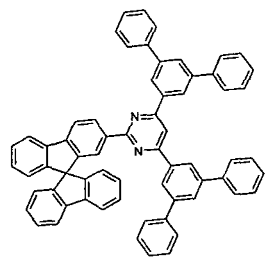 | 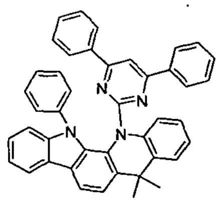 |
| 112 | 113 | 114 |
| 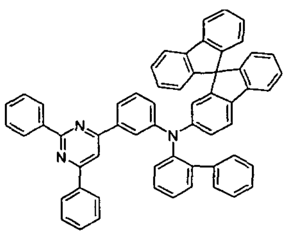 | 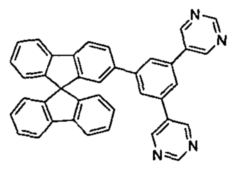 | 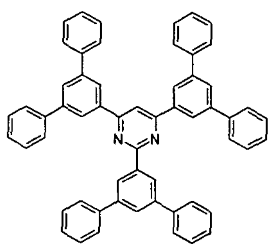 |

(fortgesetzt)

| 115 | 116 | 117 |
|---|---|---|
| 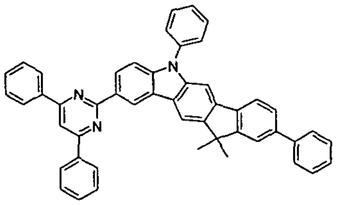 | 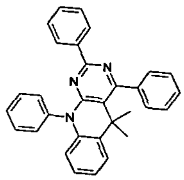 | 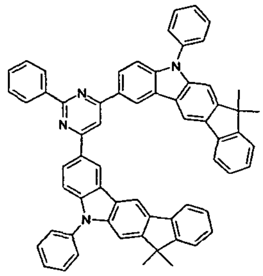 |
| 118 | 119 | 120 |
| 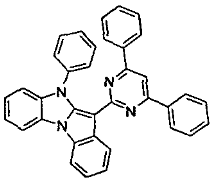 | 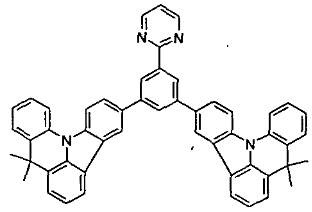 | 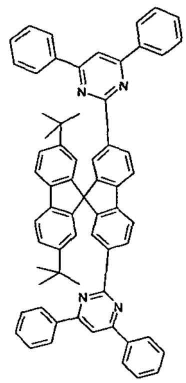 |
| 121 | 122 | 123 |
| 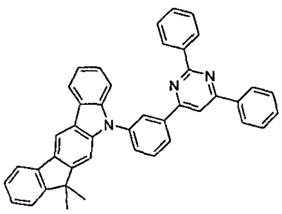 | 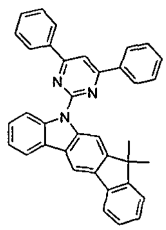 | 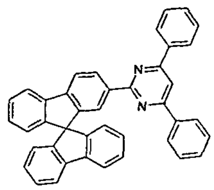 |
| 124 | 125 | 126 |
| 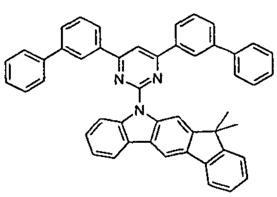 | 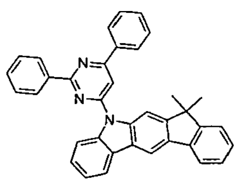 | 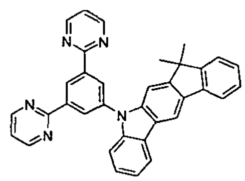 |
| 127 | 128 | 129 |
| 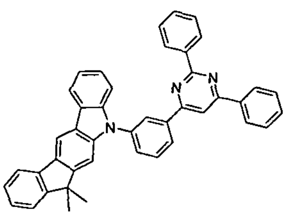 | | |
| 130 | | |

In einer weiteren bevorzugten Ausführungsform der Erfindung ist das elektronenleitende Matrixmaterial ein

aromatisches Keton oder ein aromatisches Phosphinoxid.

Unter einem aromatischen Keton im Sinne dieser Anmeldung wird eine Carbonylgruppe verstanden, an die zwei Aryl- oder Heteroarylgruppen bzw. aromatische oder heteroaromatische Ringsysteme direkt gebunden sind. Unter einem aromatischen Phosphinoxid im Sinne dieser Anmeldung wird eine P=O-Gruppe verstanden, an die drei Aryl- oder Heteroarylgruppen bzw. aromatische oder heteroaromatische Ringsysteme direkt gebunden sind.

In einer bevorzugten Ausführungsform der Erfindung ist das aromatische Keton eine Verbindung der folgenden Formel (23) und das aromatische Phosphinoxid eine Verbindung der folgenden Formel (24),

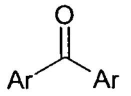

Formel (23)

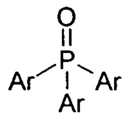

Formel (24)

wobei Ar die oben genannte Bedeutung aufweist.

Geeignete Verbindungen gemäß Formel (23) sind insbesondere die in WO 2004/093207 und WO 2010/006680 offenbarten Ketone. Geeignete Phosphinoxide gemäß Formel (24) sind insbesondere die in WO 2005/003253 offenbarten Phosphinoxide.

Aus der Definition der Verbindung gemäß Formel (23) geht hervor, dass diese nicht nur eine Carbonylgruppe enthalten muss, sondern auch mehrere Carbonylgruppen enthalten kann. Ebenso kann die Verbindung gemäß Formel (24) auch mehrere Phosphinoxidgruppen enthalten.

Bevorzugt ist die Gruppe Ar in Verbindungen gemäß Formel (23) und Formel (24) ein aromatisches Ringsystem mit 6 bis 40 aromatischen Ringatomen, d. h. sie enthält keine Heteroarylgruppen. Wie oben definiert, muss das aromatische Ringsystem nicht notwendigerweise nur aromatische Gruppen aufweisen, sondern es können auch zwei Arylgruppen durch eine nicht-aromatische Gruppe, beispielsweise durch eine weitere Carbonylgruppe bzw. Phosphinoxidgruppe unterbrochen sein.

In einer weiteren bevorzugten Ausführungsform der Erfindung weist die Gruppe Ar nicht mehr als zwei kondensierte Ringe auf. Sie ist also bevorzugt nur aus Phenyl- und/oder Naphthylgruppen, besonders bevorzugt nur aus Phenylgruppen, aufgebaut, enthält aber keine größeren kondensierten Aromaten, wie beispielsweise Anthracen.

Bevorzugte Gruppen Ar, die an die Carbonylgruppe gebunden sind, sind Phenyl, 2-, 3- oder 4-Tolyl, 3- oder 4-o-Xylyl, 2- oder 4-m-Xylyl, 2-p-Xylyl, o-, m- oder p-tert-Butylphenyl, o-, m- oder p-Fluorphenyl, Benzophenon, 1-, 2- oder 3-Phenylmethanon, 2-, 3- oder 4-Biphenyl, 2-, 3- oder 4-o-Terphenyl, 2-, 3- oder 4-m-Terphenyl, 2-, 3- oder 4-p-Terphenyl, 2'-p-Terphenyl, 2'-, 4'- oder 5'-m-Terphenyl, 3'- oder 4'-o-Terphenyl, p-, m,p-, o,p-, m,m-, o,m- oder o,o-Quaterphenyl, Quinquephenyl, Sexiphenyl, 1-, 2-, 3- oder 4-Fluorenyl, 2-, 3- oder 4-Spiro-9,9'-bifluorenyl, 1-, 2-, 3- oder 4-(9,10-Dihydro)phenanthrenyl, 1- oder 2-Naphthyl, 2-, 3-, 4-, 5-, 6-, 7- oder 8-Chinolinyl, 1-, 3-, 4-, 5-, 6-, 7- oder 8-iso-Chinolinyl, 1- oder 2-(4-Methyl-naphthyl), 1- oder 2-(4-Phenylnaphthyl), 1- oder 2-(4-naphthyl-naphthyl), 1-, 2- oder 3-(4-naphthyl-phenyl), 2-, 3- oder 4-Pyridyl, 2-, 4- oder 5-Pyrimidinyl, 2- oder 3-Pyrazinyl, 3- oder 4-Pyridanzinyl, 2-(1,3,5-Triazin)yl-, 2-, 3- oder 4-(Phenylpyridyl), 3-, 4-, 5- oder 6-(2,2'-Bipyridyl), 2-, 4-, 5- oder 6-(3,3'-Bipyridyl), 2- oder 3-(4,4'-Bipyridyl) und Kombinationen eines oder mehrerer dieser Reste.

Die Gruppen Ar können, wie oben definiert, durch einen oder mehrere Reste $R^1$ substituiert sein. Diese Reste $R^1$ sind bevorzugt gleich oder verschieden bei jedem Auftreten gewählt aus der Gruppe bestehend aus H, D, F, $C(=O)Ar^2$, $P(=O)(Ar^2)_2$, $S(=O)Ar^2$, $S(=O)_2Ar^2$, einer geradkettigen Alkylgruppe mit 1 bis 4 C-Atomen oder einer verzweigten oder cyclischen Alkylgruppe mit 3 bis 5 C-Atomen, die jeweils mit einem oder mehreren Resten $R^2$ substituiert sein kann, wobei ein oder mehrere H-Atome durch D oder F ersetzt sein können, oder einem aromatischen Ringsystem mit 6 bis 24 aromatischen Ringatomen, das durch einen oder mehrere Reste $R^2$ substituiert sein kann, oder eine Kombination dieser Systeme; dabei können zwei oder mehrere benachbarte Substituenten $R^1$ auch miteinander ein mono- oder polycyclisches, aliphatisches oder aromatisches Ringsystem bilden. Wenn die organische Elektrolumineszenzvorrichtung aus Lösung aufgebracht wird, sind auch geradkettige, verzweigte oder cyclische Alkylgruppen mit bis zu 10 C-Atomen als Substituenten $R^1$ bevorzugt. Die Reste $R^1$ sind besonders bevorzugt gleich oder verschieden bei jedem Auftreten gewählt aus der Gruppe bestehend aus H, $C(=O)Ar^2$ oder einem aromatischen Ringsystem mit 6 bis 24 aromatischen Ringatomen, das durch einen oder mehrere Reste $R^2$ substituiert sein kann, bevorzugt aber unsubstituiert ist.

In nochmals einer bevorzugten Ausführungsform der Erfindung ist die Gruppe $Ar^2$ gleich oder verschieden bei jedem Auftreten ein aromatisches Ringsystem mit 6 bis 24 aromatischen Ringatomen, das mit einem oder mehreren Resten $R^2$ substituiert sein kann. Besonders bevorzugt ist $Ar^2$ gleich oder verschieden bei jedem Auftreten ein aromatisches Ringsystem mit 6 bis 12 aromatischen Ringatomen.

Besonders bevorzugt sind Benzophenon-Derivate, die jeweils an den 3,5,3',5'-Positionen durch ein aromatisches oder heteroaromatisches Ringsystem mit 5 bis 30 aromatischen Ringatomen substituiert sind, welche wiederum durch einen oder mehrere Reste $R^1$ gemäß der obigen Definition substituiert sein kann. Weiterhin bevorzugt sind Ketone, welche mit mindestens einer Spirobifluorengruppe substituiert sind.

Bevorzugte aromatische Ketone und Phosphinoxide sind daher weiterhin die Verbindungen der folgenden Formel (25) bis (35),

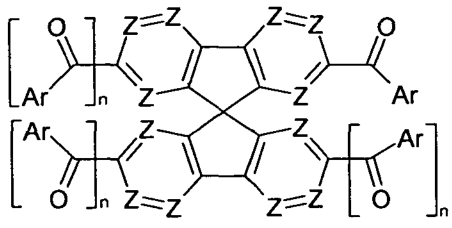

Formel (25)

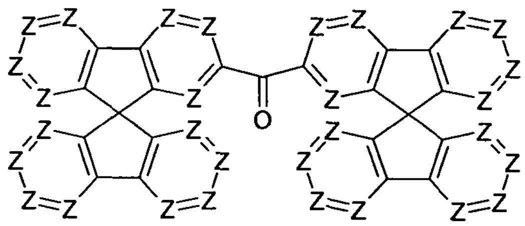

Formel (26)

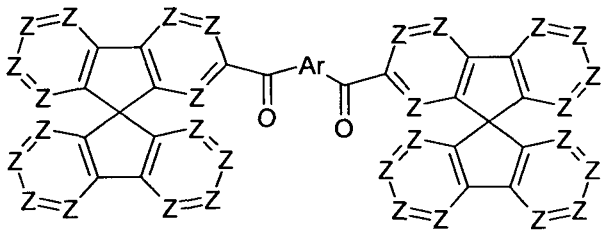

Formel (27)

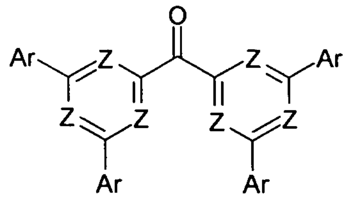

Formel (28)

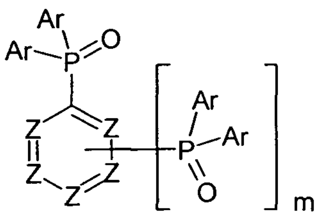

Formel (29)

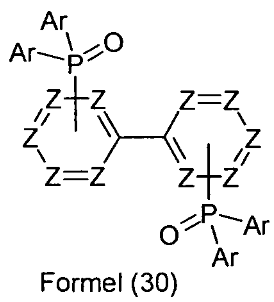

Formel (30)

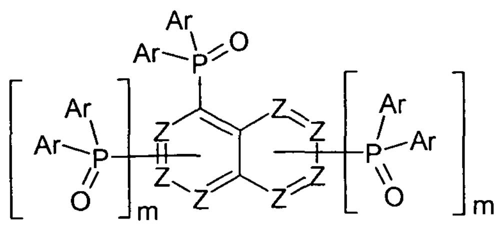

Formel (31)

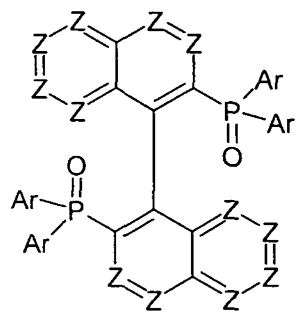

Formel (32)

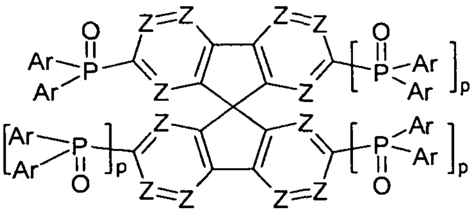

Formel (33)

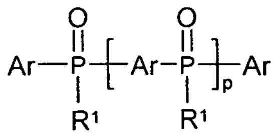

Formel (34)

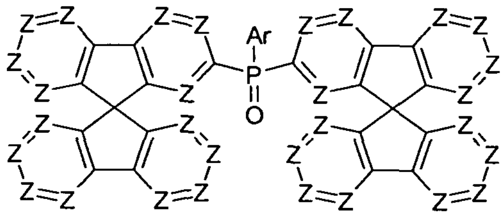

Formel (35)

wobei Ar dieselbe Bedeutung hat, wie oben beschrieben, und weiterhin gilt:

Z ist gleich oder verschieden bei jedem Auftreten $CR^1$ oder N, wobei maximal 3 Symbole Z pro Ring für N stehen; bevorzugt ist Z gleich $CR^1$;

n ist gleich oder verschieden bei jedem Auftreten 0 oder 1.

m ist gleich oder verschieden bei jedem Auftreten 0, 1, 2 oder 3;

p ist gleich oder verschieden bei jedem Auftreten 0 oder 1.

Bevorzugt steht Ar in den oben genannten Formeln für ein aromatisches oder heteroaromatisches Ringsystem mit 5 bis 30 aromatischen Ringatomen, welches keine kondensierten Arylgruppen mit mehr als 10 aromatischen Ringatomen aufweist, bevorzugt überhaupt keine kondensierten Arylgruppen, und welches mit einem oder mehreren Resten $R^1$ substituiert sein kann. Besonders bevorzugt sind die oben als bevorzugt genannten Gruppen Ar. Ebenso besonders bevorzugt sind die oben als bevorzugt genannten Gruppen $R^1$.

Beispiele für geeignete Verbindungen gemäß Formel (23) bis (35) sind die im Folgenden abgebildeten Verbindungen (1) bis (72).

| | |
|---|---|
| 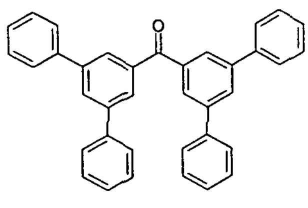 | 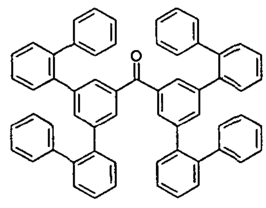 |
| (1) | (2) |
| 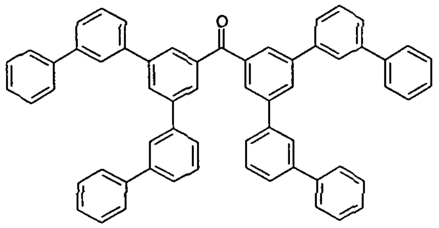 | 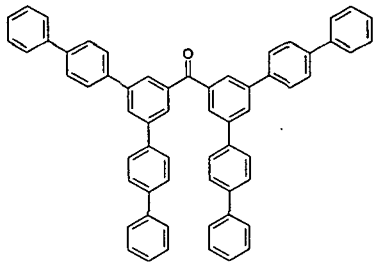 |

(fortgesetzt)

| (3) | (4) |
|---|---|
| 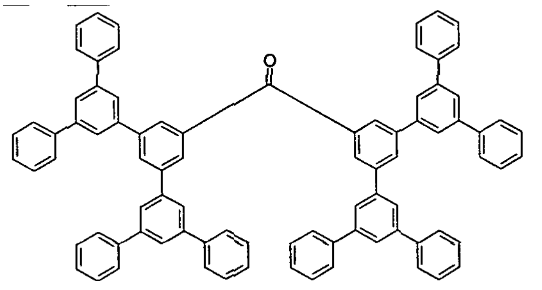 | 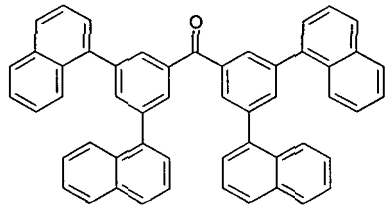 |
| (5) | (6) |
| 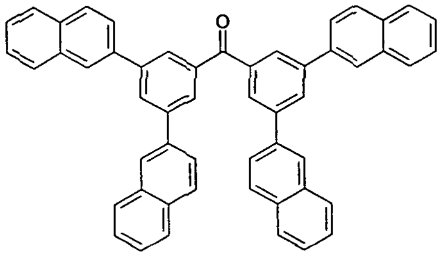 | 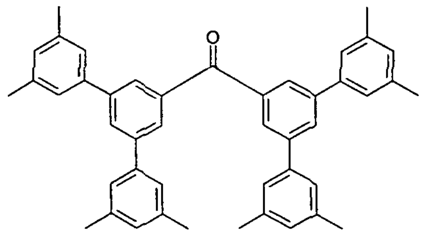 |
| (7) | (8) |
| 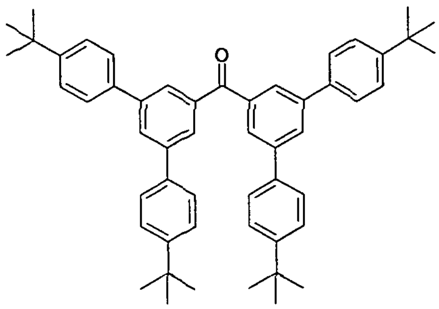 | 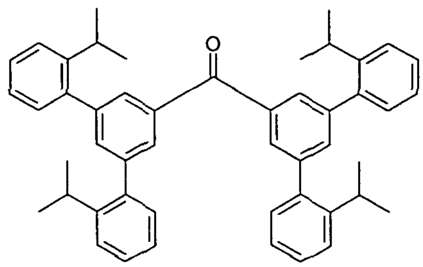 |
| (9) | (10) |
| 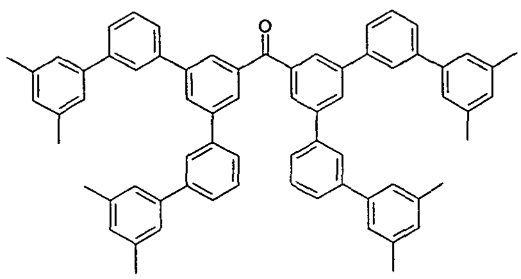 | 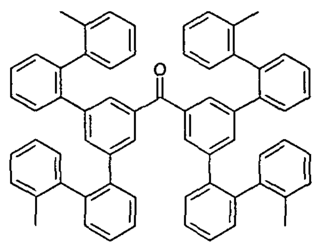 |
| (11) | (12) |

(fortgesetzt)

| | |
|---|---|
| 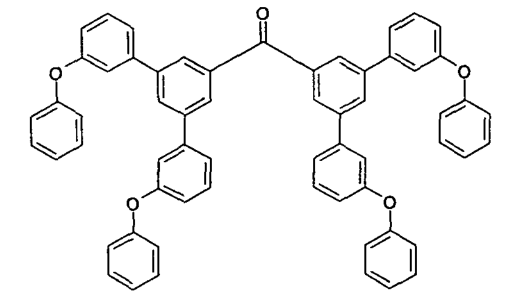 | 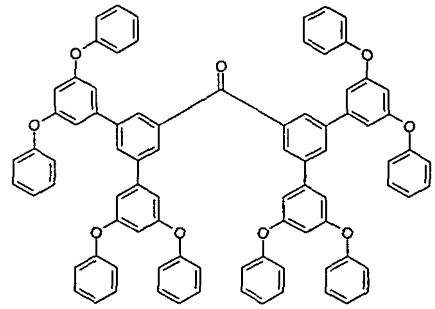 |
| (13) | (14) |
| 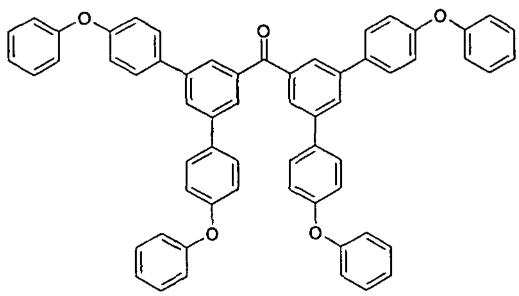 | 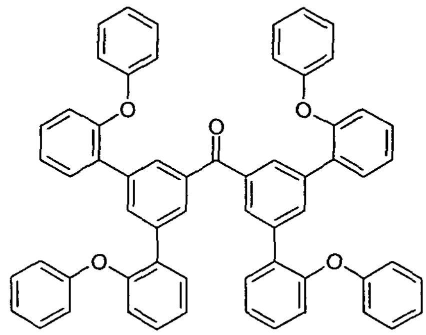 |
| (15) | (16) |
| 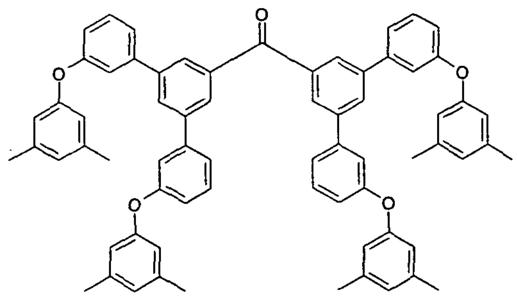 | 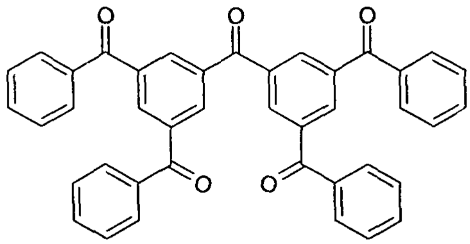 |
| (17) | (18) |
| 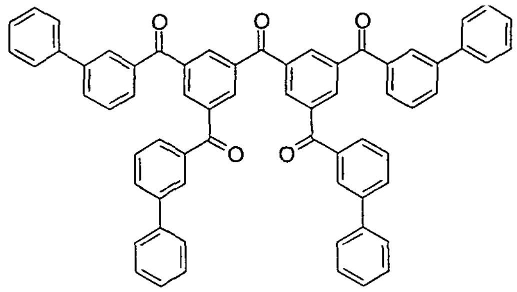 | 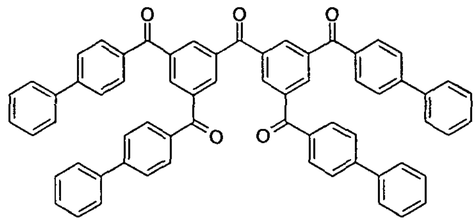 |
| (19) | (20) |

(fortgesetzt)

| | |
|---|---|
| 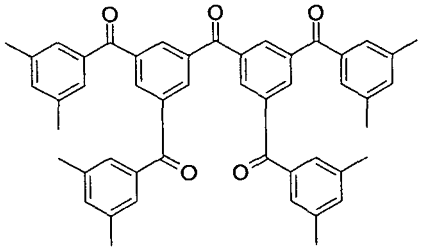 | 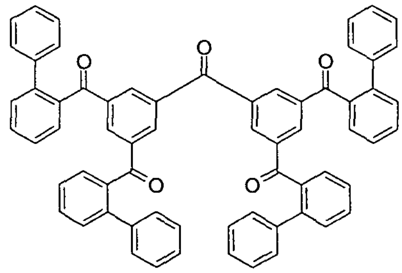 |
| (21) | (22) |
| 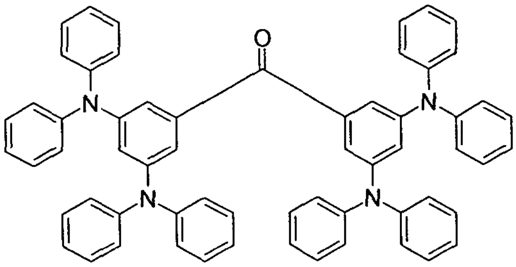 | 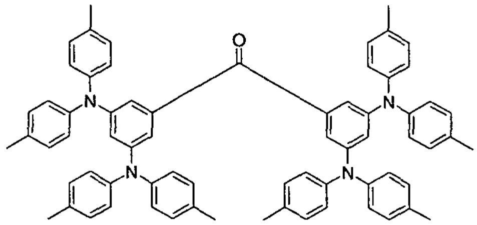 |
| (23) | (24) |
| 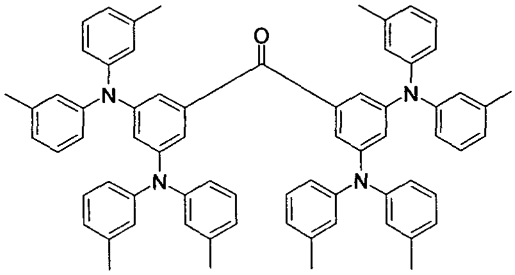 | 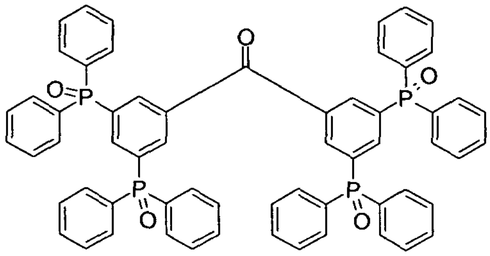 |
| (25) | (26) |
| 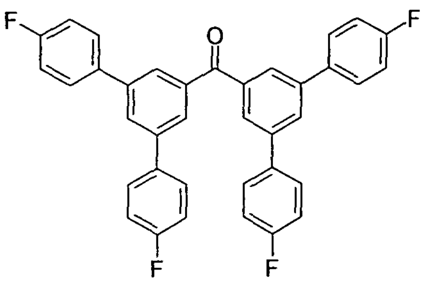 | 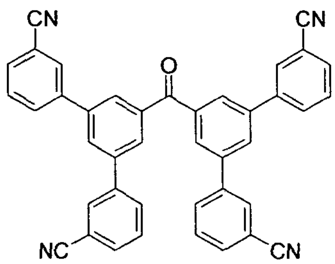 |
| (27) | (28) |
| 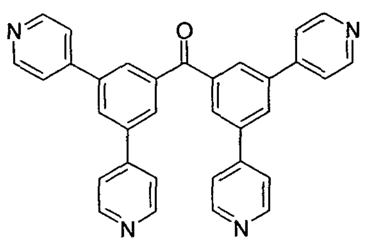 | 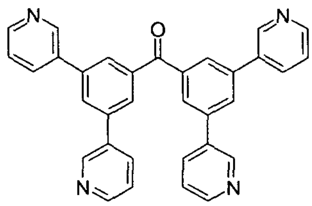 |
| (29) | (30) |

(fortgesetzt)

| | |
|---|---|
| 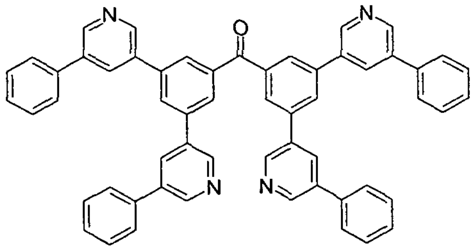 | 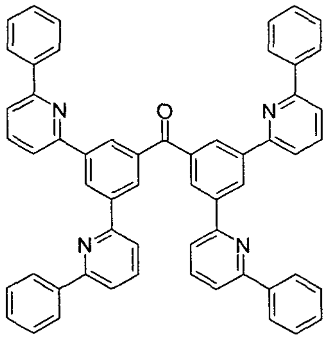 |
| (31) | (32) |
| 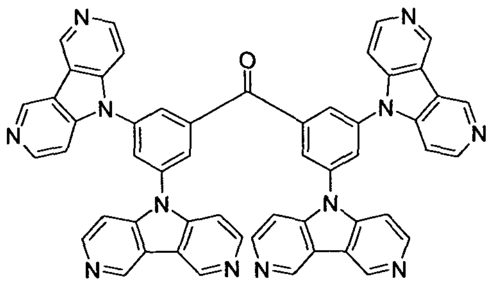 | 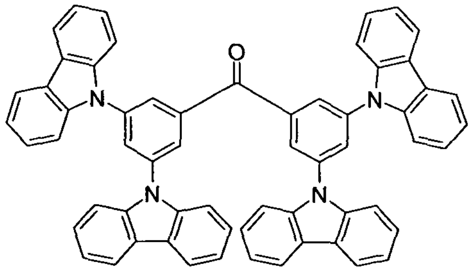 |
| (33) | (34) |
| 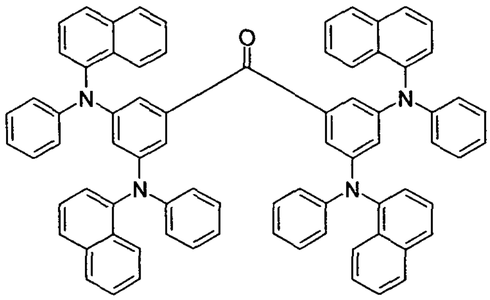 | 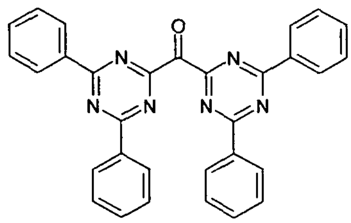 |
| (35) | (36) |
| 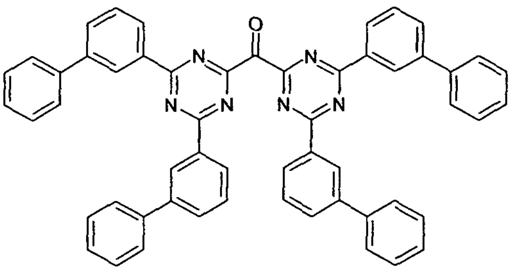 | 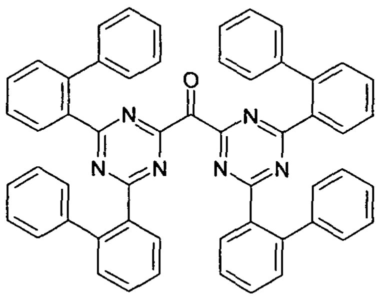 |
| (37) | (38) |

(fortgesetzt)

| | |
|---|---|
| 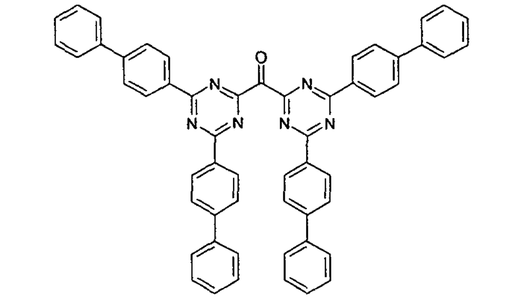 | 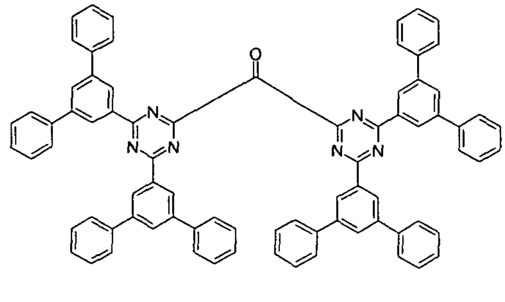 |
| (39) | (40) |
| 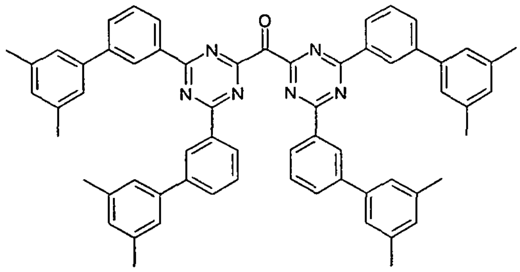 | 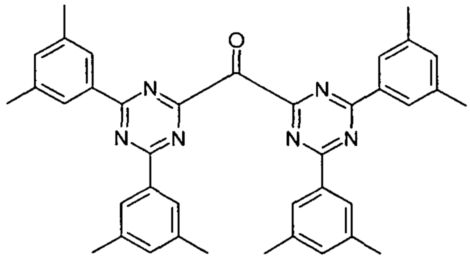 |
| (41) | (42) |
| 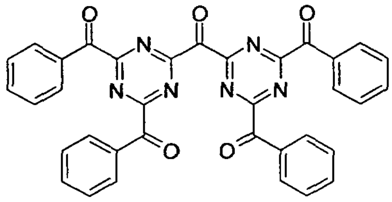 | 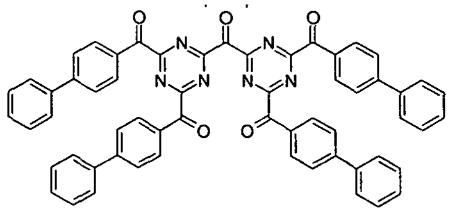 |
| (43) | (44) |
| 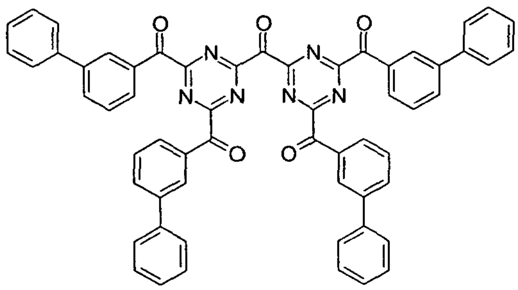 | 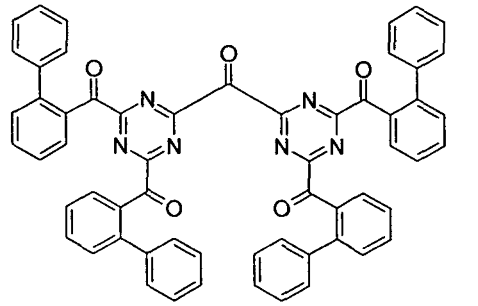 |
| (45) | (46) |
| 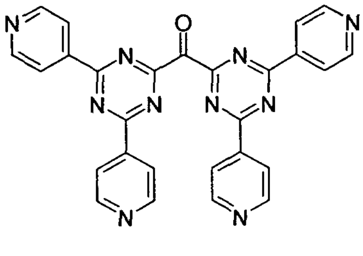 | 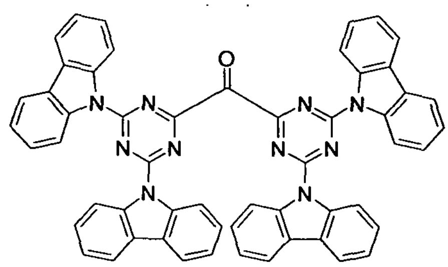 |
| (47) | (48) |

(fortgesetzt)

| | |
|---|---|
| 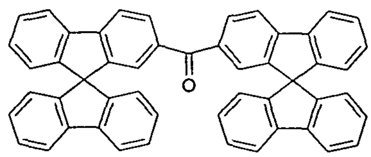 | 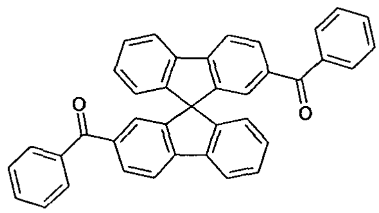 |
| (49) | (50) |
| 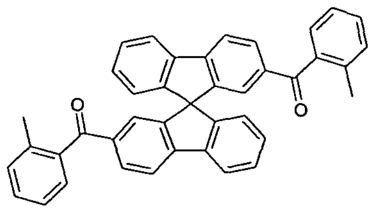 | 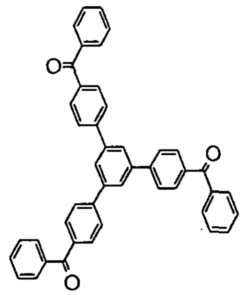 |
| (51) | (52) |
| 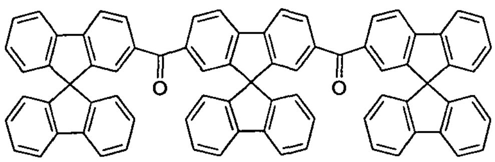 | 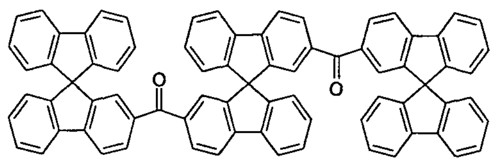 |
| (53) | (54) |
| 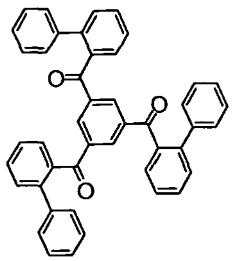 | 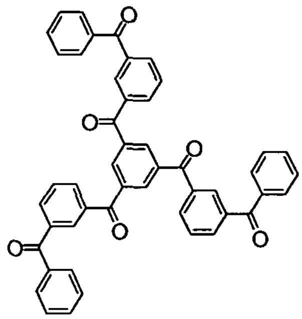 |
| (55) | (56) |
| 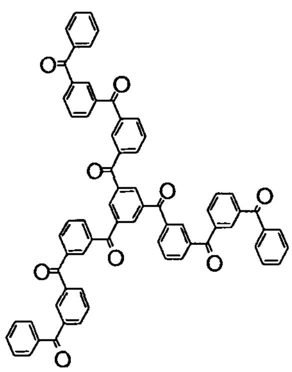 | 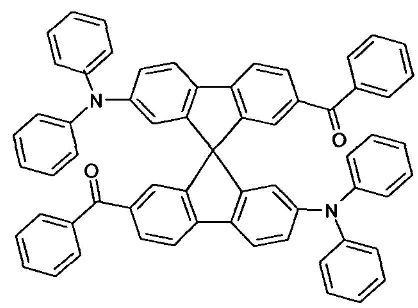 |
| (57) | (58) |

(fortgesetzt)

| | |
|---|---|
| 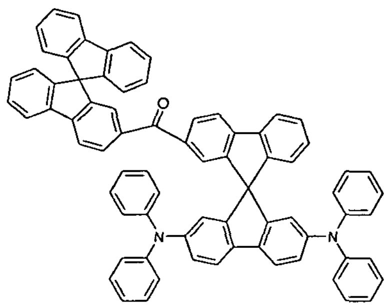 | 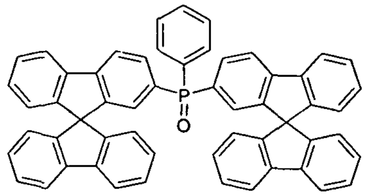 |
| (59) | (60) |
| 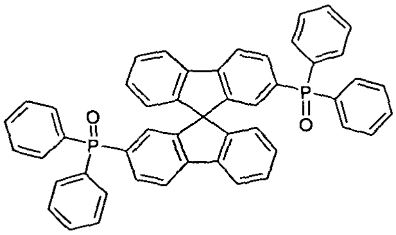 | 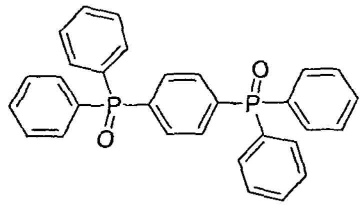 |
| (61) | (62) |
| 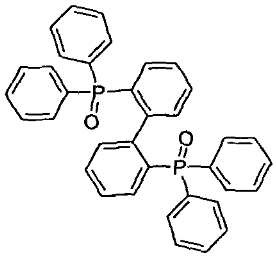 | 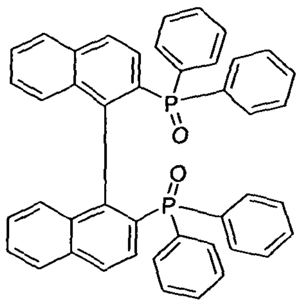 |
| (63) | (64) |
| 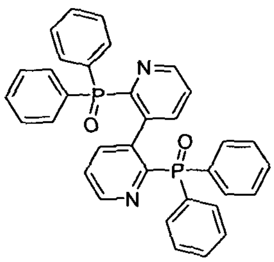 | 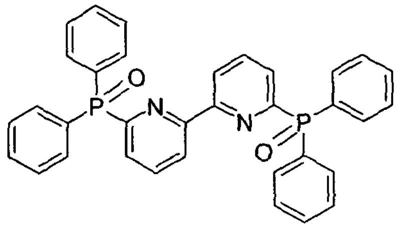 |
| (65) | (66) |
| 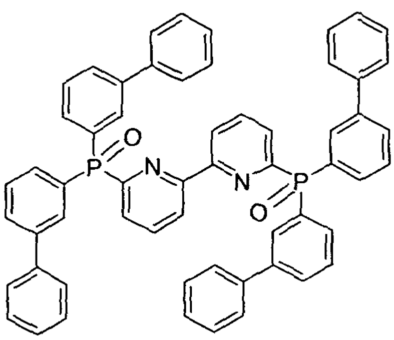 | 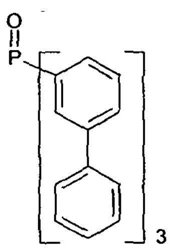 |

(fortgesetzt)

| (67) | (68) |
|---|---|
| 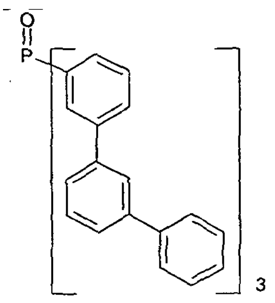 | 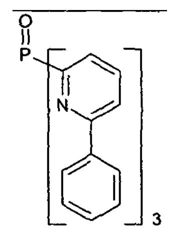 |
| (69) | (70) |
| 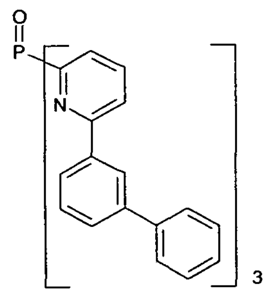 | 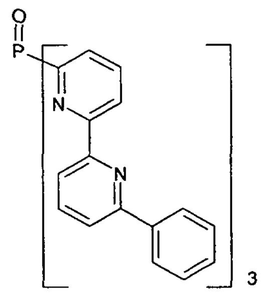 |
| (71) | (72) |

Wie oben beschrieben, handelt es sich bei ETM2 um ein Material, das nicht bzw. nicht wesentlich am Ladungstransport in der Elektronentransportschicht teilnimmt.

In einer bevorzugten Ausführungsform der Erfindung ist ETM2 ein reiner Kohlenwasserstoff, also ein Material, welches nur aus den Atomen Kohlenstoff und Wasserstoff aufgebaut ist und welches keine Atome ungleich Kohlenstoff oder Wasserstoff enthält. In einer besonders bevorzugten Ausführungsform der Erfindung handelt es sich bei ETM2 um einen aromatischen Kohlenwasserstoff. Dieser ist dadurch gekennzeichnet, dass er aromatische Gruppen enthält. Er kann aber zusätzlich auch nicht-aromatische Kohlenstoffatome enthalten, beispielsweise Alkylgruppen.

In einer besonders bevorzugten Ausführungsform der Erfindung ist ETM2 ausgewählt aus der Gruppe bestehend aus Diarylmethan-Derivaten, Fluorenderivaten oder Spirobifluorenderivaten. Besonders geeignete Materialien, die als ETM2 verwendet werden können, sind also Verbindungen der folgenden Formeln (36), (37) und (38),

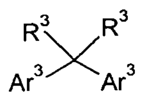

Formel (36)

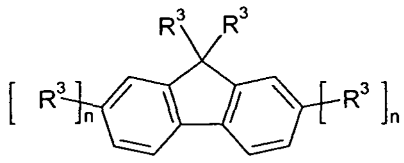

Formel (37)

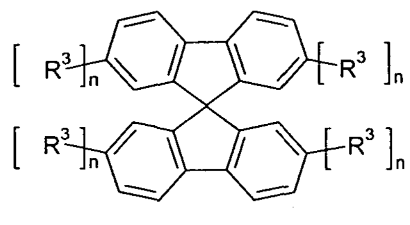

Formel (38)

wobei $R^1$ und n die oben genannte Bedeutung haben und die weiteren verwendeten Symbole die folgenden Bedeutungen haben:

$Ar^3$ ist bei jedem Auftreten gleich oder verschieden ein aromatisches Ringsystem mit 6 bis 60 aromatischen C-Atomen, welches keine nicht-aromatischen Gruppen ungleich Kohlenstoff oder Wasserstoff enthält; dabei kann $Ar^3$ durch einen oder mehrere Reste $R^4$ substituiert sein;

$R^3$ ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, oder ein aromatisches Ringsystem mit 6 bis 60

aromatischen C-Atomen, welches keine nicht-aromatischen Gruppen ungleich Kohlenstoff oder Wasserstoff enthält und welches durch einen oder mehrere Reste $R^4$ substituiert sein kann; dabei können zwei oder mehrere Reste $R^3$ auch miteinander ein Ringsystem bilden;

$R^4$ ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen; dabei können zwei oder mehrere Reste $R^4$ auch miteinander ein Ringsystem bilden.

Beispiele für bevorzugte ETM2 gemäß den oben genannten Formeln (36) bis (38) sind die im Folgenden abgebildeten Verbindungen (1) bis (17).

| | |
|---|---|
| 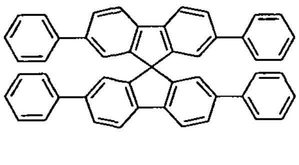 | 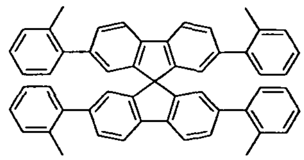 |
| (1) | (2) |
| 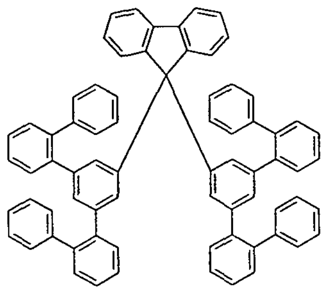 | 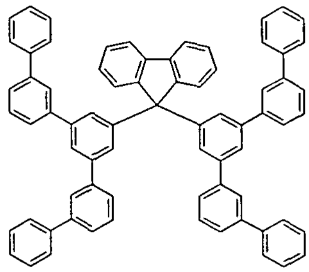 |
| (3) | (4) |
| 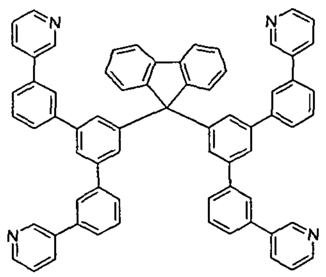 | 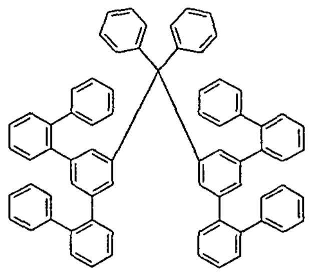 |
| (5) | (6) |
| 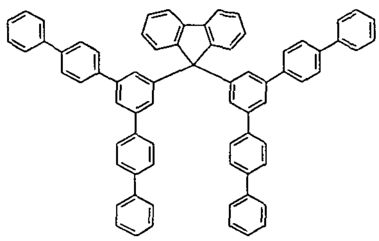 | 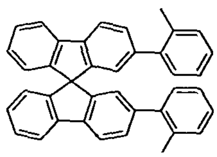 |
| (7) | (8) |

(fortgesetzt)

| | |
|---|---|
| 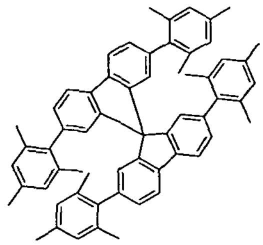 | 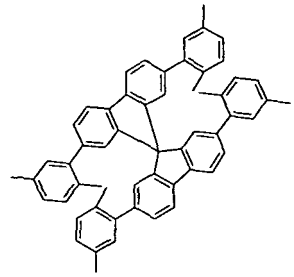 |
| (9) | (10) |
| 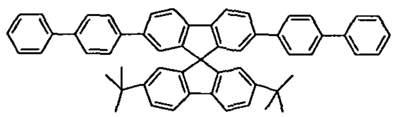 | 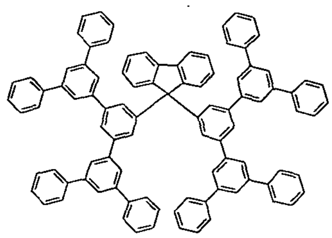 |
| (11) | (12) |
| 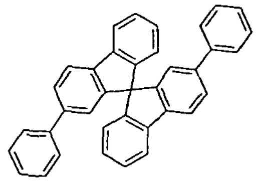 | 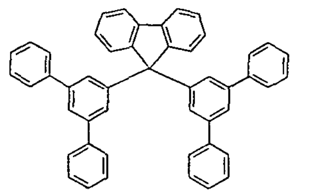 |
| (13) | (14) |
| 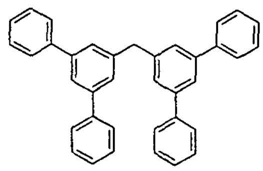 | 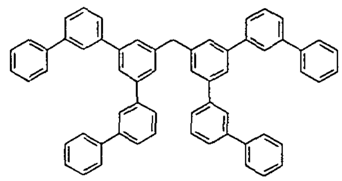 |
| (15) | (16) |
| 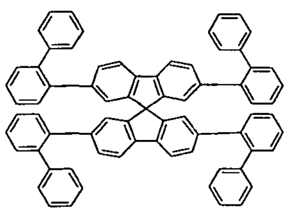 | |
| (17) | |

Weitere bevorzugte Materialien, die als ETM2 verwendet werden können, sind Carbazolderivate. Besonders geeignet sind hier die Verbindungen der folgenden Formel (39) oder (40),

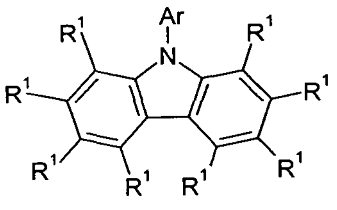

Formel (39)

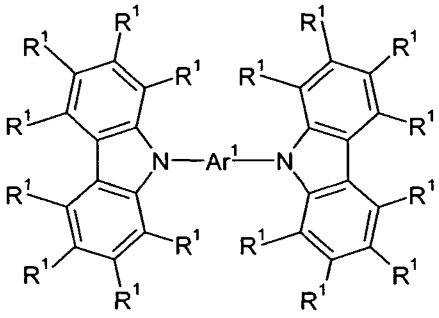

Formel (40)

wobei die verwendeten Symbole die oben genannten Bedeutungen aufweisen.

Beispiele für geeignete Carbazolderivate sind die in der folgenden Tabelle abgebildeten Verbindungen (1) bis (11).

| | |
|---|---|
| 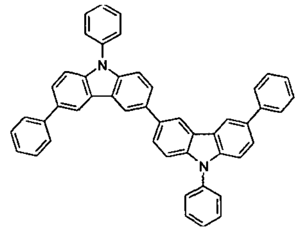 | 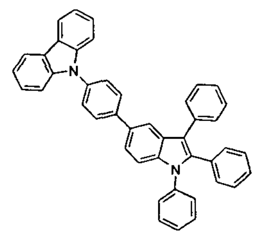 |
| (1) | (2) |
| 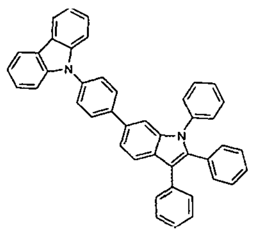 | 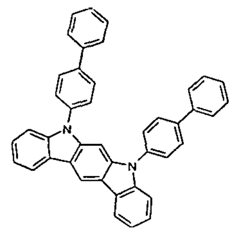 |
| (3) | (4) |
| 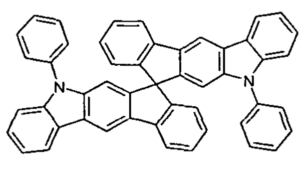 | 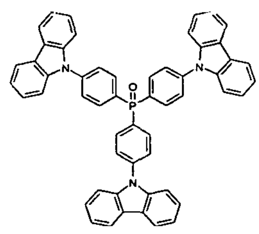 |
| (5) | (6) |
| 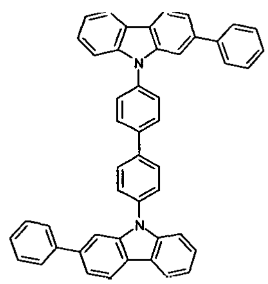 | 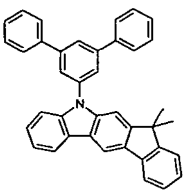 |
| (7) | (8) |

(fortgesetzt)

| | |
|---|---|
| 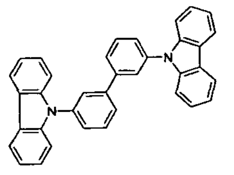 | 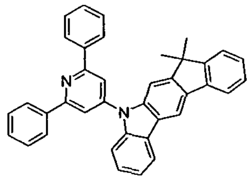 |
| (9) | (10) |
| 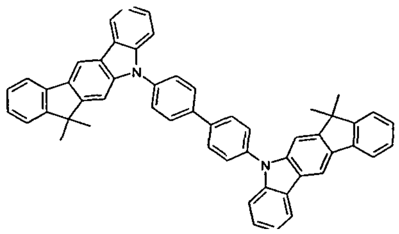 | |
| (11) | |

In einer weiteren bevorzugten Ausführungsform der Erfindung handelt es sich bei dem Material ETM2 um ein Diazasilolderivat oder ein Tetraazasilolderivat, z. B. gemäß WO 2010/054729.

Außer Kathode, Anode, der emittierenden Schicht und der oben beschriebenen, direkt an die emittierende Schicht angrenzenden Elektronentransportschicht kann die organische Elektrolumineszenzvorrichtung noch weitere Schichten enthalten. Diese sind beispielsweise gewählt aus jeweils einer oder mehreren Lochinjektionsschichten, Lochtransportschichten, weiteren Elektronentransportschichten, Elektroneninjektionsschichten, Elektronenblockierschichten, Exzitonenblockierschichten, Ladungserzeugungsschichten (Charge-Generation Layers) und/oder organischen oder anorganischen p/n-Übergängen. Außerdem können Zwischenschichten vorhanden sein, insbesondere als Zwischenschicht zwischen einer fluoreszierenden und einer phosphoreszierenden Schicht. Weiterhin können die Schichten, insbesondere die Ladungstransportschichten, auch dotiert sein. Die Dotierung der Schichten kann für einen verbesserten Ladungstransport vorteilhaft sein. Es sei aber darauf hingewiesen, dass nicht notwendigerweise jede der oben genannten Schichten vorhanden sein muss und die Wahl der Schichten immer von den verwendeten Verbindungen abhängt. Die Verwendung derartiger Schichten ist dem Fachmann bekannt, und er kann hierfür ohne erfinderisches Zutun alle für derartige Schichten bekannten Materialien gemäß dem Stand der Technik verwenden.

Weiterhin ist es möglich, mehr als eine emittierende Schicht zu verwenden, beispielsweise zwei oder drei emittierende Schichten, wobei diese bevorzugt unterschiedliche Emissionsfarben aufweisen. In einer Ausführungsform der Erfindung handelt es sich um eine weiß emittierende organische Elektrolumineszenzvorrichtung. Diese ist dadurch charakterisiert, dass sie Licht mit CIE-Farbkoordinaten im Bereich von 0.28/0.29 bis 0.45/0.41 emittiert. Der allgemeine Aufbau einer derartigen weiß emittierenden Elektrolumineszenzvorrichtung ist beispielsweise in WO 2005/011013 offenbart.

Als Kathode der erfindungsgemäßen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Ebenso bevorzugt sind Metalllegierungen, insbesondere Legierungen aus einem Alkalimetall oder Erdalkalimetall und Silber, besonders bevorzugt eine Legierung aus Mg und Ag. Es kann auch bevorzugt sein, zwischen einer metallischen Kathode und dem organischen Halbleiter eine dünne Zwischenschicht eines Materials mit einer hohen Dielektrizitätskonstante einzubringen.

Hierfür kommen beispielsweise Alkalimetall- oder Erdalkalimetallfluoride, aber auch die entsprechenden Oxide oder Carbonate (z. B. LiF, $Li_2O$, $Li_3N$, CsF, RbF, $Cs_2CO_3$, $BaF_2$, MgO, NaF, etc.) oder Metallkomplexe (z. B. Lithiumhydroxychinolinat) in Frage. Die Schichtdicke dieser Schicht beträgt bevorzugt zwischen 0.5 und 5 nm.

In einer bevorzugten Ausführungsform der Erfindung wird zwischen der metallischen Kathode und der erfindungsgemäßen Elektronentransportschicht eine Elektroneninjektionsschicht verwendet, wobei die Elektroneninjektionsschicht bevorzugt eines der oben genannten Materialien enthält.

Als Anode der erfindungsgemäßen Elektrolumineszenzvorrichtung sind Materialien mit hoher Austrittsarbeit bevorzugt. Bevorzugt weist die Anode eine Austrittsarbeit größer 4.5 eV vs. Vakuum auf. Hierfür sind einerseits Metalle

mit hohem Redoxpotential geeignet, wie beispielsweise Ag, Pt oder Au. Es können andererseits auch Metall/Metalloxid-Elektroden (z. B. $Al/Ni/NiO_x$, $Al/PtO_x$) bevorzugt sein. Dabei muss mindestens eine der Elektroden transparent oder teiltransparent sein, um die Auskopplung von Licht zu ermöglichen. Bevorzugte Anodenmaterialien für transparente oder teiltransparente Anoden sind leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Es können generell alle weiteren Materialien, wie sie gemäß dem Stand der Technik in organischen Elektrolumineszenzvorrichtungen eingesetzt werden, in Kombination mit der erfindungsgemäßen Elektronentransportschicht eingesetzt werden.

Dabei kann die emittierende Schicht phosphoreszierend oder fluoreszierend sein. Es ist auch möglich, dass sowohl eine fluoreszierende, wie auch eine phosphoreszierende Emitterschicht vorliegen.

In einer bevorzugten Ausführungsform der Erfindung handelt es sich bei der emittierenden Schicht um eine fluoreszierende Schicht, insbesondere um eine blau oder grün fluoreszierende Schicht.

Bevorzugte Dotanden, welche in der fluoreszierenden Emitterschicht eingesetzt werden können, sind ausgewählt aus der Klasse der Monostyrylamine, der Distyrylamine, der Tristyrylamine, der Tetrastyrylamine und der Arylamine. Unter einem Monostyrylamin wird eine Verbindung verstanden, die eine substituierte oder unsubstituierte Styrylgruppe und mindestens ein, bevorzugt aromatisches, Amin enthält. Unter einem Distyrylamin wird eine Verbindung verstanden, die zwei substituierte oder unsubstituierte Styrylgruppen und mindestens ein, bevorzugt aromatisches, Amin enthält. Unter einem Tristyrylamin wird eine Verbindung verstanden, die drei substituierte oder unsubstituierte Styrylgruppen und mindestens ein, bevorzugt aromatisches, Amin enthält. Unter einem Tetrastyrylamin wird eine Verbindung verstanden, die vier substituierte oder unsubstituierte Styrylgruppen und mindestens ein, bevorzugt aromatisches, Amin enthält. Die Styrylgruppen sind besonders bevorzugt Stilbene, die auch noch weiter substituiert sein können. Unter einem Arylamin bzw. einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 2- oder 9-Position. Unter einem aromatischen Anthracendiamin wird eine Verbindung verstanden, in der zwei Diarylaminogruppen direkt an eine Anthracengruppe gebunden sind, vorzugsweise in 2,6- oder 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte fluoreszierende Dotanden sind gewählt aus Indenofluorenaminen bzw. -diaminen, beispielsweise gemäß WO 2006/122630, Benzoindenofluorenaminen bzw. -diaminen, beispielsweise gemäß WO 2008/006449, und Dibenzoindenofluorenaminen bzw. -diaminen, beispielsweise gemäß WO 2007/140847. Beispiele für Dotanden aus der Klasse der Styrylamine sind substituierte oder unsubstituierte Tristilbenamine oder die Dotanden, die in WO 2006/000388, WO 2006/058737, WO 2006/000389, WO 2007/065549 und WO 2007/115610 beschrieben sind. Weiterhin bevorzugte fluoreszierende Dotanden sind kondensierte aromatische Kohlenwasserstoffe, wie beispielsweise die in WO 2010/012328 offenbarten Verbindungen. Diese weisen bevorzugt keine Arylaminogruppen auf. Besonders bevorzugte fluoreszierende Dotanden sind die oben aufgeführten aromatischen Kohlenwasserstoffe gemäß WO 2010/012328, die keine Arylaminogruppen aufweisen, und aromatische Amine, welche mindestens eine kondensierte aromatische Gruppe mit mindestens 14 aromatischen Ringatomen enthält, und kondensierte aromatische Kohlenwasserstoffe.

Geeignete Hostmaterialien (Matrixmaterialien) für den fluoreszierenden Dotanden, insbesondere für die oben genannten Dotanden, sind beispielsweise ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, der polypodalen Metallkomplexe (z. B. gemäß WO 2004/081017), der elektronenleitenden Verbindungen, insbesondere Ketone, Phosphinoxide, Sulfoxide, etc. (z. B. gemäß WO 2005/084081 und WO 2005/084082), der Atropisomere (z. B. gemäß WO 2006/048268), der Boronsäurederivate (z. B. gemäß WO 2006/117052), der Benzanthracenderivate (z. B. Benz-[a]anthracenderivate gemäß WO 2008/145239 oder gemäß der nicht offen gelegten Anmeldung DE 102009034625.2) und der Benzophenanthrenderivate (z. B. Benz[c]phenanthrenderivate gemäß WO 2010/083869). Besonders bevorzugte Hostmaterialien sind ausgewählt aus den Klassen der Oligoarylene, enthaltend Naphthalin, Anthracen, Benzanthracen, insbesondere Benz[a]anthracen, Benzophenanthren, insbesondere Benz[c] phenanthren, und/oder Pyren. Unter einem Oligoarylen im Sinne dieser Erfindung soll eine Verbindung verstanden werden, in der mindestens drei Aryl- bzw. Arylengruppen aneinander gebunden sind.

Besonders bevorzugte Hostmaterialien für fluoreszierende Emitter sind Verbindungen der folgenden Formel (41),

$Ar^4$-Ant-$Ar^4$ Formel (41)

wobei $R^1$ die oben aufgeführte Bedeutung aufweist und für die weiteren verwendeten Symbole gilt:

Ant steht für eine Anthracengruppe, welche in 9- und 10-Position durch die Gruppen $Ar^4$ substituiert ist und welche weiterhin durch einen oder mehrere Substituenten $R^1$ substituiert sein kann;

$Ar^4$ ist gleich oder verschieden bei jedem Auftreten ein aromatisches oder heteroaromatisches Ringsystem mit 5 bis 60 aromatischen Ringatomen, welches durch einen oder mehrere Reste $R^1$ substituiert sein kann.

In einer bevorzugten Ausführungsform der Erfindung enthält mindestens eine der Gruppen $Ar^4$ eine kondensierte Arylgruppe mit 10 oder mehr aromatischen Ringatomen, wobei $Ar^4$ durch einen oder mehrere Reste $R^1$ substituiert sein kann. Bevorzugte Gruppen $Ar^4$ sind gleich oder verschieden bei jedem Auftreten ausgewählt aus der Gruppe bestehend aus Phenyl, 1-Naphthyl, 2-Naphthyl, Anthracenyl, ortho-, meta- oder para-Biphenyl, Phenylen-1-naphthyl, Phenylen-2-naphthyl, Phenanthrenyl, Benz[a]anthracenyl, Benz[c]phenanthrenyl oder Kombinationen aus zwei oder drei dieser Gruppen, welche jeweils durch einen oder mehrere Reste $R^1$ substituiert sein können.

In einer weiteren bevorzugten Ausführungsform der Erfindung enthält die emittierende Schicht einen phosphoreszierenden Emitter.

Unter Phosphoreszenz im Sinne dieser Erfindung wird die Lumineszenz aus einem angeregten Zustand mit Spinmultiplizität > 1, insbesondere aus einem angeregten Triplettzustand verstanden. Im Sinne dieser Erfindung sollen alle lumineszierenden Übergangsmetallkomplexe mit Übergangsmetallen der zweiten und dritten Übergangsmetallreihe, insbesondere alle lumineszierenden Iridium-, Platin- und Kupferverbindungen als phosphoreszierende Verbindungen angesehen werden.

In einer bevorzugten Ausführungsform der Erfindung handelt es sich bei der phosphoreszierenden Verbindung um eine rot phosphoreszierende Verbindung oder um eine grün phosphoreszierende Verbindung.

Als phosphoreszierende Verbindung eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als Phosphoreszenzemitter Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenz bekannt sind, und der Fachmann kann ohne erfinderisches Zutun weitere phosphoreszierende Verbindungen verwenden. Insbesondere ist dem Fachmann bekannt, welche phosphoreszierenden Komplexe mit welcher Emissionsfarbe emittieren.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107, WO 2011/060867 oder DE 102010005697.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons oder eines Triazinderivates mit einem Triarylaminderivat oder einem Carbazolderivat als gemischte Matrix. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Gerade bei der Verwendung einer Mischung aus zwei oder mehr Matrixmaterialien, insbesondere einer Mischung aus einem eher lochleitenden und einem eher elektronenleitenden Matrixmaterial, lassen sich durch die Verwendung der erfindungsgemäßen Elektronentransportschicht besonders deutliche Verbesserungen der Eigenschaften der OLED erzielen. Daher ist die Verwendung einer Mischung aus zwei oder mehr Matrixmaterialien, insbesondere aus einem lochleitenden und einem elektronenleitenden Matrixmaterial in Kombination mit der erfindungsgemäßen Elektronentransportschicht eine bevorzugte Ausführungsform der Erfindung.

Geeignete Ladungstransportmaterialien, wie sie in der Lochinjektions- bzw. Lochtransportschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Beispiele für bevorzugte Lochtransportmaterialien, die in einer Lochtransport- oder Lochinjektionsschicht in der erfindungsgemäßen Elektrolumineszenzvorrichtung verwendet werden können, sind Indenofluorenamine und Derivate (z. B. gemäß WO 2006/122630 oder WO 2006/100896), die in EP 1661888 offenbarten Aminderivate, Hexaazatriphenylenderivate (z. B. gemäß WO 2001/049806), Aminderivate mit kondensierten Aromaten (z. B. gemäß US 5,061,569), die in WO 95/09147 offenbarten Aminderivate, Monobenzoindenofluorenamine (z. B. gemäß WO 2008/006449) oder Dibenzoindenofluorenamine (z. B. gemäß WO 2007/140847). Weiterhin geeignete Lochtransport- und Lochinjektionsmaterialien sind Derivate der oben abgebildeten Verbindungen, wie sie in JP 2001/226331, EP 676461, EP 650955, WO 2001/049806, US 4780536, WO 98/30071, EP 891121, EP 1661888, JP 2006/253445, EP 650955, WO 2006/073054 und US 5061569 offenbart werden.

Die erfindungsgemäße organische Elektrolumineszenzvorrichtung kann durch verschiedene Verfahren hergestellt werden. Ein weiterer Gegenstand der vorliegenden Erfindung ist daher ein Verfahren zur Herstellung einer organischen Elektrolumineszenzvorrichtung, wie im Folgenden erläutert.

Bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es sei jedoch angemerkt, dass der Anfangsdruck auch noch geringer sein kann, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle-Printing, hergestellt werden. Hierfür sind lösliche Verbindungen nötig. Hohe Löslichkeit lässt sich durch geeignete Substitution der Verbindungen erreichen. Dabei können nicht nur Lösungen aus einzelnen Materialien aufgebracht werden, sondern auch Lösungen, die mehrere Verbindungen enthalten, beispielsweise Matrixmaterialien und Dotanden.

Die organische Elektrolumineszenzvorrichtung kann auch als Hybridsystem hergestellt werden, indem eine oder mehrere Schichten aus Lösung aufgebracht werden und eine oder mehrere weitere Schichten aufgedampft werden. So ist es beispielsweise möglich, die emittierende Schicht aus Lösung aufzubringen und darauf die erfindungsgemäße Elektronentransportschicht im Vakuum aufzudampfen.

Diese Verfahren sind dem Fachmann generell bekannt und können von ihm ohne erfinderisches Zutun auf die erfindungsgemäßen organischen Elektrolumineszenzvorrichtungen angewandt werden.

Die organische Elektrolumineszenzvorrichtung kann für verschiedene Anwendungen verwendet werden, insbesondere für Display-Anwendungen oder als Lichtquelle, beispielsweise für Beleuchtungsanwendungen oder für medizinische Anwendungen.

Die erfindungsgemäßen organischen Elektrolumineszenzvorrichtungen weisen folgende überraschende Vorteile gegenüber dem Stand der Technik auf:

1. Die erfindungsgemäße organische Elektrolumineszenzvorrichtung weist eine hohe Effizienz auf. Dabei ist die Effizienz besser als bei Verwendung einer Elektronentransportschicht, die nur eines der Materialien ETM1 oder ETM2 enthält.

2. Die erfindungsgemäße organische Elektrolumineszenzvorrichtung weist gleichzeitig eine verbesserte Lebensdauer auf. Dabei ist die Lebensdauer höher als bei Verwendung einer Elektronentransportschicht, die nur eines der Materialien ETM1 oder ETM2 enthält.

3. Es ist nicht erforderlich, eine Lochblockierschicht zu verwenden, wie sie ansonsten üblicherweise in Kombination mit phosphoreszierenden Emitterschichten verwendet wird. Die erfindungsgemäße Elektrolumineszenzvorrichtung

weist somit einen einfacheren Aufbau auf, was einen klaren Vorteil darstellt. Dieser Vorteil zeigt sich insbesondere bei Verwendung eines Mixed Host Systems in der emittierenden Schicht, wie es gemäß dem Stand der Technik häufig besonders bei phosphoreszierenden Emissionsschichten verwendet wird.

4. Durch entsprechende Mischungsverhältnisse von ETM1 und ETM2 können Elektroneninjektion und Elektronentransport so eingestellt werden, dass das Bauteil entweder bezüglich der Lebensdauer, der Spannung oder der Effizienz optimiert wird, je nach gewünschter Anwendung.

5. Durch entsprechende Mischungsverhältnisse von ETM1 und ETM2 können Elektroneninjektion und Elektronentransport so eingestellt werden, dass sie, je nach Devicearchitektur (z. B. top emission oder bottom emission) und je nach Emissionsfarbe der Vorrichtung, bei Verwendung der benötigten optischen Schichtdicke der Elektronentransportschicht gleichzeitig auch zu einer für das Bauteil optimalen Ladungsbalance führen.

6. Gesundheitsschädliche Substanzen, insbesondere Hydroxychinolin-Metallkomplexe, können vermieden werden.

Die Erfindung wird durch die nachfolgenden Beispiele genauer beschrieben, ohne sie dadurch einschränken zu wollen. Der Fachmann kann, ohne erfinderisch tätig zu werden, weitere erfindungsgemäße organische Elektrolumineszenzvorrichtungen herstellen.

## Beispiele:

### Bestimmung der HOMO/LUMO Lagen und des Triplett-Niveaus der Materialien (allgemeines Verfahren)

Die HOMO- und LUMO-Lagen sowie das Triplett-Niveau der Materialien werden über quantenchemische Rechnungen bestimmt. Hierzu wird das Programmpaket "Gaussian03W" (Gaussian Inc.) verwendet. Zur Berechnung organischer Substanzen ohne Metalle (in Tabelle 4 mit Methode "org." bezeichnet) wird zuerst eine Geometrieoptimierung mit der Methode "Ground State/Semi-empirical/Default Spin/AM1/Charge O/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31G(d)" verwendet (Charge 0, Spin Singlet). Für metallorganische Verbindungen (in Tabelle 4 mit Methode "M-org." bezeichnet) wird die Geometrie über die Methode "Ground State/Hartree-Fock/Default Spin/LanL2MB/Charge 0/Spin Singlet" optimiert. Die Energierechnung erfolgt analog zu den organischen Substanzen wie oben beschrieben mit dem Unterschied, dass für das Metallatom der Basissatz "LanL2DZ" und für die Liganden der Basissatz "6-31 G(d)" verwendet wird. Aus der Energierechnung erhält man das HOMO HEh bzw. LUMO LEh in Hartree-Einheiten. Daraus werden die anhand von Cyclovoltammetriemessungen kalibrierten HOMO und LUMO Werte in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO bzw. LUMO der Materialien anzusehen. Als Beispiel erhält man für die Substanz ETM2-2 aus der Rechnung ein HOMO von -0.19767 Hartrees und ein LUMO von - 0.04783 Hartrees, was einem kalibrierten HOMO von -5.68346 eV und einem kalibrierten LUMO von -2.38675 eV entspricht.
Das Triplett-Niveau $T_1$ ist definiert als die Energie des Triplett-Zustands mit der niedrigsten Energie, der sich aus der quantenchemischen Rechnung ergibt.
In Tabelle 6 sind die HOMO- und LUMO-Werte sowie die Triplett-Niveaus $T_1$ der verschiedenen Materialien angegeben.

### Herstellung der OLEDs (Allgemeines Verfahren)

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, Materialien) angepasst wird.
In den folgenden Beispielen werden die Daten verschiedener OLEDs gezeigt. Glassubstrate, die mit strukturiertem ITO (Indium-Zinn-Oxid) der Dicke 50 nm beschichtet sind, werden mit einem alkalischen Detergenz intensiv

gereinigt und anschliessend 3x mit deionisiertem Wasser gespült. Nach Trocknung und Ausheizen dieser Substrate werden diese mit einem Sauerstoffplasma 5 Minuten vorbehandelt und danach sofort in einer Vakuumkammer mit OLED Materialien beschichtet. Die OLEDs haben prinzipiell folgenden Schichtaufbau: Substrat / Lochinjektionsschichten (HIL) / Lochtransportschichten (HTL) / Emissionsschicht (EML) / Elektronentransportschichten (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 5 gezeigt.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1(95%):D1(5%) bedeutet, dass das Material M1 in einem Volumenanteil von 95% und D1 in einem Volumenanteil von 5% in der Schicht vorliegt. Gegenstand der Erfindung ist es, dass entsprechend auch in der Elektronentransportschicht eine Mischung aus mindestens zwei Materialien, wie z.B. ETM1-1(50%):ETM2-1 (50%), vorliegt.

Die OLEDs werden standardmäßig charakterisiert. Hierfür werden die Elektrolumineszenzspektren, die Stromeffizienz (gemessen in cd/A) in Abhängigkeit der Leuchtdichte, berechnet aus Strom-Spannungs-Leuchtdichte-Kennlinien (IUL-Kennlinien), sowie die Lebensdauer bestimmt. Die Elektrolumineszenzspektren werden bei einer Leuchtdichte von 1000 cd/$m^2$ gemessen, woraus sich die CIE 1931 x- und y-Farbkoordinaten ergeben. Die Angabe U1000 in Tabelle 2 bezeichnet die Spannung, die für eine Leuchtdichte von 1000 cd/$m^2$ benötigt wird. SE1000 bezeichnet die Stromeffizienz, die bei 1000 cd/$m^2$ erreicht werden. Als Lebensdauer LT wird die Zeit definiert, nach der die Leuchtdichte bei einem Betrieb mit konstantem Strom von der Startleuchtdichte L0 auf einen gewissen Anteil L1 abgesunken ist. Eine Angabe von L0 = 6000 cd/$m^2$ und L1 = 50% in Tabelle 2 bedeutet, dass die in Spalte LT angegebene Lebensdauer der Zeit entspricht, nach der die Anfangsleuchtdichte der entsprechenden OLED von 6000 cd/$m^2$ auf 3000 cd/$m^2$ abgesunken ist. Die Werte für die Lebensdauer können mit Hilfe von dem Fachmann bekannten Umrechnungsformeln auf eine Angabe für andere Startleuchtdichten umgerechnet werden. Hierbei ist die Lebensdauer für eine Startleuchtdichte von 1000 cd/$m^2$ eine übliche Angabe.

Die Daten der verschiedenen OLEDs sind in den Tabellen 2 und 4 zusammengefasst. Die Beispiele A1-A15 und A16-A19 sind Vergleichsbeispiele gemäß dem Stand der Technik, die Beispiele B1-B9 und B10 bis B20 zeigen Daten von OLEDs mit erfindungsgemäßen Materialien oder Materialkombinationen.

Im Folgenden werden einige der Beispiele näher erläutert, um die Vorteile der erfindungsgemäßen Mischungen zu verdeutlichen. Es sei jedoch darauf hingewiesen, dass dies nur eine Auswahl der in den Tabellen 2 und 4 gezeigten Daten darstellt. Wie sich der Tabelle entnehmen lässt, werden auch bei Verwendung der nicht näher ausgeführten erfindungsgemäßen Elektronentransportschichten deutliche Verbesserungen gegenüber dem Stand der Technik erzielt, teilweise in allen Parametern, in manchen Fällen ist aber nur eine Verbesserung von Effizienz oder Spannung oder Lebensdauer zu beobachten. Allerdings stellt bereits die Verbesserung eines der genannten Parameter einen signifikanten Fortschritt dar, weil verschiedene Anwendungen die Optimierung hinsichtlich unterschiedlicher Parameter erfordern.

**OLEDs mit erfindungsgemäßen Elektronentransportschichten enthaltend ETM1 und ETM2**

Die OLEDs A1-A4 sind Vergleichsbeispiele, welche in der an die Emitterschicht angrenzenden Elektronentransportschicht keine ETM2-Materialien , sondern nur *ein* ETM-Material (ETM1-1) enthalten. Das gemäß dem Stand der Technik oft als Beimischungsmaterial gebrauchte ETM2-1 wird hier als EIL in einer separaten Schicht eingesetzt. In Tabelle 2 ist zu erkennen, dass durch eine reine Schichtdickenoptimierung des als Einzelschicht verwendeten ETM2-1 keine weitere Optimierung des Bauteils möglich ist. Die Spannungen, Effizienzen und Lebensdauern der Bauteile sind alle sehr ähnlich. Ab einer Schichtdicke von 4 nm ETM2-1 sinkt die Lebensdauer allerdings deutlich.

Die OLEDs A5-A8 sind Vergleichsbeispiele, welche in der an die Emitterschicht angrenzenden Elektronentransportschicht ein Gemisch aus ETM1 und ETM2 (ETM1-1 und ETM2-1), die nicht der Erfindung entsprechen, gemäß dem Stand der Technik enthält. ETM2-1 wird zusätzlich in einer separaten Elektroneninjektionsschicht eingesetzt. In Tabelle 2 ist zu erkennen, dass durch eine Mischung von ETM1-1 und ETM2-1 im Vergleich zu den Beispielen A1-A4 bereits eine Optimierung des Bauteils hinsichtlich Spannung (Erniedrigungen von ca. -1V) und Effizienz (Erhöhungen von bis zu 60%) möglich ist.

Die OLEDs A9-A12 sind Vergleichsbeispiele, welche in der an die Emitterschicht angrenzenden Elektronentransportschicht ein Gemisch aus ETM1, welches bezüglich dem Triplett-Niveau der vorliegenden Erfindung entspricht, und ETM2, welches bezüglich dem Triplett-Niveau der vorliegenden Erfindung nicht entspricht, (ETM1-2 und ETM2-1), enthält. Obwohl es sich bei den genannten Beispielen um blaue Devices (fluoreszierende Emitter) handelt, sind diese Beispiele auch bezüglich des Triplett-Niveaus der ETL relevant, da in einem Display für fluoreszierende und phosphoreszierende Pixel die gleiche ETL eingesetzt wird. ETM2-1 wird hier zusätzlich in einer separaten EIL eingesetzt. In

Tabelle 2 ist zu erkennen, dass durch eine Mischung von ETM1-2 und ETM2-1 im Vergleich zu den Beispielen A1-A4 eine weitere Optimierung des Bauteils hinsichtlich Spannung (Erniedrigungen von bis zu -2V), Effizienz (Erhöhungen von bis zu 100%) und Lebensdauer (Verlängerung von bis zu 70%) möglich ist.

Die OLEDs B1-B4 sind erfindungsgemäße Beispiele, welche in der an die Emitterschicht angrenzenden Elektronentransportschicht ein Gemisch aus erfindungsgemäßen ETM1 und ETM2 (ETM1-2 und ETM2-2), welche der vorliegenden Erfindung entsprechen, enthält. ETM2-1 wird hier in einer separaten Elektroneninjektionsschicht eingesetzt. In Tabelle 2 ist zu erkennen, dass durch eine entsprechende Mischung von ETM1-2 und ETM2-2 im Vergleich zu den Beispielen A9-A12 eine weitere Optimierung des Bauteils hinsichtlich Effizienz (Erhöhungen von ca. 5%) und Lebensdauer (Verlängerungen von bis zu 45%) möglich ist. Zusätzlich ist hier die Kompatibilität mit phosphoreszierenden Schichten gegeben.

Die OLEDs A13-A15 sind grüne Vergleichsbeispiele, welche in der an die Emitterschicht angrenzenden Elektronentransportschicht ein Gemisch aus zwei nicht erfindungsgemäßen oder aus einem erfindungsgemäßen und einem nicht erfindungsgemäßen ETM (ETM1-1:ETM2-1, ETM1-1:ETM2-3 oder ETM1-3:ETM2-1) enthalten. Jeweils eine der Komponenten erfüllt in diesem Falle die Anforderungen an das Triplett-Niveau nicht. Während z.B. die Kombination ETM1-1:ETM2-1 aus den Vergleichsbeispielen A5 bis A8 in Singulett-Blau noch relativ gut funktioniert hat, ist die Effizienz in Triplett-Grün (A13) niedrig. Die erfindungsgemäßen Beispiele B5-B9 enthalten dagegen nur Elektronentransportmaterialien in der ETM Schicht (ETM1-3:ETM2-3), die alle erfindungsgemäßen Bedingungen erfüllen. In B5 wird das mutagenverdächtige ETM2-1 in einer separaten Elektroneninjektionsschicht eingesetzt. In den Beispielen B6-B9 werden daher andere, weniger gesundheitsschädliche Elektroneninjektionsmaterialien eingesetzt, wie Cäsiumfluorid, Lithiumnitrid, Rubidiumfluorid oder Lithiumfluorid eingesetzt, die außer im Falle von Lithiumfluorid zu keiner nennenswerten Änderung der Deviceperformance im Vergleich zu B5 führen. In Tabelle 2 ist zu erkennen, dass durch eine Mischung von ETM1-3 und ETM2-3 im Vergleich zu den Beispielen A13-A15 eine weitere Optimierung des Bauteils hinsichtlich Spannung (Erniedrigungen von bis zu -0,2V), Effizienz (Erhöhungen von bis zu 20%) und Lebensdauer (Verlängerungen von über 10%) möglich ist.

Die OLEDs A16-A19 in Tabelle 3 sind Vergleichsbeispiele, welche in der an die Emitterschicht angrenzenden Elektronentransportschicht ein Gemisch enthalten, das die erfindungsgemäßen Bedingungen nicht erfüllt. B10 bis B20 sind dagegen erfindungsgemäße Beispiele. Die Evaluierungsdaten sind in Tabelle 4 zusammengefasst. In B11 wurde das mutagenverdächtige ETM2-1 durch das weniger gesundheitsschädliche Elektroneninjektionsmaterial Cäsiumfluorid ersetzt, was zu keiner nennenswerten Änderung der Deviceperformance im Vergleich zu B10 führt. Das Ersetzen von ETM2-1 ist also ohne Leistungsverlust möglich, was im Endprodukt (Wertstoffkreislauf, Umwelt- und Gesundheitsbeurteilung), aber auch in bezug auf die Produktionssicherheit ein großer Vorteil ist. Die erfindungsgemäßen Beispiele B10 bis B20 aus Tabelle 4 zeigen, dass durch eine erfindungsgemäße Mischung von Elektronentransportmaterialien im Vergleich zu den Bauteilen, die keine oder nicht nur erfindungsgemäße Elektronentransportmaterialien enthalten, eine Optimierung des Bauteils hinsichtlich Spannung (Erniedrigungen von bis zu -0,2V), Effizienz (Erhöhungen von über 30%) und Lebensdauer (Verlängerungen von über 18%) möglich ist. Die Verbesserung ist mit diesen phosphoreszierenden Bauteilen, die in der emittierenden Schicht eine gemischte Matrix aus zwei Matrixmaterialien aufweisen, besonders stark ausgeprägt, da hier die Emissionszone besonders stark an die ETL-Seite verschoben ist und sich dadurch die Effekte eines kleines T1-Niveaus in der ETL besonders stark auswirken. Tabelle 5 zeigt sämtliche in den Beispielen verwendeten chemischen Strukturen.

Tabelle 1 zeigt den Aufbau der OLEDs A1 bis A15 sowie B1 bis B9. Vor der 1. Schicht befinden sich immer 50 nm ITO und auf die letzte ETM Schicht werden immer 100 nm Aluminium aufgedampft; die einzelnen Schichten sind in der Tabelle durch "/" voneinander getrennt, die Schichtdicken in Klammern in der Einheit nm angegeben

Für die Beispiele A1 bis A12 und B1 bis B4 wird die folgende Schichtstruktur verwendet: HIM1(5)/HIM2(140)/HTM1(20)/ M1(95%):D1(5%)(30)/ETMX/ETMY

Für die Beispiele A13 bis A15 und B5 bis B9 wird die folgende Schichtstruktur verwendet: HIM4(80)/HIM1(5)/HIM4(125)/HTM2(20)/ M2(85%):D3(15%)(30)/ETMX/ETMY)

**Tabelle 1**

| Bsp.-Nr. | ETMX | ETMY |
|---|---|---|
| A1 | ETM1-1(20) | ETM2-1(1) |
| A2 | ETM 1-1(20) | ETM2-1(2) |
| A3 | ETM1-1(20) | ETM2-1(3) |

(fortgesetzt)

| Bsp.-Nr. | ETMX | ETMY |
|---|---|---|
| A4 | ETM1-1(20) | ETM2-1(4) |
| | | |
| A5 | ETM1-1(65%):ETM2-1(35%)(20) | ETM2-1(1.5) |
| A6 | ETM1-1(50%):ETM2-1(50%)(20) | ETM2-1(1.5) |
| A7 | ETM1-1(35%):ETM2-1(65%)(20) | ETM2-1(1.5) |
| A8 | ETM1-1(20%):ETM2-1 (80%)(20) | ETM2-1(1.5) |
| | | |
| A9 | ETM1-2(65%):ETM2-1(35%)(20) | ETM2-1(1.5) |
| A10 | ETM1-2(50%):ETM2-1(50%)(20) | ETM2-1(1.5) |
| A11 | ETM1-2(35%):ETM2-1(65%)(20) | ETM2-1(1.5) |
| A12 | ETM1-2(20%):ETM2-1(80%)(20) | ETM2-1(1.5) |
| | | |
| B1 | ETM1-2(65%):ETM2-2(35%)(20) | ETM2-1(1.5) |
| B2 | ETM1-2(50%):ETM2-2(50%)(20) | ETM2-1(1.5) |
| B3 | ETM1-2(35%):ETM2-2(65%)(20) | ETM2-1(1.5) |
| B4 | ETM1-2(20%):ETM2-2(80%)(20) | ETM2-1(1.5) |
| | | |
| A13 | ETM1-1(50%):ETM2-1 (50%)(35) | ETM2-1(2) |
| A14 | ETM1-1(50%):ETM2-3(50%)(35) | ETM2-1(2) |
| A15 | ETM1-3(50%):ETM2-1 (50%)(35) | ETM2-1(2) |
| B5 | ETM1-3(50%):ETM2-3(50%)(35) | ETM2-1(2) |
| B6 | ETM1-3(50%):ETM2-3(50%)(35) | CsF(2) |
| B7 | ETM1-3(50%):ETM2-3(50%)(35) | $Li_3N$(0.5) |
| B8 | ETM1-3(50%):ETM2-3(50%)(35) | RbF(2) |
| B9 | ETM1-3(50%):ETM2-3(50%)(35) | LiF(1.5) |

**Tabelle 2:** Daten der OLEDs

| Bsp. Nr.: | SE1000 (cd/A) | U1000 (V) | CIE x bei 1000 cd/m2 | CIE y bei 1000 cd/m2 | LT (h) | L0 (cd/m$^2$) |
|---|---|---|---|---|---|---|
| A1 | 4,05 | 6,10 | 0,140 | 0,154 | 272 | 6000 |
| A2 | 4,31 | 5,86 | 0,140 | 0,156 | 238 | 6000 |
| A3 | 4,33 | 5,82 | 0,140 | 0,156 | 258 | 6000 |
| A4 | 4,39 | 6,20 | 0,141 | 0,152 | 110 | 6000 |
| | | | | | | |
| A5 | 5,04 | 5,47 | 0,142 | 0,162 | 270 | 6000 |
| A6 | 6,13 | 4,99 | 0,142 | 0,159 | 212 | 6000 |
| A7 | 7,04 | 4,76 | 0,142 | 0,158 | 214 | 6000 |
| A8 | 6,49 | 5,25 | 0,142 | 0,159 | 274 | 6000 |

(fortgesetzt)

| Bsp. Nr.: | SE1000 (cd/A) | U1000 (V) | CIE x bei 1000 cd/m2 | CIE y bei 1000 cd/m2 | LT (h) | L0 (cd/m$^2$) |
|---|---|---|---|---|---|---|
| | | | | | | |
| A9 | 6,68 | 4,05 | 0,142 | 0,159 | 320 | 6000 |
| A10 | 8,12 | 4,13 | 0,141 | 0,159 | 332 | 6000 |
| A11 | 8,24 | 4,02 | 0,142 | 0,161 | 362 | 6000 |
| A12 | 7,36 | 4,68 | 0,142 | 0,159 | 445 | 6000 |
| | | | | | | |
| B1 | 6,97 | 4,15 | 0,142 | 0,155 | 380 | 6000 |
| B2 | 8,50 | 4,06 | 0,142 | 0,154 | 385 | 6000 |
| B3 | 8,64 | 4,11 | 0,142 | 0,156 | 465 | 6000 |
| B4 | 7,45 | 4,27 | 0,142 | 0,156 | 645 | 6000 |
| | | | | | | |
| A13 | 48,01 | 4,00 | 0,356 | 0,605 | 932 | 8000 |
| A14 | 55,82 | 4,19 | 0,349 | 0,608 | 1012 | 8000 |
| A15 | 57,19 | 4,02 | 0,351 | 0,609 | 1053 | 8000 |
| B5 | 68.18 | 3,83 | 0,355 | 0,606 | 1185 | 8000 |
| B6 | 68,30 | 3,81 | 0,354 | 0,607 | 1180 | 8000 |
| B7 | 67,95 | 3,88 | 0,353 | 0,608 | 1175 | 8000 |
| B8 | 67,92 | 3,85 | 0,354 | 0,606 | 1163 | 8000 |
| B9 | 67,86 | 4,57 | 0,356 | 0,605 | 1110 | 8000 |

Tabelle 3 zeigt den Aufbau der OLEDs A16 bis A19 und B10 bis B20. Vor der 1. Schicht befinden sich immer 50 nm ITO, und auf die letzte ETM Schicht werden immer 100 nm Aluminium aufgedampft; die einzelnen Schichten sind in der Tabelle durch "/" voneinander getrennt, die Schichtdicken in Klammern in der Einheit nm angegeben. Die hierin aufgeführten OLEDs haben die folgende Schichtstruktur:
HIM2(40)/HIM1(10)/HIM2(170)/HIM1(10)/HTM3(20)/ M3(32%):M4(63%)D3(5%)(40)/ETMX/ETMY

**Tabelle 3**

| **Bsp.-Nr.** | **ETMX** | **ETMY** |
|---|---|---|
| A16 | ETM1-1(50%):ETM2-1(50%)(30) | ETM2-1(1) |
| A17 | ETM1-3(50%):ETM2-1(50%)(30) | ETM2-1(1) |
| B10 | ETM1-3(50%):ETM2-3(50%)(30) | ETM2-1(1) |
| B11 | ETM1-3(50%):ETM2-3(50%)(30) | CsF(1) |
| | | |
| A18 | ETM1-2(50%):ETM2-1(50%)(30) | ETM2-1(1) |
| B12 | ETM1-2(50%):ETM2-3(50%)(30) | ETM2-1(1) |
| | | |
| A19 | ETM1-1 (50%):ETM2-3(50%)(30) | ETM2-1 (1) |
| B13 | ETM1-4(50%):ETM2-3(50%)(30) | ETM2-1(1) |
| B14 | ETM1-5(50%): ETM2-3(50%)(30) | ETM2-1(1) |
| B15 | ETM1-6(50%):ETM2-3(50%)(30) | ETM2-1(1) |

(fortgesetzt)

| Bsp.-Nr. | ETMX | ETMY |
|---|---|---|
| B16 | ETM1-7(50%):ETM2-3(50%)(30) | ETM2-1(1) |
| B17 | ETM1-8(50%):ETM2-3(50%)(30) | ETM2-1(1) |
| | | |
| B18 | ETM1-3(50%):ETM2-4(50%)(30) | ETM2-1(1) |
| B19 | ETM1-3(50%):ETM2-5(50%)(30) | ETM2-1(1) |
| B20 | ETM1-3(50%):ETM2-6(50%)(30) | ETM2-1(1) |

**Tabelle 4:** Daten der OLEDs

| Bsp. Nr.: | SE1000 (cd/A) | U1000 (V) | CIE x bei 1000 cd/m2 | CIE y bei 1000 cd/m2 | LT (h) | L0 (cd/m$^2$) |
|---|---|---|---|---|---|---|
| A16 | 49,05 | 3,61 | 0,341 | 0,626 | 1622 | 8000 |
| A17 | 54,00 | 3,49 | 0.342 | 0,624 | 1713 | 8000 |
| B10 | 63.95 | 3,44 | 0,340 | 0,625 | 1928 | 8000 |
| B11 | 63,68 | 3,48 | 0,343 | 0,623 | 1918 | 8000 |
| | | | | | | |
| A18 | 55,50 | 3,42 | 0.341 | 0,625 | 1688 | 8000 |
| B12 | 64,75 | 3,39 | 0,343 | 0,623 | 1907 | 8000 |
| | | | | | | |
| A19 | 51,05 | 3,58 | 0,343 | 0,624 | 1603 | 8000 |
| B13 | 64,24 | 3,49 | 0,342 | 0,622 | 1833 | 8000 |
| B14 | 62,35 | 3,42 | 0,342 | 0,623 | 1783 | 8000 |
| B15 | 64,53 | 3,40 | 0,340 | 0,626 | 1723 | 8000 |
| B16 | 62,86 | 3,51 | 0,344 | 0,621 | 1659 | 8000 |
| B17 | 59,79 | 3,61 | 0,342 | 0,624 | 1678 | 8000 |
| | | | | | | |
| B18 | 61,89 | 3,54 | 0,345 | 0,623 | 1897 | 8000 |
| B19 | 64,91 | 3,41 | 0,342 | 0,626 | 1871 | 8000 |
| B20 | 62,65 | 3,46 | 0,341 | 0,624 | 1843 | 8000 |

**Tabelle 5**: Strukturformeln der verwendeten Materialien und deren Funktion in der OLED

| | |
|---|---|
| 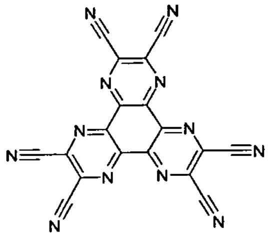 | 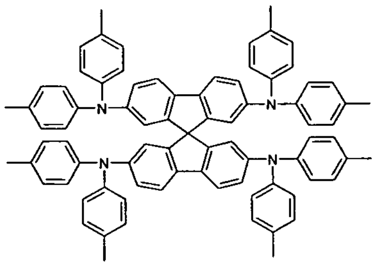 |
| HIM1 (HIL) | HIM2 (HIL) EP 0676461 |

(fortgesetzt)

| | |
|---|---|
| 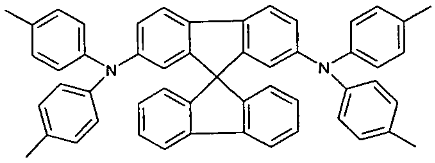 | 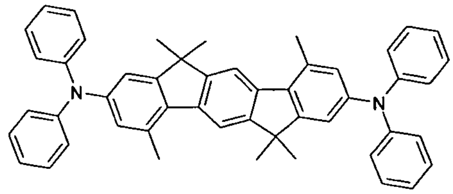 |
| HIM3 (HIL) EP 0676461 | HIM4 (HIL) WO 2006/122630 |
| 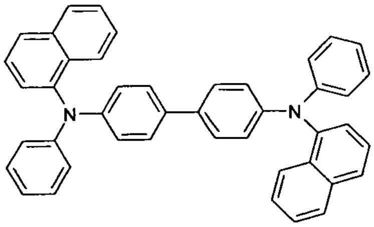 | 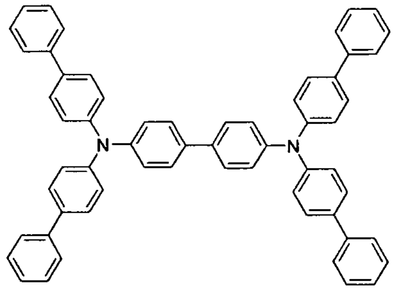 |
| HTM1 (HTL), α-NPB | HTM2 (HTL) |
| 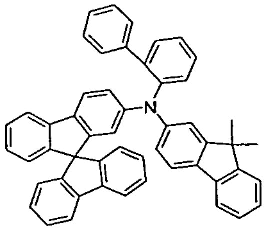 | 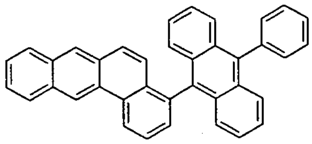 |
| HTM3 (HTL), WO 2012/034627 | M1 (Host EML), WO 2008/145239 |
| 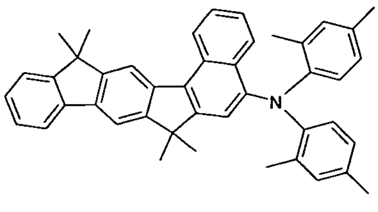 | 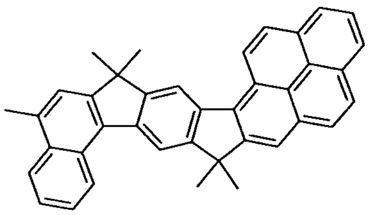 |
| D1 (Dotant EML), WO 2008/006449 | D2 (Dotant EML), WO 2010/012328 |
| 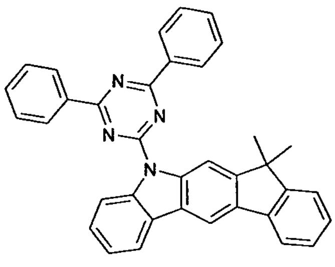 | 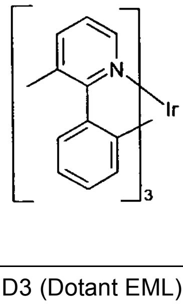 |
| M2 (Host EML), DE 102009023155 | D3 (Dotant EML) |

(fortgesetzt)

| | |
|---|---|
| 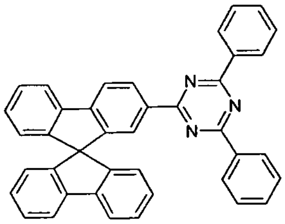 | 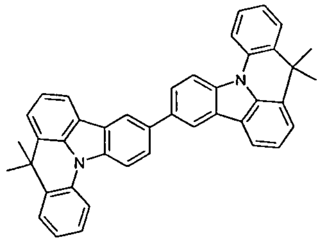 |
| M3 (Host EML), WO 2005/053055 | M4 (Host EML), WO 2011/088877 |
| 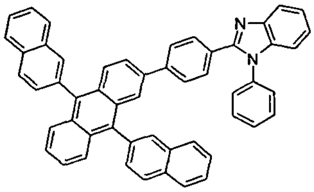 | 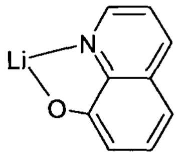 |
| ETM1-1 (ETL) | FTM2-1 (ETL; EIL), Liq |
| 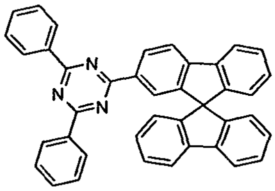 | 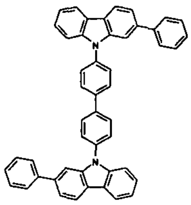 |
| ETM1-2 (ETL), WO 2005/053055 | ETM2-2 (ETL), WO 2008/086851 |
| 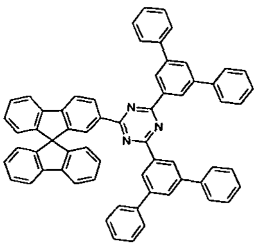 | 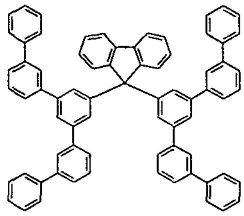 |
| ETM1-3 (ETL), ), WO 2005/053055, DE 10200836982 | ETM2-3 (ETL), WO 2009/124627 |
| 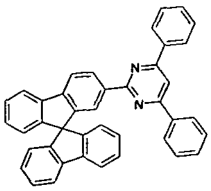 | 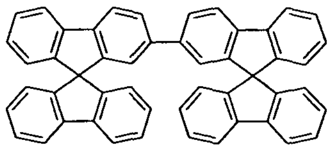 |
| ETM1-4 (ETL) | ETM2-4, E 0676461 |
| 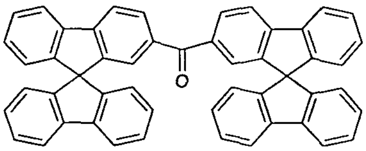 | 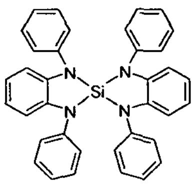 |
| ETM1-5 (ETL), WO 2004/093207, WO 2005/054403 | ETM2-5 (ETL), DE 102008056688 |

(fortgesetzt)

| | |
|---|---|
| 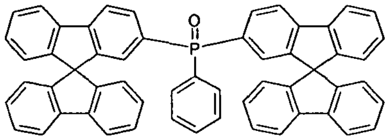 | 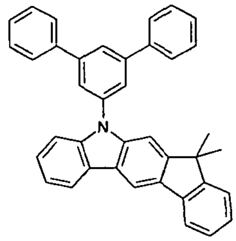 |
| ETM1-6 (ETL), ), WO 2005/003253, WO 2005/054403 | ETM2-6 (ETL), DE 102009023155 |
| 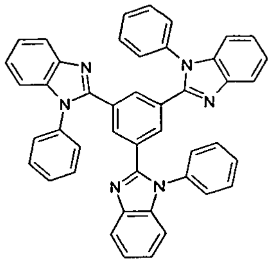 | 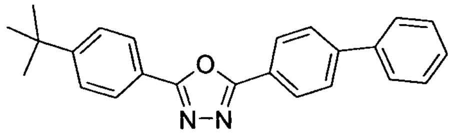 |
| ETM1-7 ETL), TPBI | ETM1-8 (ETL) |

| Tabelle 6: HOMO/LUMO Werte und Triplett-Niveaus $T_1$ der Materialien | | | | |
|---|---|---|---|---|
| Material | HOMO (eV) | LUMO (eV) | $T_1$ (eV) | *Methode* |
| ETM1-1 | -5,54 | -2,82 | 1,66 | *org.* |
| ETM2-1 | -4,79 | -2,30 | 1,81 | *org.* |
| ETM1-2 | -6,05 | -2,79 | 2,70 | *org.* |
| ETM2-2 | -5,68 | -2,39 | 2,84 | *org.* |
| ETM1-3 | -6.03 | -2,82 | 2,68 | *org.* |
| ETM2-3 | -6,16 | -2,24 | 2,95 | *org.* |
| ETM1-4 | -5,93 | -2,61 | 2,74 | *org.* |
| ETM2-4 | -5,73 | -2,42 | 2,61 | *org.* |
| ETM1-5 | -6,04 | -2,81 | 2,57 | *org.* |
| ETM2-5 | -5,43 | -1,81 | 3,25 | *org.* |
| ETM1-6 | -5,99 | -2,47 | 2,86 | *org.* |
| ETM2-6 | -5,54 | -2,27 | 2,82 | *org.* |
| ETM1-7 | -6,26 | -2,48 | 3,04 | *org.* |
| ETM1-8 | -6,05 | -2,87 | 2,24 | *org.* |

## Patentansprüche

1. Organische Elektrolumineszenzvorrichtung, enthaltend Anode, Kathode, mindestens eine emittierende Schicht und mindestens eine Elektronentransportschicht, welche auf Kathodenseite direkt an die emittierende Schicht angrenzt, **dadurch gekennzeichnet, dass** die Elektronentransportschicht eine Mischung aus mindestens zwei Materialien ETM1 und ETM2 enthält, wobei für ETM1 und ETM2 die folgenden Bedingungen gelten:

   a) $T_1$(ETM1) > 2.2 eV; und

b) $T_1$(ETM2) > 2.2 eV; und
c) -3.2 eV < LUMO(ETM1) < -2.0 eV; und
d) LUMO(ETM2) > LUMO(ETM1);

wobei $T_1$ für die niedrigste Triplettenergie des jeweiligen Materials und LUMO für die Energie des niedrigsten unbesetzten Molekülorbitals des jeweiligen Materials steht und
wobei ETM1 und ETM2 rein organische Materialien sind,
und wobei die Triplett-Energieen sowie die HOMO- und LUMO-Werte mit dem im Beispielteil offenbarten Verfahren, der zeitabhängigen Dichtefunktionaltheorie, ermittelt werden.

**2.** Organische Elektrolumineszenzvorrichtung nach Anspruch 1, **dadurch gekennzeichnet, dass** die Triplettenergie $T_1$ von ETM1 und ETM2 und von gegebenenfalls weiteren in der Elektronentransportschicht vorhandenen Materialien > 2.4 eV, bevorzugt > 2.6 eV ist.

**3.** Organische Elektrolumineszenzvorrichtung nach Anspruch 1 oder 2, **dadurch gekennzeichnet, dass** das LUMO von ETM1 im Bereich von -3.1 eV bis -2.2 eV und bevorzugt im Bereich von -3.0 eV bis -2.4 eV liegt.

**4.** Organische Elektrolumineszenzvorrichtung nach einem oder mehreren der Ansprüche 1 bis 3, **dadurch gekennzeichnet, dass** das LUMO von ETM2 mindestens 0.1 eV größer als das LUMO von ETM1 ist.

**5.** Organische Elektrolumineszenzvorrichtung nach einem oder mehreren der Ansprüche 1 bis 4, **dadurch gekennzeichnet, dass** das HOMO von ETM1 < -5.3 eV ist.

**6.** Organische Elektrolumineszenzvorrichtung nach einem oder mehreren der Ansprüche 1 bis 5, **dadurch gekennzeichnet, dass** HOMO(ETM1)< HOMO(EML) und HOMO(ETM2) < HOMO(EML) ist, wobei HOMO(EML) das HOMO der emittierenden Schicht bzw. des Materials der emittierenden Schicht, welches das höchste HOMO aufweist, darstellt.

**7.** Organische Elektrolumineszenzvorrichtung nach einem oder mehreren der Ansprüche 1 bis 6, **dadurch gekennzeichnet, dass** der Anteil von ETM2 ≥ 10 Vol.-% und bevorzugt ≥ 30 Vol.-% ist und weiterhin der Anteil von ETM2 ≤ 90 Vol.-% und bevorzugt ≤ 80 Vol.-% ist.

**8.** Organische Elektrolumineszenzvorrichtung nach einem oder mehreren der Ansprüche 1 bis 7, **dadurch gekennzeichnet, dass** die Elektronentransportschicht außer ETM1 und ETM2 keine weiteren Materialien enthält.

**9.** Organische Elektrolumineszenzvorrichtung nach einem oder mehreren der Ansprüche 1 bis 8, **dadurch gekennzeichnet, dass** ETM1 ausgewählt ist aus der Gruppe bestehend aus Verbindungen enthaltend Sechsringheteroarylgruppen, insbesondere Triazinderivate, Pyrimidinderivate, Pyridinderivate, Pyrazinderivate, Chinoxalinderivate bzw. Chinolinderivate, Verbindungen enthaltend Fünfringheteroaromaten mit mindestens zwei Heteroatomen, insbesondere Oxadiazolderivate bzw. Benzimidazolderivate, oder aus aromatischen Ketonen, Boranen, Lactamen, Diazaphospholderivaten und Phosphinoxidderivaten.

**10.** Organische Elektrolumineszenzvorrichtung nach einem oder mehreren der Ansprüche 1 bis 9, **dadurch gekennzeichnet, dass** als ETM1 eine Verbindung gemäß einer der Formeln (1) bis (8) verwendet wird,

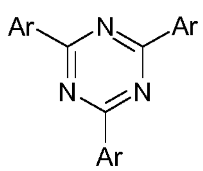

Formel (1)

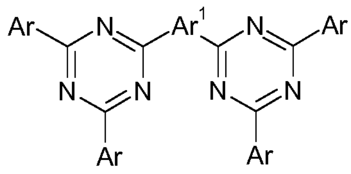

Formel (2)

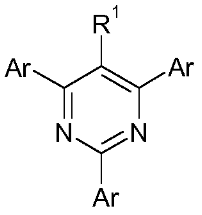
Formel (3)

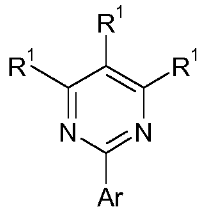
Formel (4)

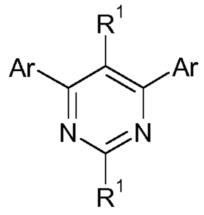
Formel (5)

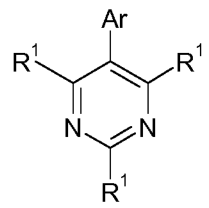
Formel (6)

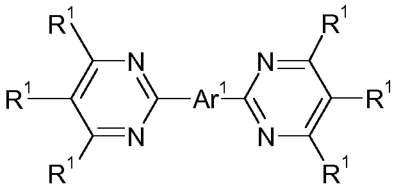
Formel (7)

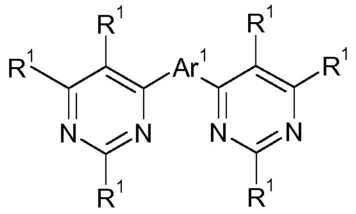
Formel (8)

wobei für die verwendeten Symbole gilt:

Ar ist gleich oder verschieden bei jedem Auftreten ein monovalentes aromatisches oder heteroaromatisches Ringsystem mit 5 bis 60 aromatischen Ringatomen, welches jeweils mit einem oder mehreren Resten $R^1$ substituiert sein kann;
$Ar^1$ ist ein bivalentes aromatisches oder heteroaromatisches Ringsystem mit 5 bis 60 aromatischen Ringatomen, welches mit einem oder mehreren Resten $R^1$ substituiert sein kann;
$R^1$ ist bei jedem Auftreten gleich oder verschieden H, D, F, Cl, Br, I, CHO, $C(=O)Ar^2$, $P(=O)(Ar^2)_2$, $S(=O)Ar^2$, $S(=O)_2Ar^2$, $CR^2=CR^2Ar^2$, CN, $NO_2$, $Si(R^2)_3$, $B(OR^2)_2$, $B(R^2)_2$, $B(N(R^2)_2)_2$, $OSO_2R^2$, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch F, Cl, Br, I, CN oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Kombination dieser Systeme; dabei können zwei oder mehrere benachbarte Substituenten $R^1$ auch miteinander ein mono- oder polycyclisches, aliphatisches oder aromatisches Ringsystem bilden;
$Ar^2$ ist bei jedem Auftreten gleich oder verschieden ein aromatisches oder heteroaromatisches Ringsystem mit 5 bis 40 aromatischen Ringatomen, das mit einem oder mehreren Resten $R^2$ substituiert sein kann;
$R^2$ ist bei jedem Auftreten gleich oder verschieden H, D, CN oder ein aliphatischer, aromatischer und/oder heteroaromatischer organischer Rest mit 1 bis 20 C-Atomen, in dem auch H-Atome durch F ersetzt sein können; dabei können zwei oder mehrere benachbarte Substituenten $R^2$ auch miteinander ein mono- oder polycyclisches, aliphatisches oder aromatisches Ringsystem bilden.

oder **dadurch gekennzeichnet, dass** als ETM1 ein Keton der Formel (23) oder ein Phosphinoxid der Formel (24) verwendet wird,

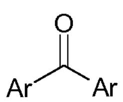
Formel (23)

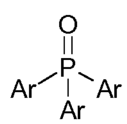
Formel (24)

wobei Ar die oben genannte Bedeutung aufweist.

**11.** Organische Elektrolumineszenzvorrichtung nach einem oder mehreren der Ansprüche 1 bis 10, **dadurch gekennzeichnet, dass** ETM2 ein reiner Kohlenwasserstoff ist, bevorzugt ein aromatischer Kohlenwasserstoff, oder dass ETM2 ein Carbazolderivat, ein Diazasilolderivat oder ein Tetraazasilolderivat ist.

**12.** Organische Elektrolumineszenzvorrichtung nach einem oder mehreren der Ansprüche 1 bis 11, **dadurch gekennzeichnet, dass** ETM2 ausgewählt ist aus Verbindungen der Formeln (36), (37) und (38),

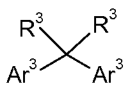

Formel (36)

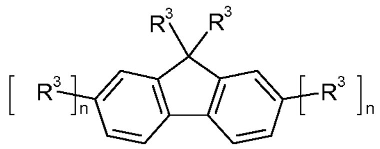

Formel (37)

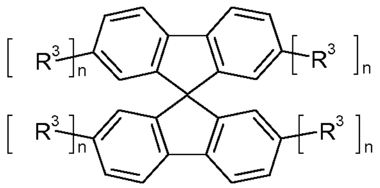

Formel (38)

wobei $R^1$ die in Anspruch 11 genannte Bedeutung hat und die weiteren verwendeten Symbole und Indizes die folgenden Bedeutungen haben:

$Ar^3$ ist bei jedem Auftreten gleich oder verschieden ein aromatisches Ringsystem mit 6 bis 60 aromatischen C-Atomen, welches keine nicht-aromatischen Gruppen ungleich Kohlenstoff oder Wasserstoff enthält; dabei kann $Ar^3$ durch einen oder mehrere Reste $R^4$ substituiert sein;
$R^3$ ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen, oder ein aromatisches Ringsystem mit 6 bis 60 aromatischen C-Atomen, welches keine nicht-aromatischen Gruppen ungleich Kohlenstoff oder Wasserstoff enthält und welches durch einen oder mehrere Reste $R^4$ substituiert sein kann; dabei können zwei oder mehrere Reste $R^3$ auch miteinander ein Ringsystem bilden;
$R^4$ ist bei jedem Auftreten gleich oder verschieden eine geradkettige Alkylgruppe mit 1 bis 20 C-Atomen oder eine verzweigte oder cyclische Alkylgruppe mit 3 bis 20 C-Atomen; dabei können zwei oder mehrere Reste $R^4$ auch miteinander ein Ringsystem bilden;
n ist gleich oder verschieden bei jedem Auftreten 0 oder 1;

oder **dadurch gekennzeichnet, dass** als ETM2 eine Verbindung der Formel (39) oder (40) verwendet wird,

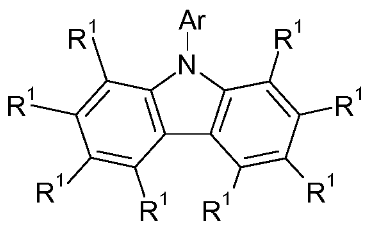

Formel (39)

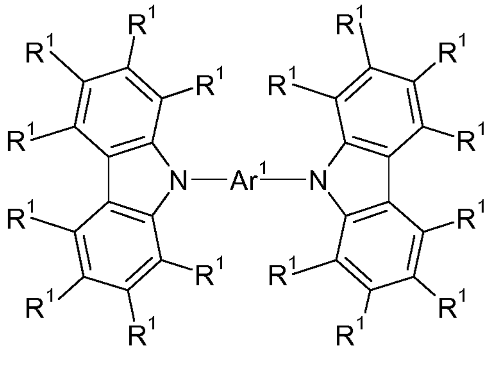

Formel (40)

wobei die verwendeten Symbole die in Anspruch 10 genannten Bedeutungen aufweisen.

**13.** Organische Elektrolumineszenzvorrichtung nach einem oder mehreren der Ansprüche 1 bis 12, **dadurch gekennzeichnet, dass** zwischen der Elektronentransportschicht und der metallischen Kathode eine Elektroneninjektionsschicht verwendet wird, welche ein Alkalimetall- oder Erdalkalimetallfluorid, ein Alkalimetall- oder Erdalkalimetalloxid, ein Alkalimetall- oder Erdalkalimetallcarbonat oder einen Alkalimetall- oder Erdalkalimetallkomplex enthält.

**14.** Organische Elektrolumineszenzvorrichtung nach einem oder mehreren der Ansprüche 1 bis 13, **dadurch gekennzeichnet, dass** die emittierende Schicht phosphoreszierend ist und bevorzugt eine Mischung aus zwei oder mehr

Matrixmaterialien enthält.

**15.** Verfahren zur Herstellung einer organischen Elektrolumineszenzvorrichtung nach einem oder mehreren der Ansprüche 1 bis 14, **dadurch gekennzeichnet, dass** eine oder mehrere Schichten mit einem Sublimationsverfahren beschichtet werden und/oder dass eine oder mehrere Schichten mit dem OVPD Verfahren oder mit Hilfe einer Trägergassublimation beschichtet werden und/oder dass eine oder mehrere Schichten aus Lösung beschichtet werden.

## Claims

**1.** Organic electroluminescent device comprising anode, cathode, at least one emitting layer and at least one electron-transport layer which is directly adjacent to the emitting layer on the cathode side, **characterised in that** the electron-transport layer comprises a mixture of at least two materials ETM1 and ETM2, where the following conditions apply to ETM1 and ETM2:

a) $T_1$(ETM1) > 2.2 eV; and
b) $T_1$(ETM2) > 2.2 eV; and
c) -3.2 eV < LUMO(ETM1) < -2.0 eV; and
d) LUMO(ETM2) > LUMO(ETM1);

where $T_1$ stands for the lowest triplet energy of the respective material and LUMO stands for the energy of the lowest unoccupied molecular orbital of the respective material and
where ETM1 and ETM2 are purely organic materials,
and where the triplet energies and the HOMO and LUMO values are determined using the time-dependant density functional theory method disclosed in the example part.

**2.** Organic electroluminescent device according to Claim 1, **characterised in that** the triplet energy $T_1$ of ETM1 and ETM2 and of any further materials present in the electron-transport layer is > 2.4 eV, preferably > 2.6 eV.

**3.** Organic electroluminescent device according to Claim 1 or 2, **characterised in that** the LUMO of ETM1 is in the range from -3.1 eV to -2.2 eV and preferably in the range from -3.0 eV to -2.4 eV.

**4.** Organic electroluminescent device according to one or more of Claims 1 to 3, **characterised in that** the LUMO of ETM2 is at least 0.1 eV greater than the LUMO of ETM1.

**5.** Organic electroluminescent device according to one or more of Claims 1 to 4, **characterised in that** the HOMO of ETM1 is < -5.3 eV.

**6.** Organic electroluminescent device according to one or more of Claims 1 to 5, **characterised in that** HOMO(ETM1) < HOMO(EML) and HOMO(ETM2) < HOMO(EML), where HOMO(EML) represents the HOMO of the emitting layer or of the emitting layer material that has the highest HOMO.

**7.** Organic electroluminescent device according to one or more of Claims 1 to 6, **characterised in that** the proportion of ETM2 is ≥ 10% by vol. and preferably ≥ 30% by vol. and furthermore the proportion of ETM2 is ≤ 90% by vol. and preferably ≤ 80% by vol.

**8.** Organic electroluminescent device according to one or more of Claims 1 to 7, **characterised in that** the electron-transport layer comprises no further materials apart from ETM1 and ETM2.

**9.** Organic electroluminescent device according to one or more of Claims 1 to 8, **characterised in that** ETM1 is selected from the group consisting of compounds containing six-membered heteroaryl ring groups, in particular triazine derivatives, pyrimidine derivatives, pyridine derivatives, pyrazine derivatives, quinoxaline derivatives or quinoline derivatives, compounds containing five-membered heteroaromatic ring groups having at least two heteroatoms, in particular oxadiazole derivatives or benzimidazole derivatives, or of aromatic ketones, boranes, lactams, diazaphosphole derivatives and phosphine oxide derivatives.

**10.** Organic electroluminescent device according to one or more of Claims 1 to 9, **characterised in that** the ETM1 used

is a compound of one of the formulae (1) to (8),

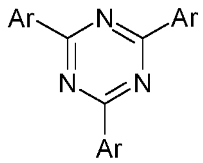

formula (1)

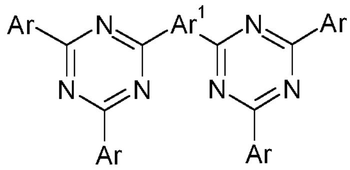

formula (2)

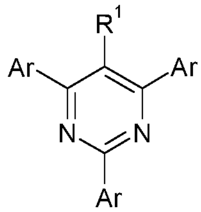

formula (3)

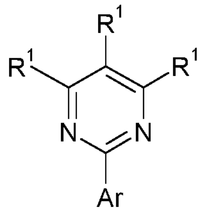

formula (4)

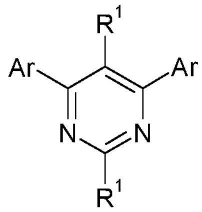

formula (5)

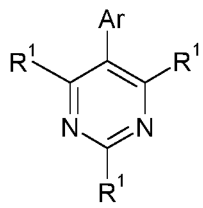

formula (6)

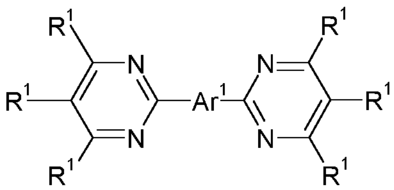

formula (7)

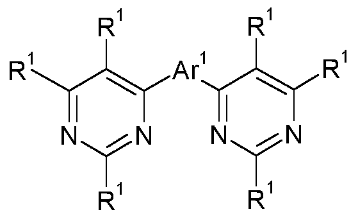

formula (8)

where the following applies to the symbols used:

Ar is, identically or differently on each occurrence, a monovalent aromatic or heteroaromatic ring system having 5 to 60 aromatic ring atoms, which may in each case be substituted by one or more radicals $R^1$;
$Ar^1$ is a divalent aromatic or heteroaromatic ring system having 5 to 60 aromatic ring atoms, which may be substituted by one or more radicals $R^1$;
$R^1$ is on each occurrence, identically or differently, H, D, F, Cl, Br, I, CHO, $C(=O)Ar^2$, $P(=O)(Ar^2)_2$, $S(=O)Ar^2$, $S(=O)_2Ar^2$, $CR^2=CR^2Ar^2$, CN, $NO_2$, $Si(R^2)_3$, $B(OR^2)_2$, $B(R^2)_2$, $B(N(R^2)_2)_2$, $OSO_2R^2$, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, which may in each case be substituted by one or more radicals $R^2$, where one or more non-adjacent $CH_2$ groups may be replaced by $R^2C=CR^2$, C=C , $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S or $CONR^2$ and where one or more H atoms may be replaced by F, Cl, Br, I, CN or $NO_2$, or an aromatic or heteroaromatic ring system having 5 to 60 aromatic ring atoms, which may in each case be substituted by one or more radicals $R^2$, or an aryloxy or heteroaryloxy group having 5 to 60 aromatic ring atoms, which may be substituted by one or more radicals $R^2$, or a combination of these systems; two or more adjacent substituents $R^1$ may also form a monoor polycyclic, aliphatic or aromatic ring system with one another;
$Ar^2$ is on each occurrence, identically or differently, an aromatic or heteroaromatic ring system having 5 to 40 aromatic ring atoms, which may be substituted by one or more radicals $R^2$;
$R^2$ is on each occurrence, identically or differently, H, D, CN or an aliphatic, aromatic and/or heteroaromatic organic radical having 1 to 20 C atoms, in which, in addition, H atoms may be replaced by F; two or more adjacent substituents $R^2$ may also form a mono- or polycyclic, aliphatic or aromatic ring system with one another.

or **characterised in that** the ETM1 used is a ketone of the formula (23) or a phosphine oxide of the formula (24),

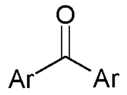
formula (23)

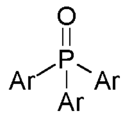
formula (24)

where Ar has the meaning given above.

**11.** Organic electroluminescent device according to one or more of Claims 1 to 10, **characterised in that** ETM2 is a pure hydrocarbon, preferably an aromatic hydrocarbon, or **in that** ETM2 is a carbazole derivative, a diazasilole derivative or a tetraazasilole derivative.

**12.** Organic electroluminescent device according to one or more of Claims 1 to 11, **characterised in that** ETM2 is selected from compounds of the formulae (36), (37) and (38),

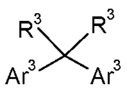
formula (36)

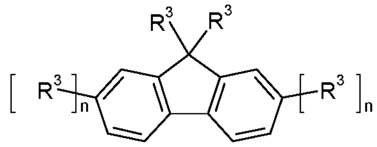
formula (37)

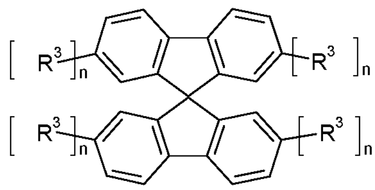
formula (38)

where $R^1$ has the meaning given in Claim 11 and the other symbols and indices used have the following meanings:

$Ar^3$ is on each occurrence, identically or differently, an aromatic ring system having 6 to 60 aromatic C atoms which contains no nonaromatic groups other than carbon or hydrogen; $Ar^3$ may be substituted by one or more radicals $R^4$;
$R^3$ is on each occurrence, identically or differently, a straight-chain alkyl group having 1 to 20 C atoms or a branched or cyclic alkyl group having 3 to 20 C atoms, or an aromatic ring system having 6 to 60 aromatic C atoms which contains no non-aromatic groups other than carbon or hydrogen and which may be substituted by one or more radicals $R^4$; two or more radicals $R^3$ may also form a ring system with one another;
$R^4$ is on each occurrence, identically or differently, a straight-chain alkyl group having 1 to 20 C atoms or a branched or cyclic alkyl group having 3 to 20 C atoms; two or more radicals $R^4$ may also form a ring system with one another;
n is, identically or differently on each occurrence, 0 or 1;

or **characterised in that** the ETM2 used is a compound of the formula (39) or (40),

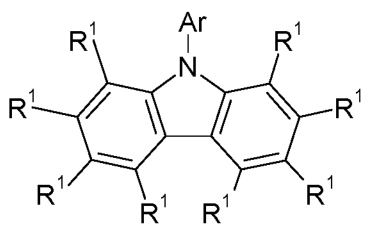
formula (39)

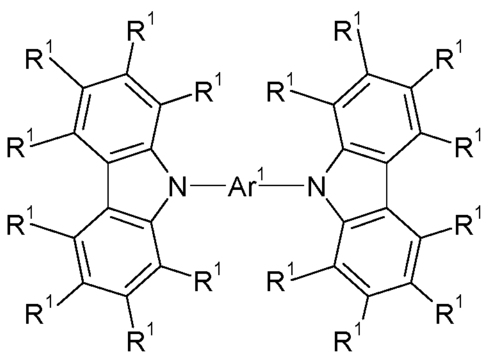
formula (40)

where the symbols used have the meanings given in Claim 10.

**13.** Organic electroluminescent device according to one or more of Claims 1 to 12, **characterised in that** an electron-injection layer which comprises an alkali metal fluoride or alkaline earth metal fluoride, an alkali metal oxide or alkaline earth metal oxide, an alkali metal carbonate or alkaline earth metal carbonate or an alkali metal complex or alkaline earth metal complex is used between the electron-transport layer and the metallic cathode.

**14.** Organic electroluminescent device according to one or more of Claims 1 to 13, **characterised in that** the emitting layer is phosphorescent and preferably comprises a mixture of two or more matrix materials.

**15.** Process for the production of an organic electroluminescent device according to one or more of Claims 1 to 14, **characterised in that** one or more layers are applied by means of a sublimation process and/or **in that** one or more layers are applied by means of the OVPD process or with the aid of carrier-gas sublimation and/or **in that** one or more layers are applied from solution.

**Revendications**

**1.** Dispositif électroluminescent organique comprenant une anode, une cathode, au moins une couche d'émission et au moins une couche de transport d'électrons qui est directement adjacente à la couche d'émission sur le côté de cathode, **caractérisé en ce que** la couche de transport d'électrons comprend un mélange d'au moins deux matériaux ETM1 et ETM2, où les conditions qui suivent s'appliquent au ETM1 et au ETM2 :

a) $T_1$(ETM1) > 2,2 eV ; et
b) $T_1$(ETM2) > 2,2 eV ; et
c) -3,2 eV < LUMO(ETM1) < -2,0 eV ; et
d) LUMO(ETM2) > LUMO(ETM1) ;

où $T_1$ représente l'énergie de triplet la plus faible du matériau respectif et LUMO représente l'énergie de l'orbite moléculaire non occupée la plus basse du matériau respectif ; et
où le ETM1 et le ETM2 sont des matériaux purement organiques,
et où les énergies de triplet et les valeurs de la HOMO et de la LUMO sont déterminées en utilisant le procédé de la théorie fonctionnelle de la densité en fonction du temps qui est divulgué dans la section des exemples.

**2.** Dispositif électroluminescent organique selon la revendication 1, **caractérisé en ce que** l'énergie de triplet $T_1$ du ETM1 et du ETM2 et de quelconques autres matériaux qui sont présents dans la couche de transport d'électrons est > 2,4 eV, de préférence, est > 2,6 eV.

**3.** Dispositif électroluminescent organique selon la revendication 1 ou 2, **caractérisé en ce que** la LUMO du ETM1 s'inscrit à l'intérieur de la plage qui va de -3,1 eV à -2,2 eV de préférence, à l'intérieur de la plage qui va de -3,0 eV à -2,4 eV.

**4.** Dispositif électroluminescent organique selon une ou plusieurs des revendications 1 à 3, **caractérisé en ce que** la LUMO du ETM2 est d'au moins 0,1 eV plus grande que la LUMO du ETM1.

**5.** Dispositif électroluminescent organique selon une ou plusieurs des revendications 1 à 4, **caractérisé en ce que** la HOMO du ETM1 est < -5,3 eV.

**6.** Dispositif électroluminescent organique selon une ou plusieurs des revendications 1 à 5, **caractérisé en ce que** HOMO(ETM1) < HOMO(EML) et HOMO(ETM2) < HOMO(EML), où HOMO(EML) représente la HOMO de la couche d'émission ou du matériau de la couche d'émission qui présente la HOMO la plus haute.

**7.** Dispositif électroluminescent organique selon une ou plusieurs des revendications 1 à 6, **caractérisé en ce que** la proportion du ETM2 est ≥ 10 % en vol. et de préférence, est ≥ 30 % en vol. et en outre, la proportion du ETM2 est ≤ 90 % en vol. et de préférence, est ≤ 80 % en vol.

**8.** Dispositif électroluminescent organique selon une ou plusieurs des revendications 1 à 7, **caractérisé en ce que** la couche de transport d'électrons ne comprend pas d'autres matériaux en dehors du ETM1 et du ETM2.

**9.** Dispositif électroluminescent organique selon une ou plusieurs des revendications 1 à 8, **caractérisé en ce que** le ETM1 est sélectionné parmi le groupe qui est constitué par les composés qui contiennent des groupes de cycle

hétéroaryle à six éléments, en particulier les dérivés de triazine, les dérivés de pyrimidine, les dérivés de pyridine, les dérivés de pyrazine, les dérivés de quinoxaline ou les dérivés de quinoline, les composés qui contiennent des groupes de cycle hétéroaromatique à cinq éléments qui comportent au moins deux hétéroatomes, en particulier les dérivés d'oxadiazole ou les dérivés de benzimidazole, ou par les cétones aromatiques, les boranes aromatiques, les lactames aromatiques, les dérivés de diazaphosphole et les dérivés d'oxyde de phosphine.

**10.** Dispositif électroluminescent organique selon une ou plusieurs des revendications 1 à 9, **caractérisé en ce que** le ETM1 qui est utilisé est un composé de l'une des formules (1) à (8),

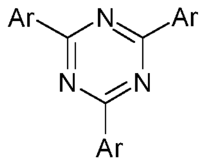

formule (1)

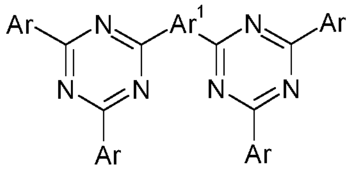

formule (2)

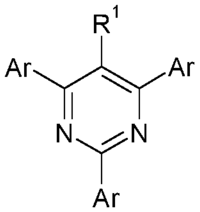

formule (3)

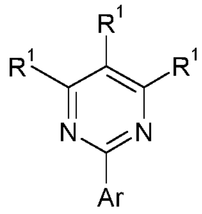

formule (4)

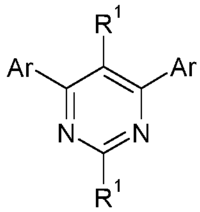

formule (5)

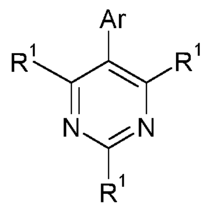

formule (6)

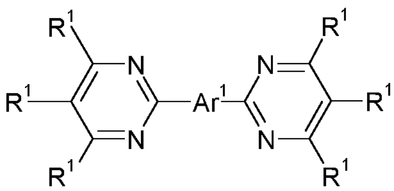

formule (7)

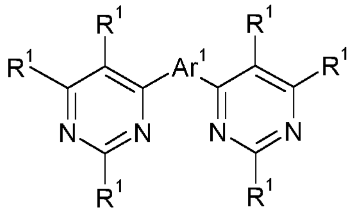

formule (8)

dans lesquelles ce qui suit s'applique aux symboles qui sont utilisés :

Ar est, de manière identique ou différente pour chaque occurrence, un système de cycle aromatique ou hétéroaromatique monovalent qui comporte de 5 à 60 atomes de cycle aromatique, lequel peut dans chaque cas être substitué par un radical ou par plusieurs radicaux $R^1$ ;

$Ar^1$ est un système de cycle aromatique ou hétéroaromatique divalent qui comporte de 5 à 60 atomes de cycle aromatique, lequel peut être substitué par un radical ou par plusieurs radicaux $R^1$ ;

$R^1$ est pour chaque occurrence, de manière identique ou différente, H, D, F, Cl, Br, I, CHO, $C(=O)Ar^2$, $P(=O)(Ar^2)_2$, $S(=O)Ar^2$, $S(=O)_2Ar^2$, $CR^2=CR^2Ar^2$, CN, $NO_2$, $Si(R^2)_3$, $B(OR^2)_2$, $B(R^2)_2$, $B(N(R^2)_2)_2$, $OSO_2R^2$, un groupe alkyle, alcoxy ou thioalcoxy en chaîne droite qui comporte de 1 à 40 atome(s) de C ou un groupe alkényle ou alkynyle en chaîne droite qui comporte de 2 à 40 atomes de C ou un groupe alkyle, alkényle, alkynyle, alcoxy ou thioalcoxy ramifié ou cyclique qui comporte de 3 à 40 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, C=C , $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S ou $CONR^2$ et où un ou plusieurs atome(s) de H peut/peuvent être remplacé(s) par F, Cl, Br, I, CN ou $NO_2$, ou un système de cycle aromatique ou hétéroaromatique qui comporte de 5 à 60 atomes de cycle aromatique, lequel peut dans chaque cas être substitué par un radical ou par plusieurs radicaux $R^2$, ou un groupe aryloxy ou hétéroaryloxy qui comporte de 5 à 60 atomes de cycle aromatique, lequel peut être substitué par un radical ou par plusieurs radicaux $R^2$, ou une combinaison de ces systèmes ; deux substituants $R^1$ adjacents ou plus peuvent également former un système de cycle aliphatique ou aromatique mono- ou polycyclique l'un avec

l'autre ou les uns avec les autres ;

$Ar^2$ est pour chaque occurrence, de manière identique ou différente, un système de cycle aromatique ou hétéroaromatique qui comporte de 5 à 40 atomes de cycle aromatique, lequel peut être substitué par un radical ou par plusieurs radicaux $R^2$ ;

$R^2$ est pour chaque occurrence, de manière identique ou différente, H, D, CN ou un radical organique aliphatique, aromatique et/ou hétéroaromatique qui comporte de 1 à 20 atome(s) de C, où, en outre, des atomes de H peuvent être remplacés par F ; deux substituants $R^2$ adjacents ou plus peuvent également former un système de cycle aliphatique ou aromatique mono- or polycyclique l'un avec l'autre ou les uns avec les autres ;

ou **caractérisé en ce que** le ETM1 qui est utilisé est un cétone de la formule (23) ou un oxyde de phosphine de la formule (24),

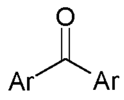

formule (23)

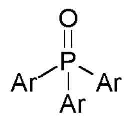

formule (24)

dans lesquelles Ar présente la signification qui a été donnée ci-avant.

**11.** Dispositif électroluminescent organique selon une ou plusieurs des revendications 1 à 10, **caractérisé en ce que** le ETM2 est un hydrocarbone pur, de préférence un hydrocarbone aromatique, ou **en ce que** le ETM2 est un dérivé de carbazole, un dérivé de diazasilole ou un dérivé de tétraazasilole.

**12.** Dispositif électroluminescent organique selon une ou plusieurs des revendications 1 à 11, **caractérisé en ce que** le ETM2 est sélectionné parmi les composés des formules (36), (37) et (38),

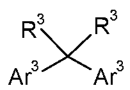

formule (36)

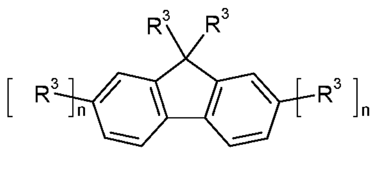

formule (37)

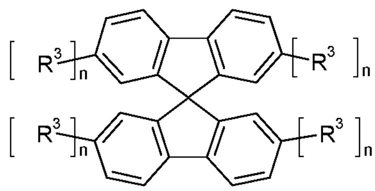

formule (38)

dans lesquelles $R^1$ présente la signification qui a été donnée selon la revendication 11 et les autres symboles et les autres indices qui sont utilisés présentent les significations qui suivent :

$Ar^3$ est pour chaque occurrence, de manière identique ou différente, un système de cycle aromatique qui comporte de 6 à 60 atomes de C aromatique, lequel ne contient pas de groupes non aromatiques autres que carbone ou hydrogène ; $Ar^3$ peut être substitué par un radical ou par plusieurs radicaux $R^4$ ;

$R^3$ est pour chaque occurrence, de manière identique ou différente, un groupe alkyle en chaîne droite qui comporte de 1 à 20 atome(s) de C ou un groupe alkyle ramifié ou cyclique qui comporte de 3 à 20 atomes de C, ou un système de cycle aromatique qui comporte de 6 à 60 atomes de C aromatique, lequel ne contient pas de groupes non aromatiques autres que carbone ou hydrogène et lequel peut être substitué par un radical ou par plusieurs radicaux $R^4$ ; deux radicaux $R^3$ ou plus peuvent également former un système de cycle l'un avec l'autre ou les uns avec les autres ;

$R^4$ est pour chaque occurrence, de manière identique ou différente, un groupe alkyle en chaîne droite qui comporte de 1 à 20 atome(s) de C ou un groupe alkyle ramifié ou cyclique qui comporte de 3 à 20 atomes de C ; deux radicaux $R^4$ ou plus peuvent également former un système de cycle l'un avec l'autre ou les uns avec les autres ;

n est, de manière identique ou différente pour chaque occurrence, 0 ou 1 ;

ou **caractérisé en ce que** le ETM2 qui est utilisé est un composé de la formule (39) ou (40) :

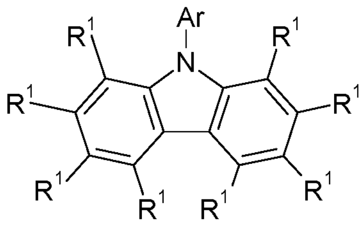

formule (39)

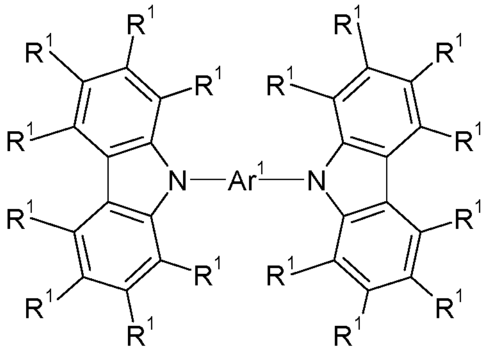

formule (40)

dans lesquelles les symboles qui sont utilisés présentent les significations qui ont été données selon la revendication 10.

**13.** Dispositif électroluminescent organique selon une ou plusieurs des revendications 1 à 12, **caractérisé en ce qu'**une couche d'injection d'électrons qui comprend un fluorure de métal alcalin ou un fluorure de métal alcalino-terreux, un oxyde de métal alcalin ou un oxyde de métal alcalino-terreux, un carbonate de métal alcalin ou un carbonate de métal alcalino-terreux ou un complexe de métal alcalin ou un complexe de métal alcalino-terreux est utilisée entre la couche de transport d'électrons et la cathode métallique.

**14.** Dispositif électroluminescent organique selon une ou plusieurs des revendications 1 à 13, **caractérisé en ce que** la couche d'émission est phosphorescente et de préférence, elle comprend un mélange de deux matériaux de matrice ou plus.

**15.** Procédé pour la fabrication d'un dispositif électroluminescent organique selon une ou plusieurs des revendications 1 à 14, **caractérisé en ce qu'**une ou plusieurs couche(s) est/sont appliquée(s) au moyen d'un processus de sublimation et/ou **en ce qu'**une ou plusieurs couche(s) est/sont appliquée(s) au moyen d'un processus OVPD ou à l'aide d'une sublimation par gaz porteur et/ou **en ce qu'**une ou plusieurs couche(s) est/sont appliquée(s) à partir d'une solution.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2010072300 A
- EP 1286568 A
- WO 2007015781 A
- US 2001052751 A1
- EP 1859491 A1
- WO 2004093207 A
- WO 2010006680 A
- WO 2005003253 A
- WO 2010054729 A
- WO 2005011013 A
- WO 2006122630 A
- WO 2008006449 A
- WO 2007140847 A
- WO 2006000388 A
- WO 2006058737 A
- WO 2006000389 A
- WO 2007065549 A
- WO 2007115610 A
- WO 2010012328 A
- EP 676461 A
- WO 2004081017 A
- WO 2005084081 A
- WO 2005084082 A
- WO 2006048268 A
- WO 2006117052 A
- WO 2008145239 A
- DE 102009034625
- WO 2010083869 A
- WO 2004013080 A
- WO 2006005627 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2010054730 A
- WO 2010015306 A
- EP 652273 A
- WO 2009062578 A
- WO 2009148015 A
- US 20090136779 A
- WO 2010050778 A
- WO 2011042107 A
- WO 2011060867 A
- DE 102010005697
- WO 2010108579 A
- WO 2006100896 A
- EP 1661888 A
- WO 2001049806 A
- US 5061569 A
- WO 9509147 A
- JP 2001226331 A
- EP 650955 A
- US 4780536 A
- WO 9830071 A
- EP 891121 A
- JP 2006253445 A
- WO 2006073054 A
- WO 2004058911 A
- WO 2012034627 A
- DE 102009023155
- WO 2005053055 A
- WO 2011088877 A
- DE 10200836982
- WO 2009124627 A
- WO 2005054403 A
- DE 102008056688


### In der Beschreibung aufgeführte Nicht-Patentliteratur


- **Y. SHIROTA et al.** *Chem. Rev.,* 2007, vol. 107 (4), 953-1010
- **B. M. S. ARNOLD et al.** *Appl. Phys. Lett.,* 2008, vol. 92, 053301